# EUROPEAN PATENT APPLICATION

(11) **EP 4 626 204 A1**
(43) Date of publication of application: **01.10.2025**
(21) Application number: 23894852.5
(22) Date of filing: 31.10.2023
(51) Int. Cl.: H10K 85/60, H10K 50/11

(54) **ORGANIC LIGHT-EMITTING DEVICE, AND COMPOSITION FOR FORMING ORGANIC MATERIAL LAYER**

(30) Priority: 24.11.2022 KR 20220159372
(71) Applicant: LT Materials Co., Ltd., Yongin-si, Gyeonggi-do 17118 (KR)
(72) Inventor: LEE, Yong-Hui, Yongin-si, Gyeonggi-do 17118 (KR); MO, Jun-Tae, Yongin-si, Gyeonggi-do 17118 (KR); KIM, Dong-Jun, Yongin-si, Gyeonggi-do 17118 (KR); CHOI, Dae-Hyuk, Yongin-si, Gyeonggi-do 17118 (KR)
(74) Representative: Goddar, Heinz J.
(86) International application number: PCT/KR2023/017141
(87) International publication number: WO 2024/111923

(57) **Abstract**

The present specification provides an organic light emitting device and a composition for an organic material layer of the organic light emitting device.

## Description

### [Technical Field]

The present specification relates to an organic light emitting device and a composition for forming an organic material layer.

This application claims priority to and the benefits of Korean Patent Application No. 10-2022-0159372, filed with the Korean Intellectual Property Office on November 24, 2022, the entire contents of which are incorporated herein by reference.

### [Background Art]

An electroluminescence device is a kind of selfemitting type display device, and has an advantage in that the viewing angle is wide, the contrast is excellent, and the response speed is fast.

An organic light emitting device is composed of a structure in which an organic thin film is disposed between two electrodes. When a voltage is applied to an organic light emitting device having such a structure, electrons and holes injected from the two electrodes are combined with each other in the organic thin film to make a pair, and then, the paired electrons and holes emit light while being annihilated. The organic thin film may be composed of a single layer or multiple layers, if necessary.

A material for the organic thin film may have a light emitting function, if necessary. For example, as the material for the organic thin film, it is also possible to use a compound, which may itself constitute a light emitting layer alone, or it is also possible to use a compound, which may serve as a host or a dopant of a hostdopant-based light emitting layer. In addition, as a material for the organic thin film, it is also possible to use a compound, which may perform a function such as hole injection, hole transport, electron blocking, hole blocking, electron transport or electron injection.

In order to improve the performance, efficiency and service life of the organic light emitting device, there is a continuous need for developing a material for an organic thin film.

### [Related Art Documents]

### [Patent Documents]

(Patent Document 1) US Patent No. 4,356,429

### [Disclosure]

### [Technical Problem]

The present specification has been made in an effort to provide an organic light emitting device and a composition for forming an organic material layer.

### [Technical Solution]

The present specification provides an organic light emitting device including: a first electrode; a second electrode; and an organic material layer provided between the first electrode and the second electrode, in which the organic material layer includes a compound of the following Chemical Formula 1 and a compound of the following Chemical Formula 2. 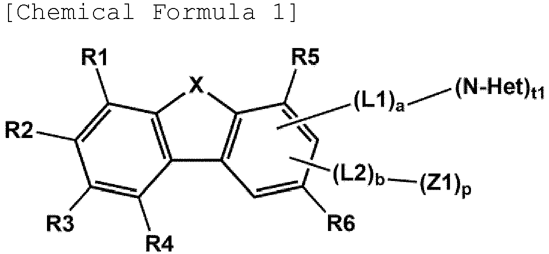 In Chemical Formula 1,
X is O or S,
L1 and L2 are the same as or different from each other, and are each independently a direct bond; a substituted or unsubstituted C6 to C60 arylene group; or a substituted or unsubstituted C2 to C60 heteroarylene group,
Z1 is a substituted or unsubstituted C6 to C60 aryl group; or a substituted or unsubstituted C2 to C60 heteroaryl group,
N-Het is a monocyclic or polycyclic C2 to C60 heteroaryl group which is substituted or unsubstituted and includes one or more N's,
R1 to R6 are the same as or different from each other, and are each independently hydrogen; deuterium; a halogen group; -CN; a substituted or unsubstituted C1 to C60 alkyl group; a substituted or unsubstituted C6 to C60 aryl group; or a substituted or unsubstituted C2 to C60 heteroaryl group,
a and b are each an integer from 0 to 3, and when a is 2 or higher, L1's are the same as or different from each other, and when b is 2 or higher, L2's are the same as or different from each other,
p and t1 are each an integer from 1 to 3, and when p is 2 or higher, Z1's are the same as or different from each other, and when t1 is 2 or higher, N-Het's are the same as or different from each other, 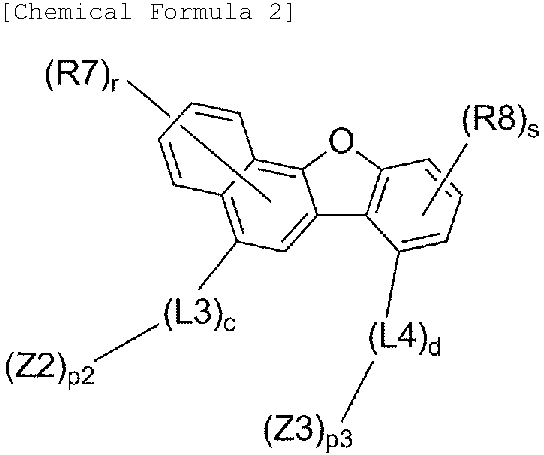 in Chemical Formula 2,
   L3 and L4 are the same as or different from each other, and are each independently a direct bond; or a substituted or unsubstituted C6 to C60 arylene group,
   Z2 and Z3 are each independently a substituted or unsubstituted amine group; a substituted or unsubstituted C6 to C60 aryl group; or a substituted or unsubstituted C2 to C60 heteroaryl group,
   any one of Z2 and Z3 is a substituted or unsubstituted amine group, and the other is a substituted or unsubstituted C6 to C60 aryl group; or a substituted or unsubstituted C2 to C60 heteroaryl group,
   R7 and R8 are the same as or different from each other, and are each independently hydrogen; deuterium; a halogen group; -CN; a substituted or unsubstituted C1 to C60 alkyl group; a substituted or unsubstituted C6 to C60 aryl group; or a substituted or unsubstituted C2 to C60 heteroaryl group,
   c and d are each an integer from 0 to 3, and when c is 2 or higher, L3's are the same as or different from each other, and when d is 2 or higher, L4's are the same as or different from each other,
   p2 and p3 are each an integer from 1 to 3, and when p2 is 2 or higher, Z2's are the same as or different from each other, and when p3 is 2 or higher, Z3's are the same as or different from each other,
   r is an integer from 0 to 5, and when r is 2 or higher, R7's are the same as or different from each other, and
   s is an integer from 0 to 3, and when s is 2 or higher, R8's are the same as or different from each other.

Further, the present specification provides a composition for forming an organic material layer including the compound of Chemical Formula 1 and the compound of Chemical Formula 2.

### [Advantageous Effects]

The organic light emitting device of the present specification includes an organic material layer including a compound of Chemical Formula 1 and a compound of Chemical Formula 2, and the organic material layer including the compounds may be a hole injection layer, a hole transport layer, a light emitting layer, an electron transport layer, an electron injection layer, a charge generation layer, and the like. In particular, the organic material layer including the compounds may be a light emitting layer of an organic light emitting device.

When the compound of Chemical Formula 1 and the compound of Chemical Formula 2 are together used as materials for the light emitting layer of the organic light emitting device, the driving voltage of the device can be lowered, the light emitting efficiency can be improved, and the service life characteristics can be improved.

Specifically, when the compound of Chemical Formula 1 as an acceptor (n-host) with good electron transport ability and the compound of Chemical Formula 2 as a donor (p-host) with good hole transport ability are used as a cohost of a light emitting layer, the driving voltage can be lowered because electrons and holes are smoothly injected into the light emitting layer, and the efficiency and service life of the device can be improved through the formation of an effective recombination zone.

### [Description of Drawings]

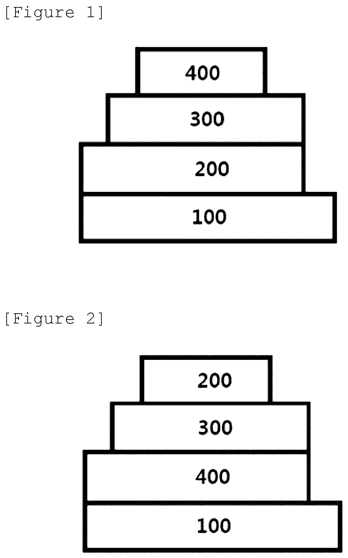

FIGS. 1 to 4 are views each schematically illustrating a stacking structure of an organic light emitting device according to an exemplary embodiment of the present application.

### [Mode for Invention]

Hereinafter, the present specification will be described in more detail.

When one part "includes" one constituent element in the present specification, unless otherwise specifically described, this does not mean that another constituent element is excluded, but means that another constituent element may be further included.

In the present specification, 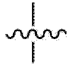 of a chemical formula means a position to which a constituent element is bonded.

The term "substitution" means that a hydrogen atom bonded to a carbon atom of a compound is changed into another substituent, and a position to be substituted is not limited as long as the position is a position at which the hydrogen atom is substituted, that is, a position at which the substituent may be substituted, and when two or more are substituted, the two or more substituents may be the same as or different from each other.

In the present specification, "substituted or unsubstituted" means being unsubstituted or substituted with one or more substituents selected from the group consisting of deuterium; a halogen group; -CN; a C1 to C60 alkyl group; a C2 to C60 alkenyl group; a C2 to C60 alkynyl group; a C1 to C60 haloalkyl group; a C1 to C60 alkoxy group; a C6 to C60 aryloxy group; a C1 to C60 alkylthioxy group; a C6 to C60 arylthioxy group; a C1 to C60 alkylsulfoxy group; a C6 to C60 arylsulfoxy group; a C3 to C60 cycloalkyl group; a C2 to C60 heterocycloalkyl group; a C6 to C60 aryl group; a C2 to C60 heteroaryl group; - SiRR'R"; -P(=O)RR'; and -NRR', or a substituent to which two or more substituents selected among the exemplified substituents are linked, and R, R' and R" are each independently a substituent composed of at least one of hydrogen; deuterium; a halogen group; an alkyl group; an alkenyl group; an alkoxy group; a cycloalkyl group; a heterocycloalkyl group; an aryl group; and a heteroaryl group.

In the present specification, "when a substituent is not indicated in the structure of a chemical formula or compound" means that a hydrogen atom is bonded to a carbon atom. However, since deuterium (²H) is an isotope of hydrogen, some hydrogen atoms may be deuterium.

In an exemplary embodiment of the present application, "when a substituent is not indicated in the structure of a chemical formula or compound" may mean that all the positions that may be reached by the substituent are hydrogen or deuterium. That is, deuterium is an isotope of hydrogen, and some hydrogen atoms may be deuterium which is an isotope, and in this case, the content of deuterium may be 0% to 100%.

In an exemplary embodiment of the present application, in "the case where a substituent is not indicated in the structure of a chemical formula or compound", when the content of deuterium is 0%, the content of hydrogen is 100%, and all the substituents do not explicitly exclude deuterium such as hydrogen, hydrogen and deuterium may be mixed and used in the compound.

In an exemplary embodiment of the present application, deuterium is one of the isotopes of hydrogen, is an element that has a deuteron composed of one proton and one neutron as a nucleus, and may be represented by hydrogen-2, and the element symbol may also be expressed as D or ²H.

In an exemplary embodiment of the present application, the isotope means an atom with the same atomic number (Z), but different mass numbers (A), and the isotope may also be interpreted as an element which has the same number of protons, but different number of neutrons.

In an exemplary embodiment of the present application, when the total number of substituents of a basic compound is defined as T1 and the number of specific substituents among the substituents is defined as T2, the content T% of the specific substituent may be defined as T2/T1×100 = T%.

That is, in an example, a deuterium content of 20% in a phenyl group represented by 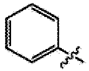 may be represented by 20% when the total number of substituents that the phenyl group can have is 5 (T1 in the formula) and the number of deuteriums among the substituents is 1 (T2 in the formula). That is, a deuterium content of 20% in the phenyl group may be represented by the following structural formula.

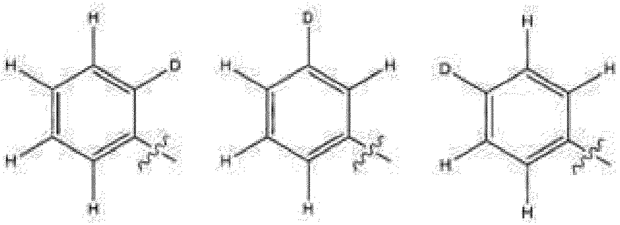

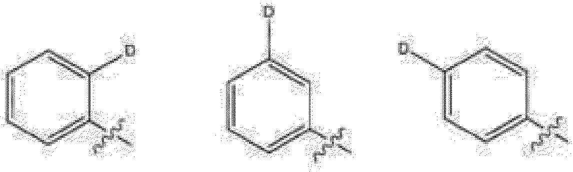

Further, in an exemplary embodiment of the present application, "a phenyl group having a deuterium content of 0%" may mean a phenyl group that does not include a deuterium atom, that is, has five hydrogen atoms.

In the present specification, the halogen may be fluorine, chlorine, bromine or iodine.

In the present specification, an alkyl group includes a straight-chain or branched-chain having 1 to 60 carbon atoms, and may be additionally substituted with another substituent. The number of carbon atoms of the alkyl group may be 1 to 60, specifically 1 to 40, and more specifically 1 to 20. Specific examples thereof include a methyl group, an ethyl group, a propyl group, an n-propyl group, an isopropyl group, a butyl group, an n-butyl group, an isobutyl group, a tert-butyl group, a sec-butyl group, a 1-methyl-butyl group, a 1-ethyl-butyl group, a pentyl group, an n-pentyl group, an isopentyl group, a neopentyl group, a tert-pentyl group, a hexyl group, an n-hexyl group, a 1-methylpentyl group, a 2-methylpentyl group, a 4-methyl-2-pentyl group, a 3,3-dimethylbutyl group, a 2-ethylbutyl group, a heptyl group, an n-heptyl group, a 1-methylhexyl group, an octyl group, an n-octyl group, a tert-octyl group, a 1-methylheptyl group, a 2-ethylhexyl group, a 2-propylpentyl group, an n-nonyl group, a 2,2-dimethylheptyl group, a 1-ethyl-propyl group, a 1,1-dimethyl-propyl group, an isohexyl group, a 2-methylpentyl group, a 4-methylhexyl group, a 5-methylhexyl group, and the like, but are not limited thereto.

In the present specification, an alkenyl group includes a straight-chain or branched-chain having 2 to 60 carbon atoms, and may be additionally substituted with another substituent. The number of carbon atoms of the alkenyl group may be 2 to 60, specifically 2 to 40, and more specifically 2 to 20. Specific examples thereof include a vinyl group, a 1-propenyl group, an isopropenyl group, a 1-butenyl group, a 2-butenyl group, a 3-butenyl group, a 1-pentenyl group, a 2-pentenyl group, a 3-pentenyl group, a 3-methyl-1-butenyl group, a 1,3-butadienyl group, an allyl group, a 1-phenylvinyl-1-yl group, a 2-phenylvinyl-1-yl group, a 2,2-diphenylvinyl-1-yl group, a 2-phenyl-2-(naphthyl-1-yl)vinyl-1-yl group, a 2,2-bis(diphenyl-1-yl)vinyl-1-yl group, a stilbenyl group, a styrenyl group, and the like, but are not limited thereto.

In the present specification, an alkynyl group includes a straight-chain or branched-chain having 2 to 60 carbon atoms, and may be additionally substituted with another substituent. The number of carbon atoms of the alkynyl group may be 2 to 60, specifically 2 to 40, and more specifically 2 to 20.

In the present specification, a haloalkyl group means an alkyl group substituted with a halogen group, and specific examples thereof include -CF₃, -CF₂CF₃, and the like, but are not limited thereto.

In the present specification, an alkoxy group is represented by -O(R101), and the above-described examples of the alkyl group may be applied to R101.

In the present specification, an aryloxy group is represented by -O(R102), and the above-described examples of the aryl group may be applied to R102.

In the present specification, an alkylthioxy group is represented by -S(R103), and the above-described examples of the alkyl group may be applied to R103.

In the present specification, an arylthioxy group is represented by -S(R104), and the above-described examples of the aryl group may be applied to R104.

In the present specification, an alkylsulfoxy group is represented by -S(=0)₂(R105), and the above-described examples of the alkyl group may be applied to R105.

In the present specification, an arylsulfoxy group is represented by -S(=0)₂(R106), and the above-described examples of the aryl group may be applied to R106.

In the present specification, a cycloalkyl group includes a monocycle or polycycle having 3 to 60 carbon atoms, and may be additionally substituted with another substituent. Here, the polycycle means a group in which a cycloalkyl group is directly linked to or fused with another cyclic group. Here, another cyclic group may also be a cycloalkyl group, but may also be another kind of cyclic group, for example, a heterocycloalkyl group, an aryl group, a heteroaryl group, and the like. The number of carbon atoms of the cycloalkyl group may be 3 to 60, specifically 3 to 40, and more specifically 5 to 20. Specific examples thereof include a cyclopropyl group, a cyclobutyl group, a cyclopentyl group, a 3-methylcyclopentyl group, a 2,3-dimethylcyclopentyl group, a cyclohexyl group, a 3-methylcyclohexyl group, a 4-methylcyclohexyl group, a 2,3-dimethylcyclohexyl group, a 3,4,5-trimethylcyclohexyl group, a 4-tert-butylcyclohexyl group, a cycloheptyl group, a cyclooctyl group, and the like, but are not limited thereto.

In the present specification, a heterocycloalkyl group includes O, S, Se, N, or Si as a heteroatom, includes a monocycle or polycycle having 2 to 60 carbon atoms, and may be additionally substituted with another substituent. Here, the polycycle means a group in which a heterocycloalkyl group is directly linked to or fused with another cyclic group. Here, another cyclic group may also be a heterocycloalkyl group, but may also be another kind of cyclic group, for example, a cycloalkyl group, an aryl group, a heteroaryl group, and the like. The number of carbon atoms of the heterocycloalkyl group may be 2 to 60, specifically 2 to 40, and more specifically 3 to 20.

In the present specification, an aryl group includes a monocycle or polycycle having 6 to 60 carbon atoms, and may be additionally substituted with another substituent. Here, the polycycle means a group in which an aryl group is directly linked to or fused with another cyclic group. Here, another cyclic group may also be an aryl group, but may also be another kind of cyclic group, for example, a cycloalkyl group, a heterocycloalkyl group, a heteroaryl group, and the like. The aryl group includes a spiro group. The number of carbon atoms of the aryl group may be 6 to 60, specifically 6 to 40, and more specifically 6 to 25. Specific examples of the aryl group include a phenyl group, a biphenyl group, a terphenyl group, a naphthyl group, an anthryl group, a chrysenyl group, a phenanthrenyl group, a perylenyl group, a fluoranthenyl group, a triphenylenyl group, a phenalenyl group, a pyrenyl group, a tetracenyl group, a pentacenyl group, a fluorenyl group, an indenyl group, an acenaphthylenyl group, a benzofluorenyl group, a spirobifluorenyl group, a 2,3-dihydro-1H-indenyl group, a fused cyclic group thereof, and the like, but are not limited thereto.
In the present specification, the terphenyl group may be selected from the following structures.

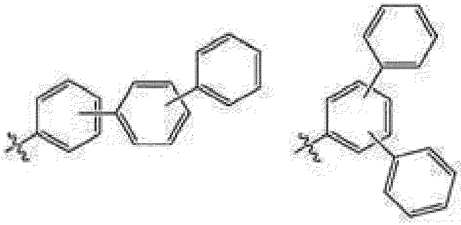

In the present specification, the fluorenyl group may be substituted, and adjacent substituents may be bonded to each other to form a ring.

When the fluorenyl group is substituted, the substituent may be 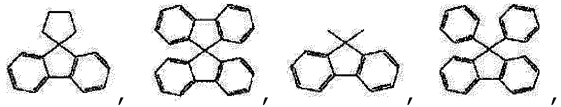 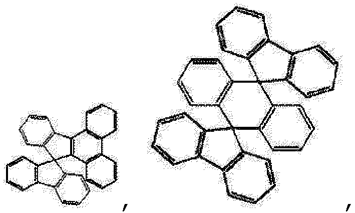 and the like, but is not limited thereto.

In the present specification, a heteroaryl group includes S, O, Se, N, or Si as a heteroatom, includes a monocycle or polycycle having 2 to 60 carbon atoms, and may be additionally substituted with another substituent. Here, the polycycle means a group in which a heteroaryl group is directly linked to or fused with another cyclic group. Here, another cyclic group may also be a heteroaryl group, but may also be another kind of cyclic group, for example, a cycloalkyl group, a heterocycloalkyl group, an aryl group, and the like. The number of carbon atoms of the heteroaryl group may be 2 to 60, specifically 2 to 40, and more specifically 3 to 25. Specific examples of the heteroaryl group include a pyridine group, a pyrrole group, a pyrimidine group, a pyridazine group, a furan group, a thiophene group, an imidazole group, a pyrazole group, an oxazole group, an isoxazole group, a thiazole group, an isothiazole group, a triazole group, a furazan group, an oxadiazole group, a thiadiazole group, a dithiazole group, a tetrazolyl group, a pyran group, a thiopyran group, a diazine group, an oxazine group, a thiazine group, a dioxin group, a triazine group, a tetrazine group, a quinoline group, an isoquinoline group, a quinazoline group, an isoquinazoline group, a quinozoline group, a naphthyridine group, an acridine group, a phenanthridine group, an imidazopyridine group, a diazanaphthalene group, a triazaindene group, an indole group, an indolizine group, a benzothiazole group, a benzoxazole group, a benzimidazole group, a benzothiophene group, a benzofuran group, a dibenzothiophene group, a dibenzofuran group, a carbazole group, a benzocarbazole group, a dibenzocarbazole group, a phenazine group, a dibenzosilole group, spirobi(dibenzosilole), a dihydrophenazine group, a phenoxazine group, a phenanthridine group, a thienyl group, an indolo[2,3-a]carbazole group, an indolo[2,3-b]carbazole group, an indoline group, a 10,11-dihydrodibenzo[b,f]azepine group, a 9,10-dihydroacridine group, a phenanthrazine group, a phenothiazine group, a phthalazine group, a phenanthroline group, a naphthobenzofuran group, a naphthobenzothiophene group, a benzo[c][1,2,5]thiadiazole group, a 2,3-dihydrobenzo[b]thiophene group, a 2,3-dihydrobenzofuran group, a 5,10-dihydrodibenzo[b,e][1,4]azasiline group, a pyrazolo[1,5-c]quinazoline group, a pyrido[1,2-b]indazole group, a pyrido[1,2-a]imidazo[1,2-e]indoline group, a 5,11-dihydroindeno[1,2-b]carbazole group, a 12H-benzofuro[2,3-a]carbazole group, a benzofuro[3,2-d]pyrimidine group, a benzo[4,5]thieno[3,2-d]pyrimidine group, and the like, but are not limited thereto.

In the present specification, when the substituent is a carbazole group, it means being bonded to nitrogen or carbon of carbazole.

In the present specification, when a carbazole group is substituted, an additional substituent may be substituted with the nitrogen or carbon of the carbazole.

In the present specification, a benzocarbazole group may be any one of the following structures.

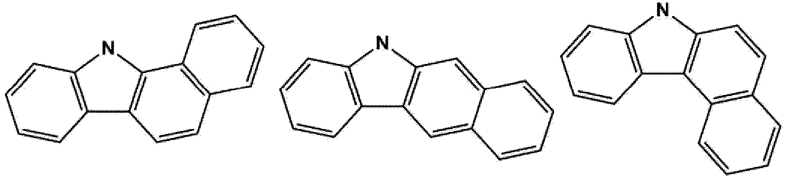

In the present specification, a dibenzocarbazole group may be any one of the following structures.

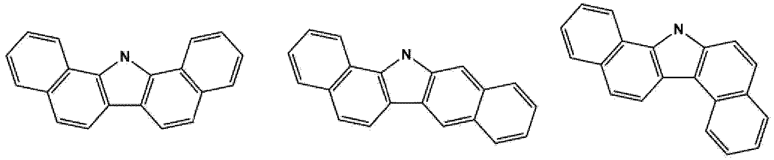

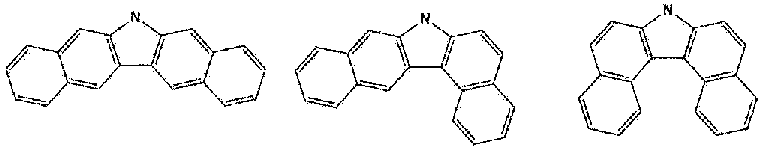

In the present specification, a naphthobenzofuran group may be any one of the following structures.

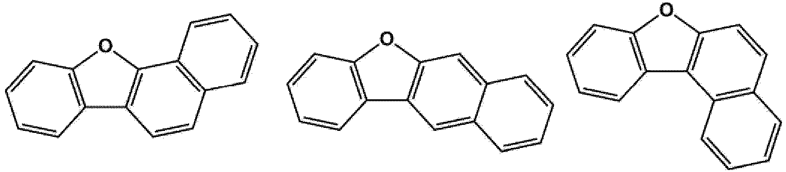

In the present specification, a naphthobenzothiophene group may be any one of the following structures.

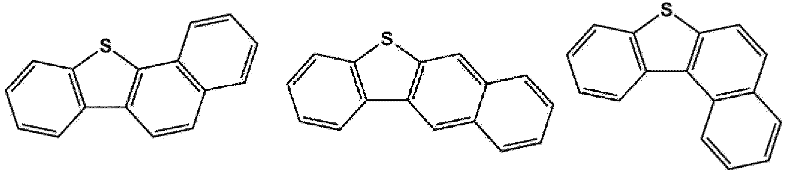

In the present specification, a silyl group includes Si and is a substituent to which the Si atom is directly linked as a radical, and is represented by - Si(R107) (R108) (R109), and R107 to R109 are the same as or different from each other, and may be each independently a substituent composed of at least one of hydrogen; deuterium; a halogen group; an alkyl group; an alkenyl group; an alkoxy group; a cycloalkyl group; a heterocycloalkyl group; an aryl group; and a heteroaryl group. Specific examples of the silyl group include 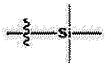 (a trimethylsilyl group), 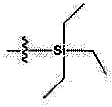 (a triethylsilyl group), 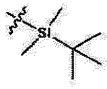 (a t-butyldimethylsilyl group), 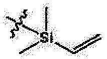 (a vinyldimethylsilyl group), 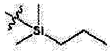 (a propyldimethylsilyl group), 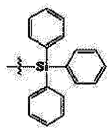 (a triphenylsilyl group), 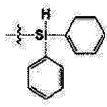 (a diphenylsilyl group), 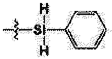 (a phenylsilyl group) and the like, but are not limited thereto.

In the present specification, a phosphine oxide group is represented by -P(=O) (R110) (R111), and R110 and R111 are the same as or different from each other, and may be each independently a substituent composed of at least one of hydrogen; deuterium; a halogen group; an alkyl group; an alkenyl group; an alkoxy group; a cycloalkyl group; a heterocycloalkyl group; an aryl group; and a heteroaryl group. Specifically, the phosphine oxide group may be substituted with an alkyl group or an aryl group, and the above-described example may be applied to the alkyl group and the aryl group. Examples of the phosphine oxide group include a dimethylphosphine oxide group, a diphenylphosphine oxide group, dinaphthylphosphine oxide, and the like, but are not limited thereto.

In the present specification, an amine group is represented by -N(R112) (R113), and R112 and R113 are the same as or different from each other, and may be each independently a substituent composed of at least one of hydrogen; deuterium; a halogen group; an alkyl group; an alkenyl group; an alkoxy group; a cycloalkyl group; a heterocycloalkyl group; an aryl group; and a heteroaryl group. The amine group may be selected from the group consisting of -NH₂; a monoalkylamine group; a monoarylamine group; a monoheteroarylamine group; a dialkylamine group; a diarylamine group; a diheteroarylamine group; an alkylarylamine group; an alkylheteroarylamine group; and an arylheteroarylamine group, and the number of carbon atoms thereof is not particularly limited, but is preferably 1 to 30. Specific examples of the amine group include a methylamine group, a dimethylamine group, an ethylamine group, a diethylamine group, a phenylamine group, a naphthylamine group, a biphenylamine group, a dibiphenylamine group, an anthracenylamine group, a 9-methyl-anthracenylamine group, a diphenylamine group, a phenylnaphthylamine group, a ditolylamine group, a phenyltolylamine group, a triphenylamine group, a biphenylnaphthylamine group, a phenylbiphenylamine group, a biphenylfluorenylamine group, a phenyltriphenylenylamine group, a biphenyltriphenylenylamine group, and the like, but are not limited thereto.

In the present specification, the above-described examples of the aryl group may be applied to an arylene group except for a divalent arylene group.

In the present specification, the above-described examples of the heteroaryl group may be applied to a heteroarylene group except for a divalent heteroarylene group.

In the present specification, the "adjacent" group may mean a substituent substituted with an atom directly linked to an atom in which the corresponding substituent is substituted, a substituent disposed to be sterically closest to the corresponding substituent, or another substituent substituted with an atom in which the corresponding substituent is substituted. For example, two substituents substituted at the ortho position in a benzene ring and two substituents substituted at the same carbon in an aliphatic ring may be interpreted as groups which are "adjacent" to each other.

Hydrocarbon rings and hetero rings that adjacent groups may form include an aliphatic hydrocarbon ring, an aromatic hydrocarbon ring, an aliphatic hetero ring and an aromatic hetero ring, and structures exemplified by the above-described cycloalkyl group, aryl group, heterocycloalkyl group and heteroaryl group may be applied to the rings, except for those that are not monovalent groups.

In an exemplary embodiment of the present application, a group not represented by a substituent; or a group represented by hydrogen may mean being all substitutable with deuterium. That is, it may be shown that hydrogen; or deuterium can be substituted with each other.

In general, compounds bonded with hydrogen and compounds substituted with deuterium exhibit a difference in thermodynamic behavior. The reason for this is that the mass of a deuterium atom is 2-fold higher than that of hydrogen, but due to the difference in the mass of atoms, deuterium is characterized by having even lower vibration energy.

Further, the single bond dissociation energy of carbon and deuterium is higher than the single bond dissociation energy of carbon and hydrogen. Accordingly, the deuterium-substituted structure has an effect of increasing the thermal stability of the molecule and improving the service life of the device using the increased thermal stability.

When a compound is deposited on a silicon wafer, a material including deuterium tends to be packed so that the intermolecular distance is reduced. Further, when the surface of a thin film is observed using an atomic force microscope (AFM), it can be confirmed that the thin film made of a compound including deuterium is deposited with a more uniform surface without any aggregated portion.

The heterocyclic compound of Chemical Formula 1 of the present application has a deuterium substitution rate of 0% or 30% to 100% or less. The deuterium-substituted compound is characterized in that the energy in the ground state is lower than that of the hydrogen-substituted compound, and the shorter the bond length between carbon and deuterium is, the smaller the molecular hardcore volume is. Accordingly, the electrical polarizability may be reduced and the intermolecular interaction can be weakened, so that when a device is manufactured, the device has a stabler stacking structure.

These characteristics induce an effect of lowering the crystallinity by creating the amorphous state of a thin film. That is, the heterocyclic compound represented by Chemical Formula 1 may be effective in improving the heat resistance of an OLED device, thereby improving the service life and driving characteristics.

The present application provides an organic light emitting device including: a first electrode; a second electrode; and an organic material layer provided between the first electrode and the second electrode, in which the organic material layer includes a compound of the following Chemical Formula 1 and a compound of the following Chemical Formula 2.

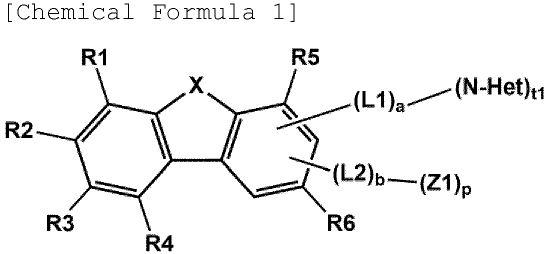

In Chemical Formula 1,
X is O or S,
L1 and L2 are the same as or different from each other, and are each independently a direct bond; a substituted or unsubstituted C6 to C60 arylene group; or a substituted or unsubstituted C2 to C60 heteroarylene group,
Z1 is a substituted or unsubstituted C6 to C60 aryl group; or a substituted or unsubstituted C2 to C60 heteroaryl group,
N-Het is a monocyclic or polycyclic C2 to C60 heteroaryl group which is substituted or unsubstituted and includes one or more N's,
R1 to R6 are the same as or different from each other, and are each independently hydrogen; deuterium; a halogen group; -CN; a substituted or unsubstituted C1 to C60 alkyl group; a substituted or unsubstituted C6 to C60 aryl group; or a substituted or unsubstituted C2 to C60 heteroaryl group,
a and b are each an integer from 0 to 3, and when a is 2 or higher, L1's are the same as or different from each other, and when b is 2 or higher, L2's are the same as or different from each other,
p and t1 are each an integer from 1 to 3, and when p is 2 or higher, Z1's are the same as or different from each other, and when t1 is 2 or higher, N-Het's are the same as or different from each other, 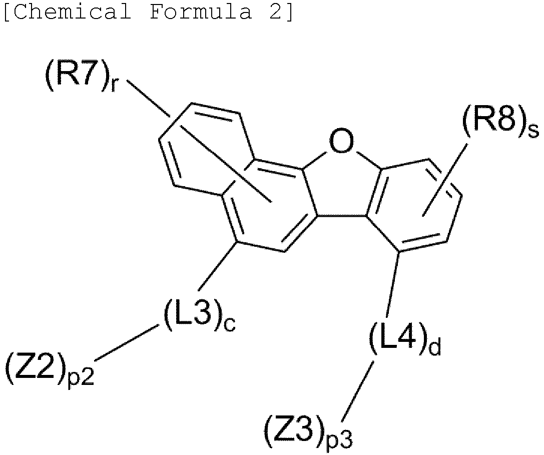 in Chemical Formula 2,
   L3 and L4 are the same as or different from each other, and are each independently a direct bond; or a substituted or unsubstituted C6 to C60 arylene group,
   Z2 and Z3 are different from each other, and are each independently a substituted or unsubstituted amine group; a substituted or unsubstituted C6 to C60 aryl group; or a substituted or unsubstituted C2 to C60 heteroaryl group,
   any one of Z2 and Z3 is a substituted or unsubstituted amine group, and the other is a substituted or unsubstituted C6 to C60 aryl group; or a substituted or unsubstituted C2 to C60 heteroaryl group,
   R7 and R8 are the same as or different from each other, and are each independently hydrogen; deuterium; a halogen group; -CN; a substituted or unsubstituted C1 to C60 alkyl group; a substituted or unsubstituted C6 to C60 aryl group; or a substituted or unsubstituted C2 to C60 heteroaryl group,
   c and d are each an integer from 0 to 3, and when c is 2 or higher, L3's are the same as or different from each other, and when d is 2 or higher, L4's are the same as or different from each other,
   p2 and p3 are each an integer from 1 to 3, and when p2 is 2 or higher, Z2's are the same as or different from each other, and when p3 is 2 or higher, Z3's are the same as or different from each other,
   r is an integer from 0 to 5, and when r is 2 or higher, R7's are the same as or different from each other, and
   s is an integer from 0 to 3, and when s is 2 or higher, R8's are the same as or different from each other.
   When the compound of Chemical Formula 1 and the compound of Chemical Formula 2 of the present specification are included together as materials for the organic material layer of the device, electrons and holes move in a well-balanced manner, so that a recombination zone (RZ) is widely located in the center of the light emitting layer, resulting in excellent driving, efficiency and service life of the device.

In an exemplary embodiment of the present application, Chemical Formula 1 may be represented by any one of the following Chemical Formulae 1-1 and 1-2.

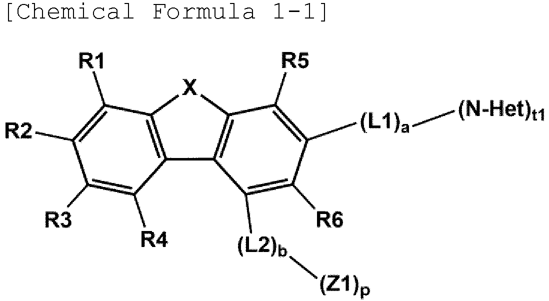

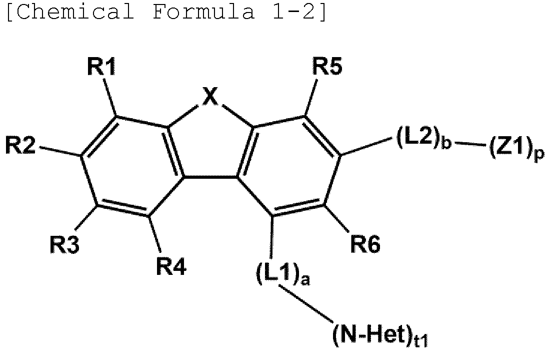

In Chemical Formulae 1-1 and 1-2,
X, R1 to R6, L1, L2, Z1, N-Het, a, b, p and t1 are the same as the definitions in Chemical Formula 1.

In an exemplary embodiment of the present application, the N-Het may be represented by the following Chemical Formula 3. 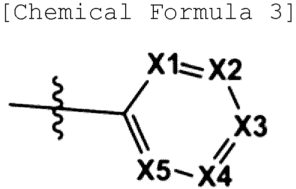 in Chemical Formula 3,
X1 is CR11 or N, X2 is CR12 or N, X3 is CR13 or N, X4 is CR14 or N, and X5 is CR15 or N,
at least one of X1 to X5 is N, and
R11 to R15 are the same as or different from each other, and are each independently selected from the group consisting of hydrogen; deuterium; a halogen group; -CN; **a** substituted or unsubstituted C1 to C60 alkyl group; a substituted or unsubstituted C6 to C60 aryl group; a substituted or unsubstituted C2 to C60 heteroaryl group; and an amine group which is unsubstituted or substituted with a substituted or unsubstituted alkyl group, a substituted or unsubstituted aryl group or a substituted or unsubstituted heteroaryl group, or two or more adjacent groups are bonded to each other to form a substituted or unsubstituted aromatic hydrocarbon ring or a substituted or unsubstituted hetero ring.

In an exemplary embodiment of the present application, Chemical Formula 3 may be represented by any one of the following Chemical Formulae 3-1 to 3-3.

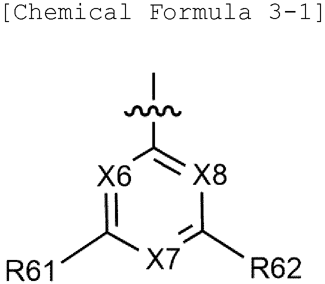

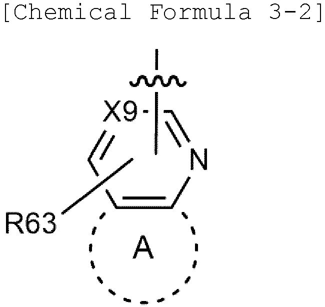

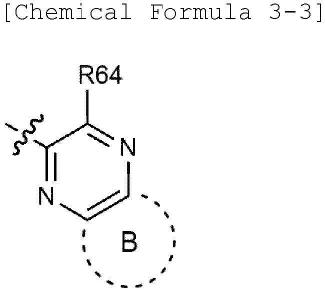

In Chemical Formulae 3-1 to 3-3,
X6 to X9 are each N or CR16,
at least one of X6 to X8 is N,
A and B are the same as or different from each other, and are each independently a substituted or unsubstituted monocyclic or polycyclic C6 to C60 aryl ring; or a substituted or unsubstituted monocyclic or polycyclic C2 to C60 hetero ring, and
R16 and R61 to R64 are the same as or different from each other, and are each independently hydrogen; deuterium; a halogen group; a cyano group; a substituted or unsubstituted C1 to C60 alkyl group; a substituted or unsubstituted C6 to C60 aryl group; or a substituted or unsubstituted C2 to C60 heteroaryl group.

In an exemplary embodiment of the present application, Chemical Formula 3-1 may be selected from the following structural formulae.

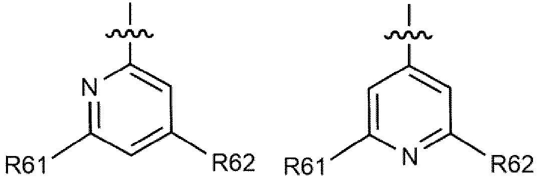

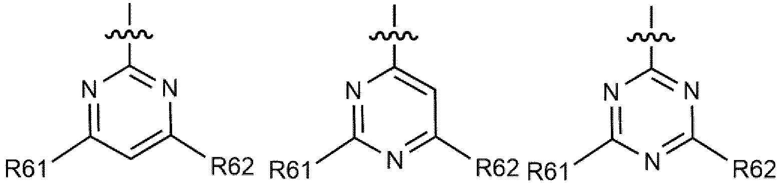

The definitions of R61 and R62 are the same as the definitions in Chemical Formula 3-1.

In an exemplary embodiment of the present application, Chemical Formula 3-2 may be represented by any one of the following Chemical Formulae 3-2-1 to 3-2-3.

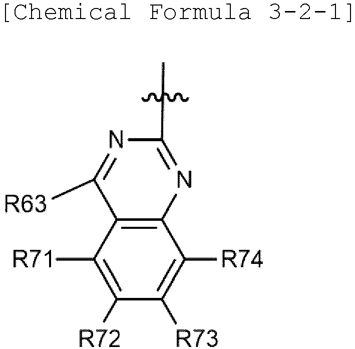

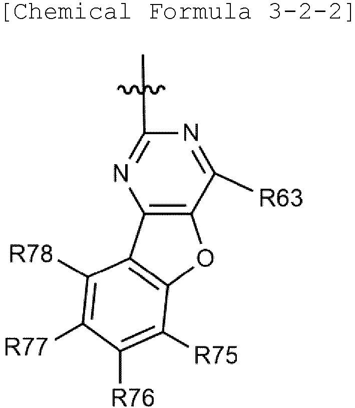

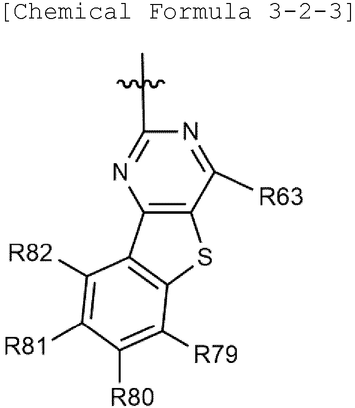

In Chemical Formulae 3-2-1 to 3-2-3, R63 is the same as the definition in Chemical Formula 3-2, and
R71 to R82 are the same as or different from each other, and are each independently hydrogen; or deuterium.

In an exemplary embodiment of the present application, Chemical Formula 3-3 may be represented by the following Chemical Formula 3-3-1.

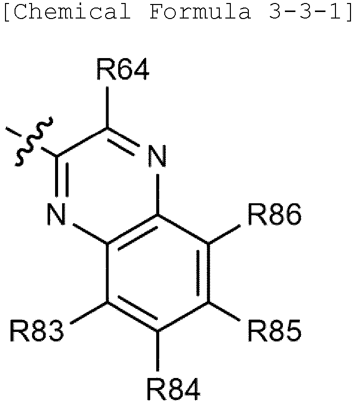

In Chemical Formula 3-3-1, R64 is the same as the definition in Chemical Formula 3-3, and
R83 to R86 are the same as or different from each other, and are each independently hydrogen; or deuterium.

In an exemplary embodiment of the present application, L1 and L2 are the same as or different from each other, and may be each independently a direct bond; a substituted or unsubstituted C6 to C40 arylene group; or a substituted or unsubstituted C2 to C40 heteroarylene group.

In another exemplary embodiment, L1 and L2 are the same as or different from each other, and may be each independently a direct bond; a substituted or unsubstituted C6 to C20 arylene group; or a substituted or unsubstituted C2 to C20 heteroarylene group.

In still another exemplary embodiment, L1 and L2 are the same as or different from each other, and may be each independently a direct bond; or a substituted or unsubstituted C6 to C20 arylene group.

In yet another further exemplary embodiment, L1 and L2 are the same as or different from each other, and may be each independently a direct bond; a substituted or unsubstituted phenylene group; a substituted or unsubstituted biphenylene group; or a substituted or unsubstituted naphthylene group.

In still yet another exemplary embodiment, L1 and L2 are the same as or different from each other, and may be each independently a direct bond; a phenylene group; or a naphthylene group.

In an exemplary embodiment of the present application, Z1 may be a substituted or unsubstituted C6 to C40 aryl group; or a substituted or unsubstituted C2 to C40 heteroaryl group.

In another exemplary embodiment, Z1 may be a substituted or unsubstituted C6 to C20 aryl group; or a substituted or unsubstituted C2 to C20 heteroaryl group.

In still another exemplary embodiment, Z1 may be a substituted or unsubstituted phenyl group; a substituted or unsubstituted biphenyl group; a substituted or unsubstituted terphenyl group; a substituted or unsubstituted naphthyl group; a substituted or unsubstituted phenanthrene group; a substituted or unsubstituted triphenylene group; a substituted or unsubstituted fluorenyl group; a substituted or unsubstituted dibenzofuran group; a substituted or unsubstituted dibenzothiophene group; a substituted or unsubstituted naphthobenzofuran group; a substituted or unsubstituted naphthobenzothiophene group; or a substituted or unsubstituted carbazole group.

In yet another exemplary embodiment, Z1 may be a substituted or unsubstituted phenyl group; a substituted or unsubstituted biphenyl group; a substituted or unsubstituted naphthyl group; a substituted or unsubstituted phenanthrene group; a substituted or unsubstituted dibenzofuran group; a substituted or unsubstituted dibenzothiophene group; a substituted or unsubstituted naphthobenzofuran group; or a substituted or unsubstituted naphthobenzothiophene group.

In still yet another exemplary embodiment, Z1 may be a phenyl group which is unsubstituted or substituted with deuterium; a biphenyl group which is unsubstituted or substituted with deuterium; a naphthyl group which is unsubstituted or substituted with deuterium; a substituted or unsubstituted phenanthrene group; a substituted or unsubstituted dibenzofuran group; a substituted or unsubstituted dibenzothiophene group; a substituted or unsubstituted naphthobenzofuran group; or a substituted or unsubstituted naphthobenzothiophene group.

In an exemplary embodiment of the present application, R1 to R6 are the same as or different from each other, and may be each independently hydrogen; deuterium; a halogen group; -CN; a substituted or unsubstituted C1 to C20 alkyl group; a substituted or unsubstituted C6 to C20 aryl group; or a substituted or unsubstituted C2 to C20 heteroaryl group.

In another exemplary embodiment, R1 to R6 are the same as or different from each other, and may be each independently hydrogen; or deuterium.

In an exemplary embodiment of the present application, a and b are each an integer from 0 to 2, and when a is 2, L1's are the same as or different from each other, and when b is 2, L2's may be the same as or different from each other.

In another exemplary embodiment, a and b may be each 0 or 1.

In an exemplary embodiment of the present application, p and t1 are each an integer from 1 to 2, and when p is 2, Z1's are the same as or different from each other, and when t1 is 2, N-Het's may be the same as or different from each other.

In another exemplary embodiment, p and t1 may be each 1.

In an exemplary embodiment of the present application, the N-Het may be a monocyclic or polycyclic C2 to C40 heteroaryl group which is substituted or unsubstituted and includes one or more N's.

In another exemplary embodiment, the N-Het may be a monocyclic or polycyclic C2 to C20 heteroaryl group which is substituted or unsubstituted and includes one or more N's.

In still another exemplary embodiment, the N-Het may be a substituted or unsubstituted pyridine group; a substituted or unsubstituted pyrimidine group; a substituted or unsubstituted triazine group; a substituted or unsubstituted quinazoline group; a substituted or unsubstituted quinoxaline group; a substituted or unsubstituted benzofuropyrimidine group; or a substituted or unsubstituted benzothienopyrimidine group.

In yet another exemplary embodiment, the N-Het may be a pyrimidine group substituted with deuterium, a phenyl group unsubstituted or substituted with a naphthyl group, a biphenyl group, a naphthyl group unsubstituted or substituted with a phenyl group, a dibenzofuran group, a dibenzothiophene group or a naphthobenzofuran group; a triazine group substituted with a naphthyl group unsubstituted or substituted with deuterium or a phenyl group unsubstituted or substituted with deuterium, a phenanthrene group, a phenyl group unsubstituted or substituted with a dibenzofuran or carbazole group, biphenyl unsubstituted or substituted with deuterium, deuterium, a naphthyl group unsubstituted or substituted with deuterium or a phenyl group unsubstituted or substituted with deuterium, a phenanthrene group unsubstituted or substituted with a phenyl group, a chrysene group, a dibenzofuran group unsubstituted or substituted with deuterium or a phenyl group, a dibenzothiophene group, a naphthobenzofuran group unsubstituted or substituted with deuterium, a naphthobenzothiophene group or a carbazole group unsubstituted or substituted with a phenyl group; a quinazoline group substituted with a phenyl group, a naphthyl group, a dibenzofuran group, a naphthobenzofuran group or a naphthobenzothiophene group; a quinoxaline group substituted with a biphenyl group or a phenanthrene group; a benzofuropyrimidine group substituted with a phenyl group, a naphthyl group, a biphenyl group, a dibenzofuran group or a naphthobenzofuran group; or a benzothienopyrimidine group substituted with a phenyl group, a biphenyl group or a naphthyl group.

In an exemplary embodiment of the present application, X6 to X8 may all be N.

In an exemplary embodiment of the present application, X9 may be N.

In an exemplary embodiment of the present application, A may be a substituted or unsubstituted benzene ring; a substituted or unsubstituted quinoline ring; a substituted or unsubstituted indole ring; a substituted or unsubstituted benzofuran ring; or a substituted or unsubstituted benzothiophene ring.

In another exemplary embodiment, A may be a benzene ring; a quinoline ring; an indole ring substituted with an aryl group; a benzofuran ring; or a benzothiophene ring.

In an exemplary embodiment of the present application, B may be a substituted or unsubstituted monocyclic aryl ring.

In another exemplary embodiment, B may be a benzene ring.

In an exemplary embodiment of the present application, R16 and R61 to R64 are the same as or different from each other, and may be each independently hydrogen; deuterium; a halogen group; a cyano group; a substituted or unsubstituted C1 to C40 alkyl group; a substituted or unsubstituted C6 to C40 aryl group; or a substituted or unsubstituted C2 to C40 heteroaryl group.

In another exemplary embodiment, R16 and R61 to R64 are the same as or different from each other, and may be each independently hydrogen; deuterium; a halogen group; a cyano group; a substituted or unsubstituted C1 to C20 alkyl group; a substituted or unsubstituted C6 to C20 aryl group; or a substituted or unsubstituted C2 to C20 heteroaryl group.

In still another exemplary embodiment, R16 and R61 to R64 are the same as or different from each other, and are each independently a substituted or unsubstituted phenyl group; a substituted or unsubstituted biphenyl group; a substituted or unsubstituted terphenyl group; a substituted or unsubstituted naphthyl group; a substituted or unsubstituted phenanthrene group; a substituted or unsubstituted chrysene group; a substituted or unsubstituted dibenzofuran group; a substituted or unsubstituted dibenzothiophene group; a substituted or unsubstituted naphthobenzofuran group; a substituted or unsubstituted naphthobenzothiophene group; or a substituted or unsubstituted carbazole group.

In an exemplary embodiment of the present application, the deuterium content of the compound of Chemical Formula 1 may be 0%, or 1% to 100%.

In an exemplary embodiment of the present application, the deuterium content of the compound of Chemical Formula 1 may be 0%, or 10% to 100%.

In an exemplary embodiment of the present application, the deuterium content of the compound of Chemical Formula 1 may be 0%, or 15% to 100%.

In an exemplary embodiment of the present application, the deuterium content of the compound of Chemical Formula 1 may be 0%, or 30% to 100%.

In an exemplary embodiment of the present application, the deuterium content of the compound of Chemical Formula 1 may be 0%, or 50% to 100%.

In an exemplary embodiment of the present application, the deuterium content of the compound of Chemical Formula 1 may be 0%, or 70% to 100%.

In an exemplary embodiment of the present application, the deuterium content of the compound of Chemical Formula 1 may be 0%, or 90% to 100%.

In an exemplary embodiment of the present application, the deuterium content of the compound of Chemical Formula 1 may be 0%.

In an exemplary embodiment of the present application, the deuterium content of the compound of Chemical Formula 1 may be 15% to 100%.

In an exemplary embodiment of the present application, the deuterium content of the compound of Chemical Formula 1 may be 30% to 100%.

In an exemplary embodiment of the present application, the deuterium content of the compound of Chemical Formula 1 may be 50% to 100%.

In an exemplary embodiment of the present application, the deuterium content of the compound of Chemical Formula 1 may be 70% to 100%.

In an exemplary embodiment of the present application, the deuterium content of the compound of Chemical Formula 1 may be 90% to 100%.

In an exemplary embodiment of the present application, provided is a heterocyclic compound in which Chemical Formula 1 is represented by any one of the following compounds.

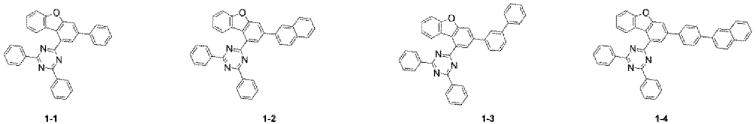

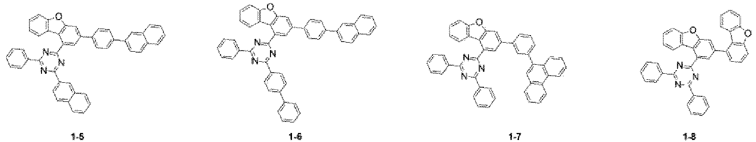

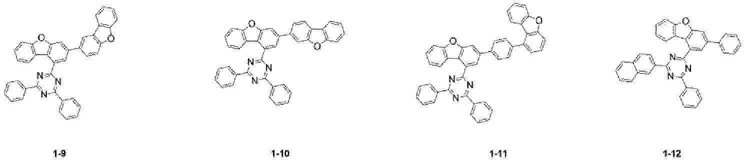

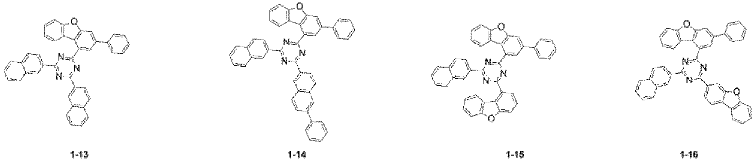

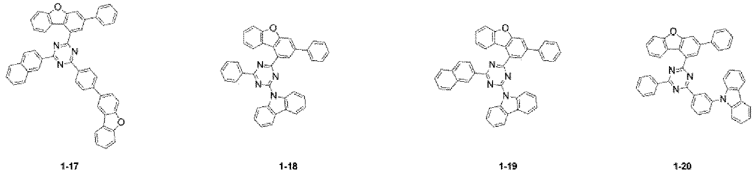

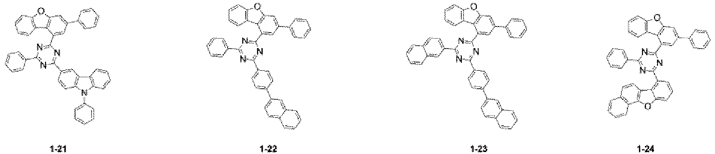

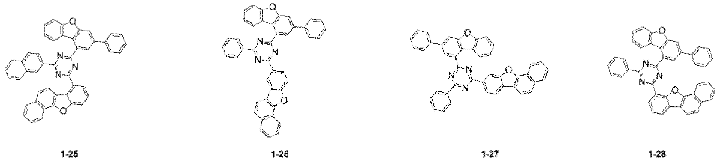

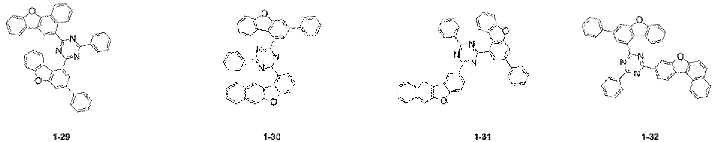

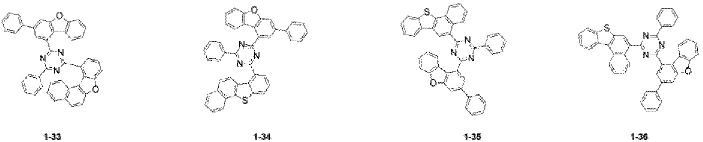

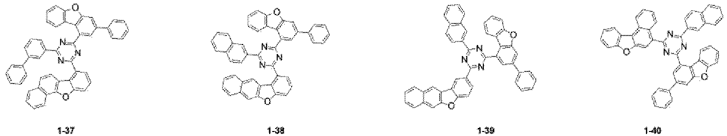

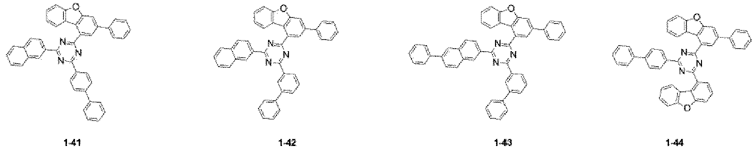

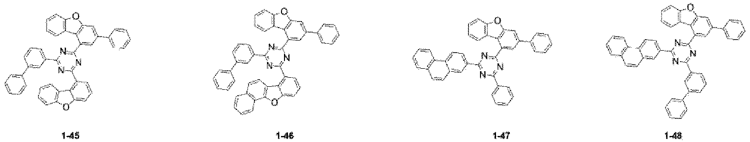

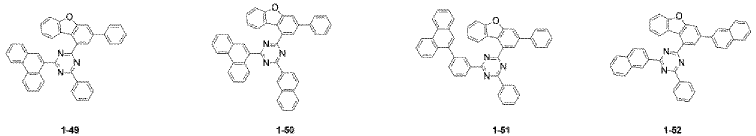

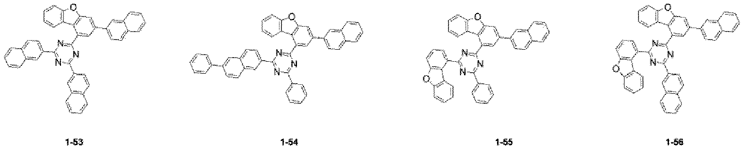

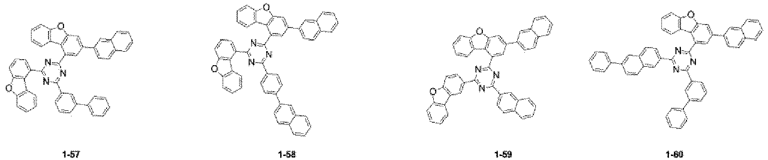

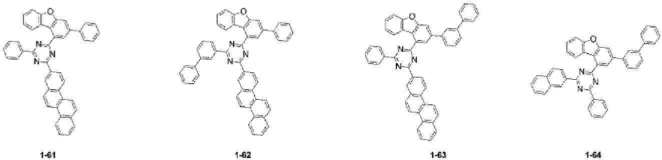

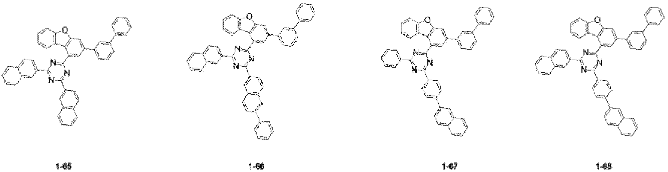

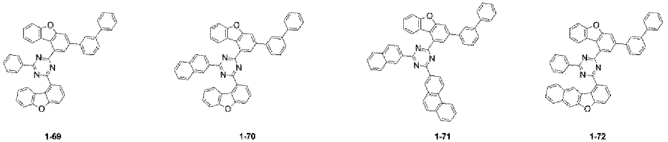

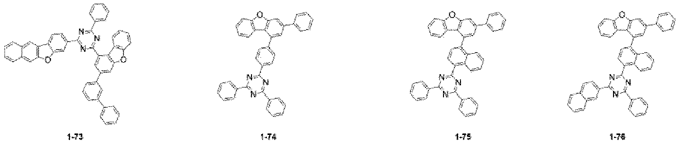

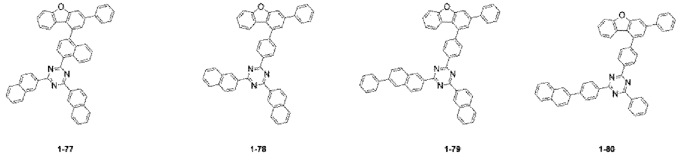

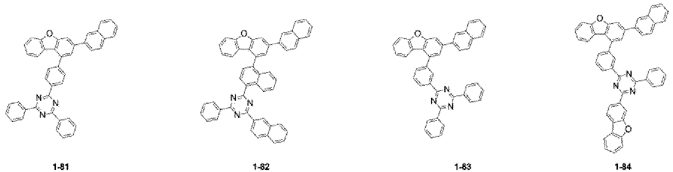

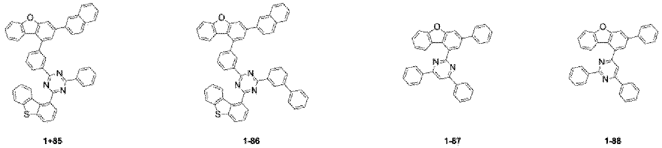

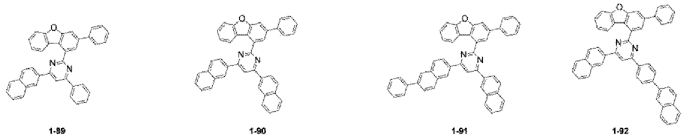

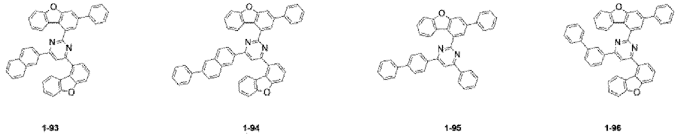

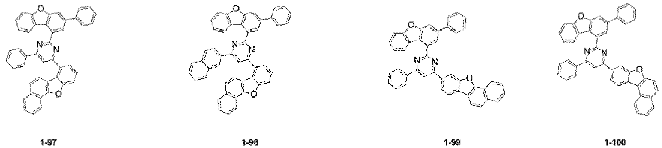

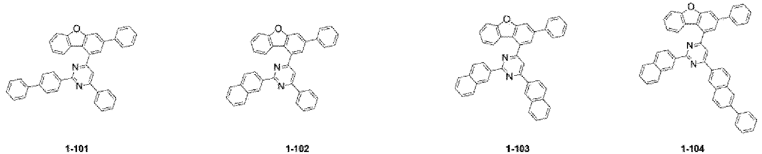

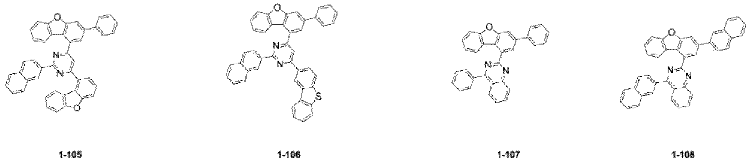

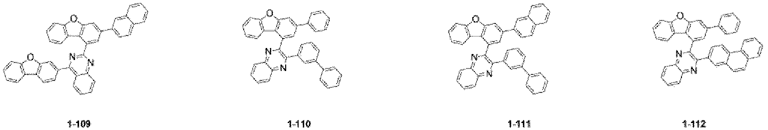

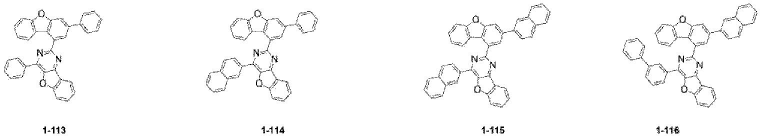

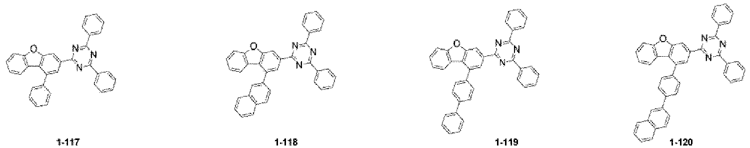

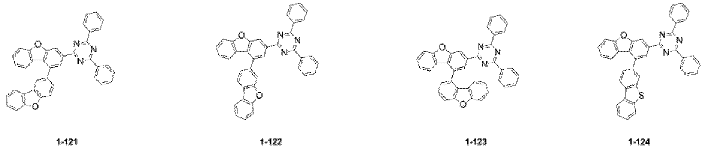

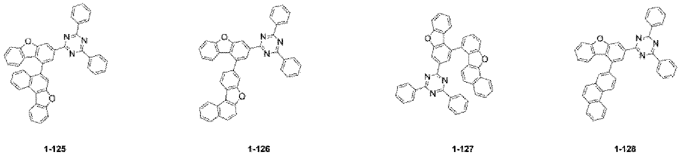

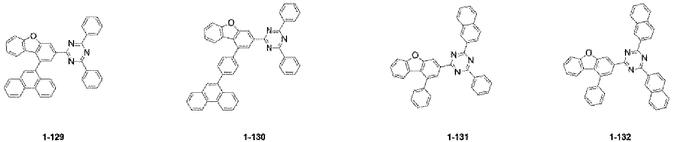

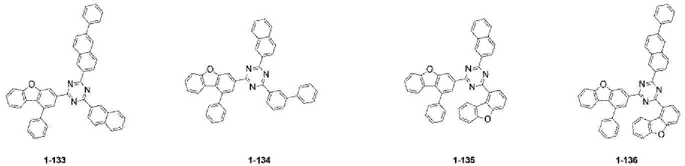

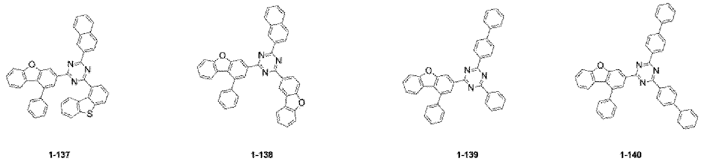

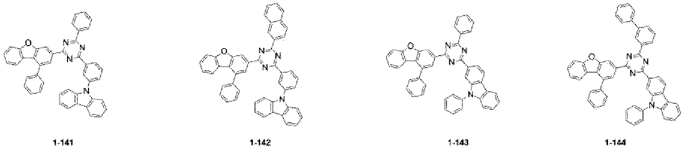

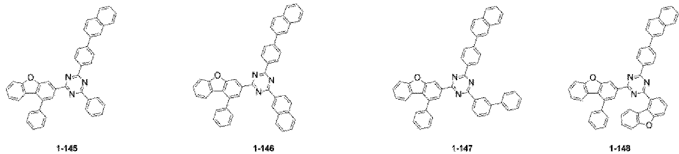

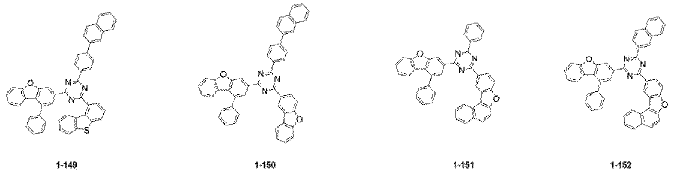

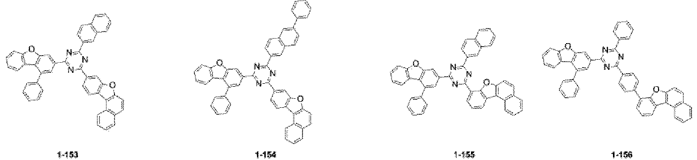

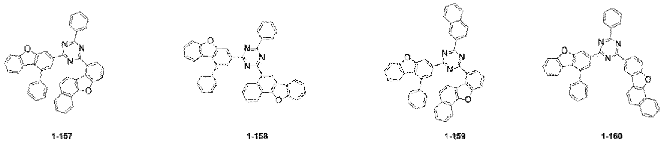

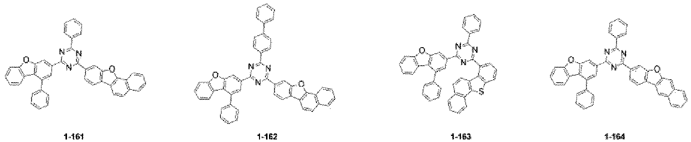

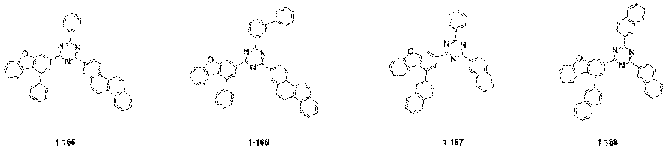

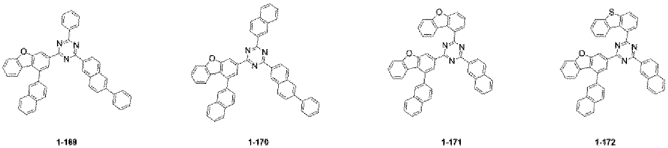

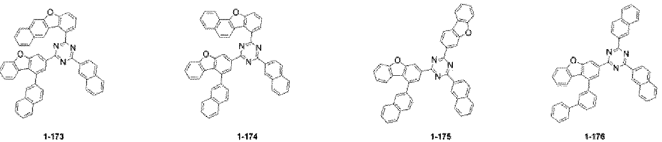

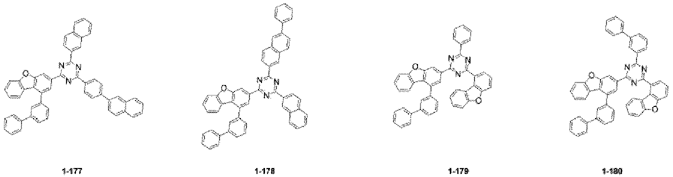

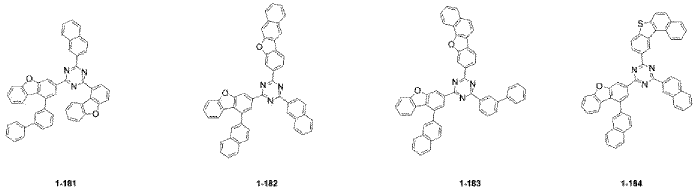

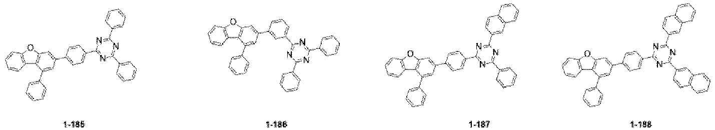

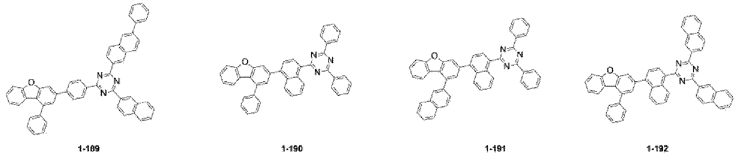

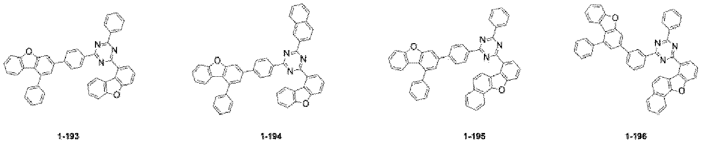

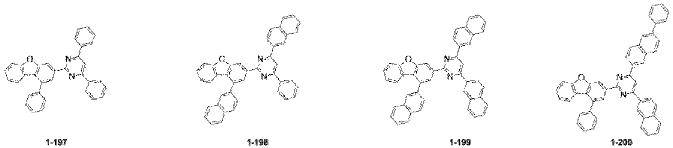

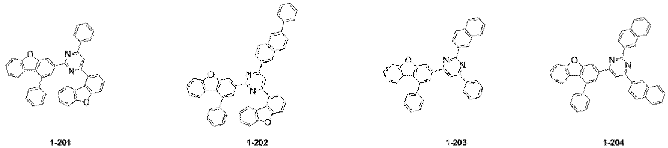

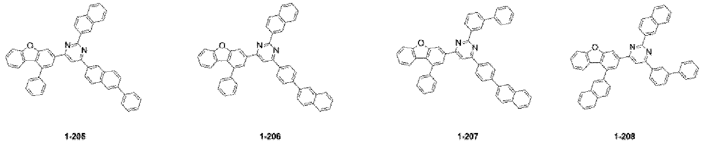

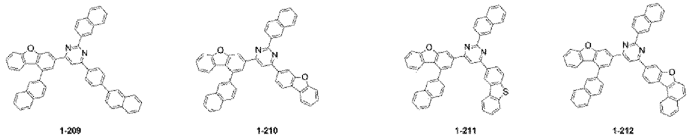

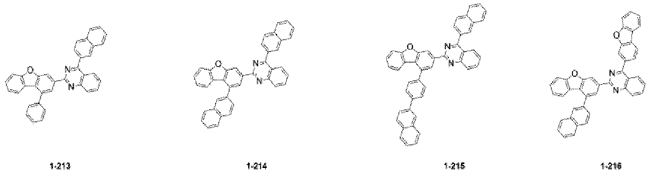

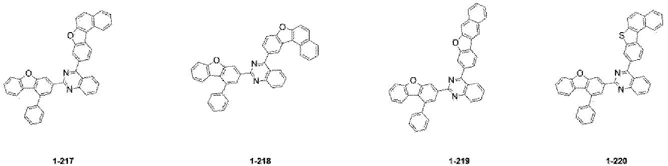

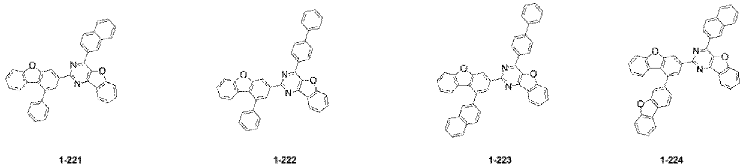

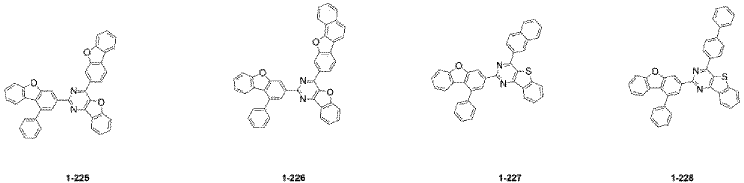

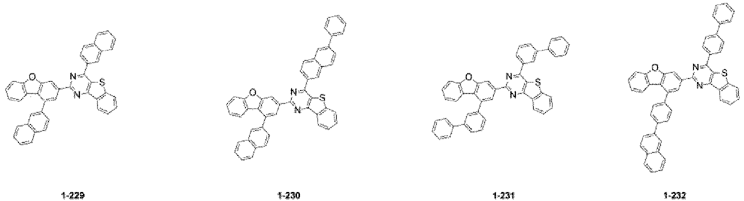

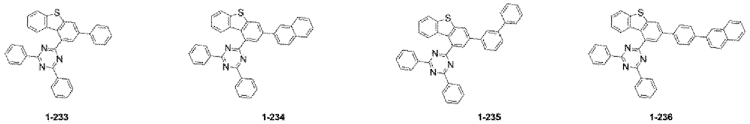

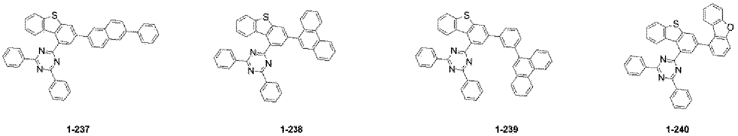

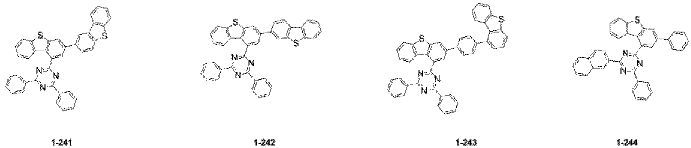

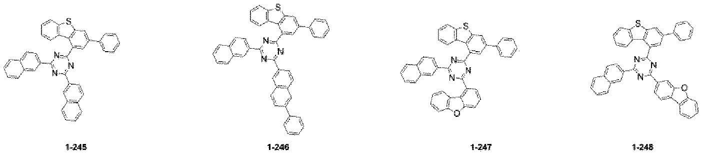

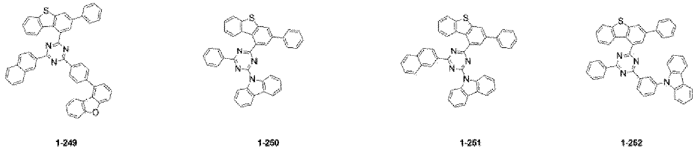

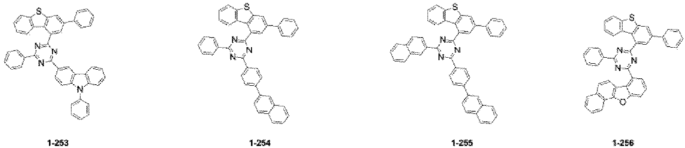

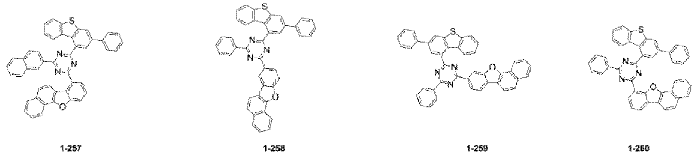

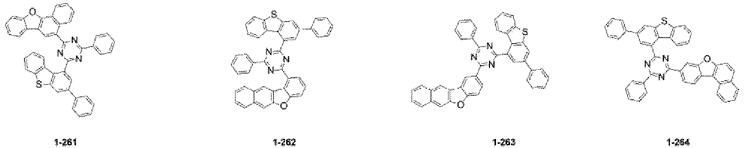

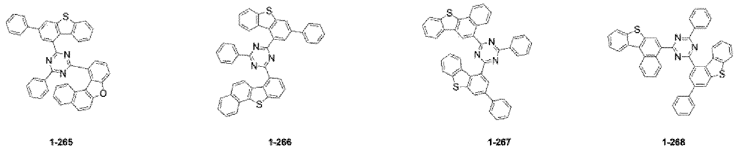

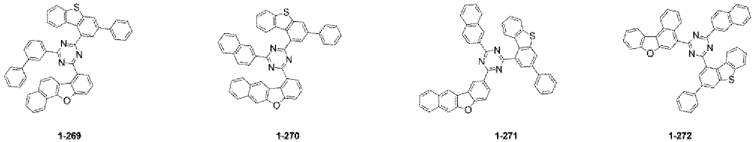

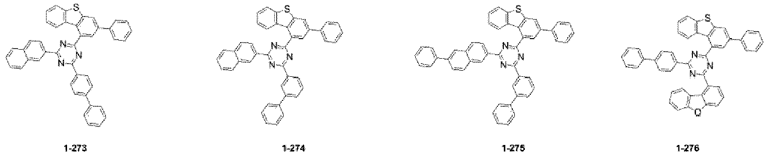

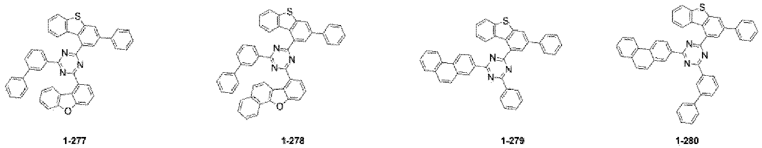

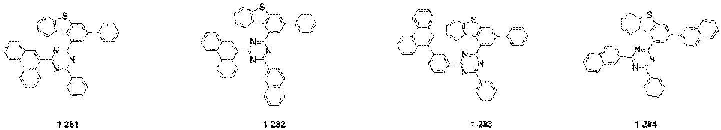

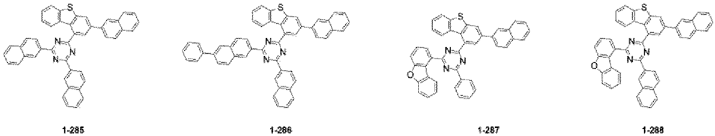

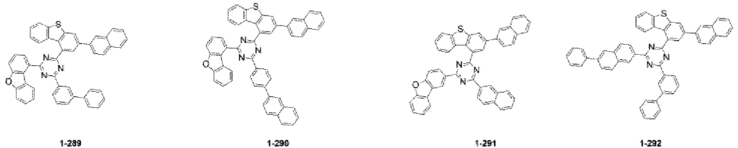

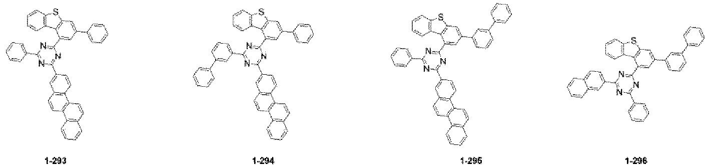

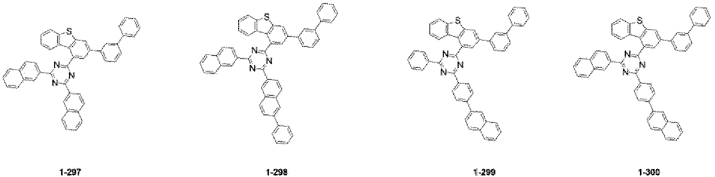

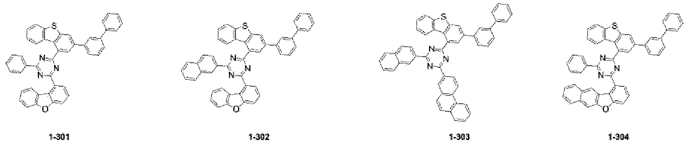

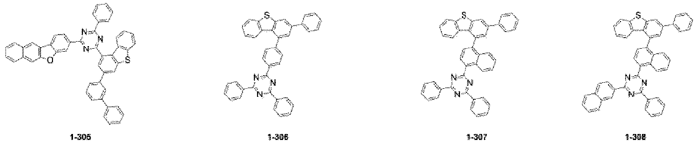

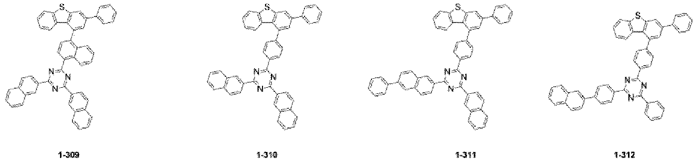

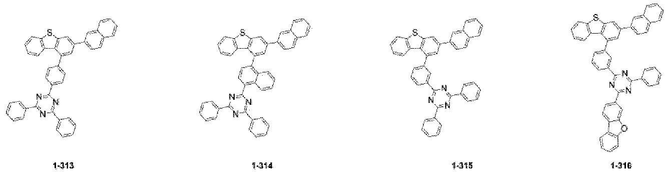

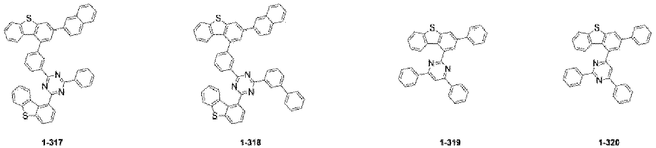

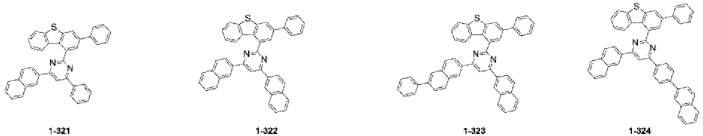

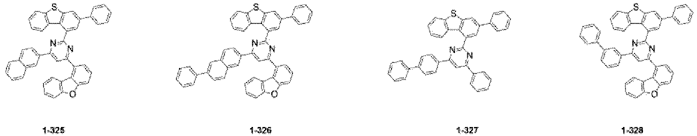

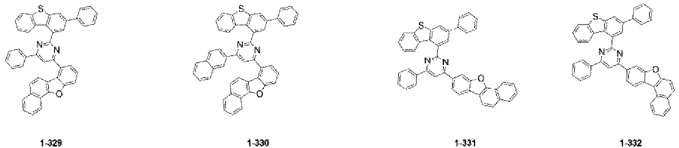

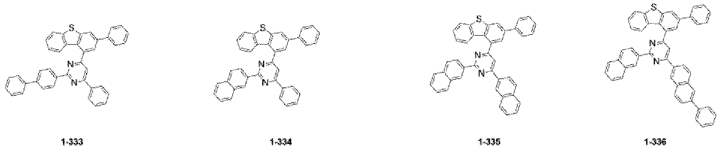

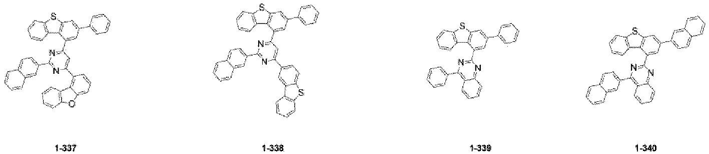

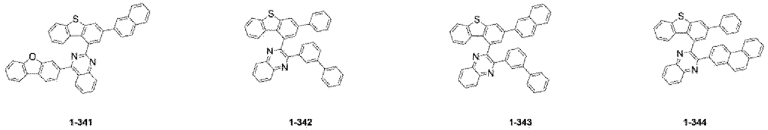

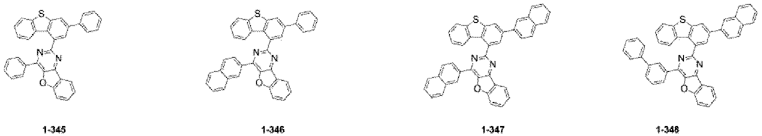

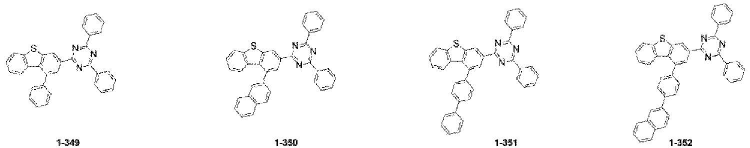

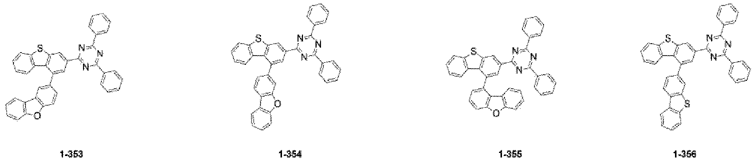

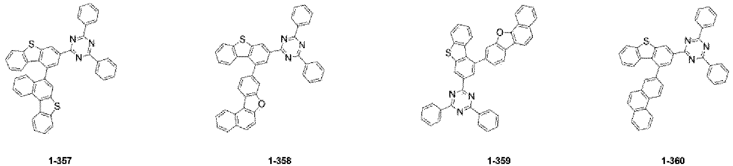

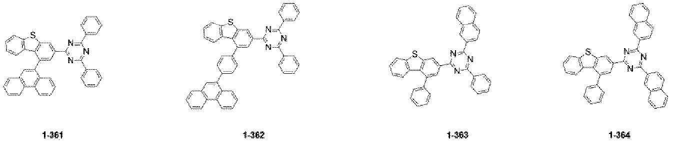

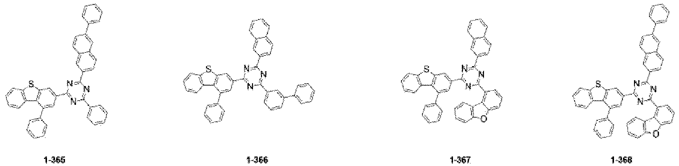

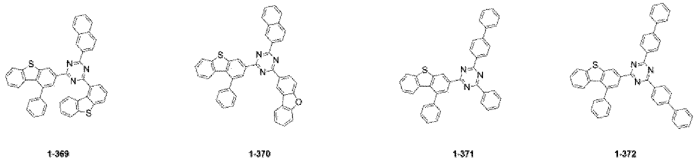

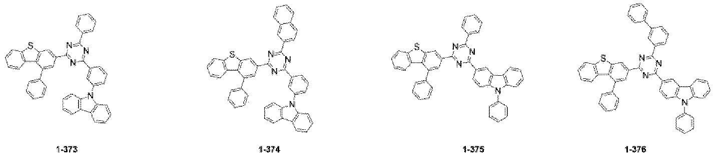

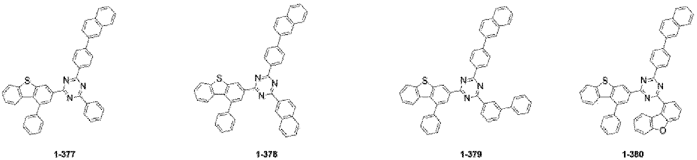

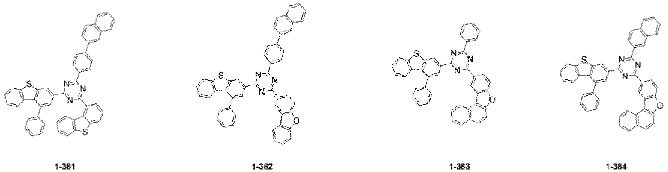

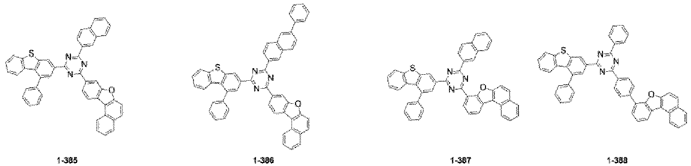

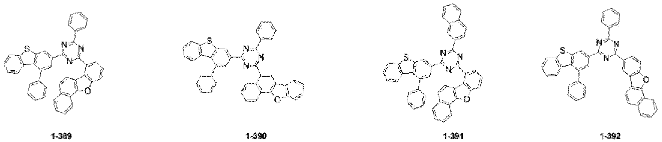

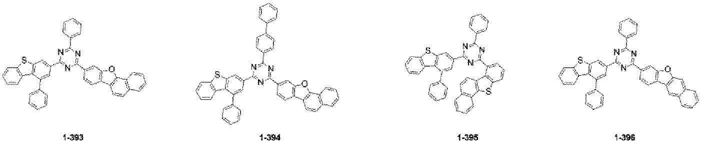

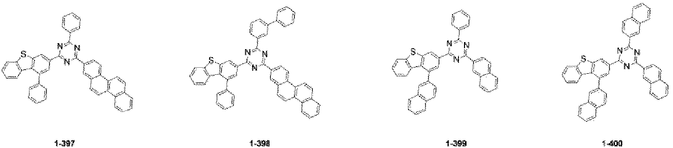

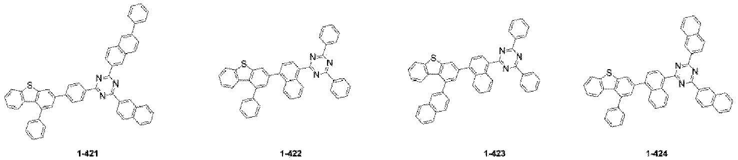

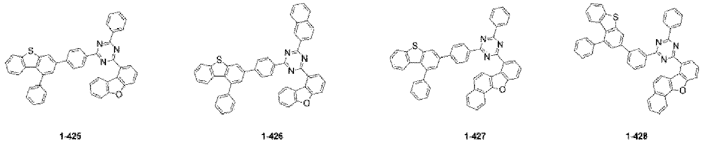

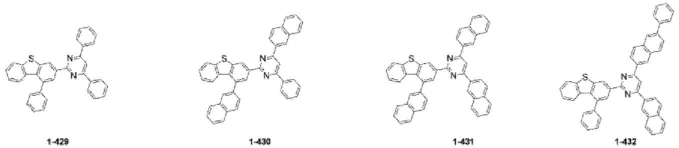

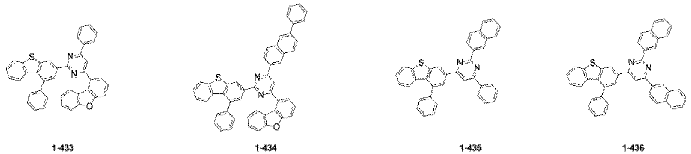

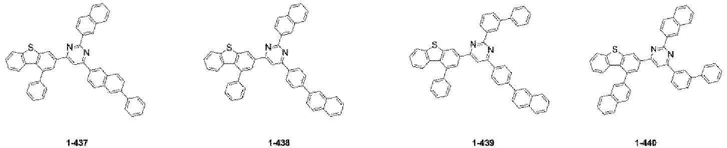

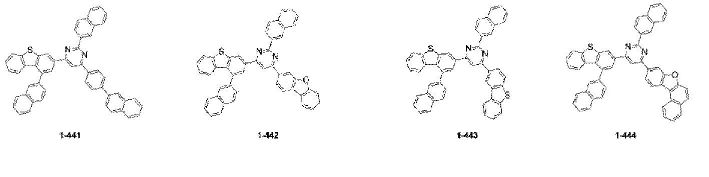

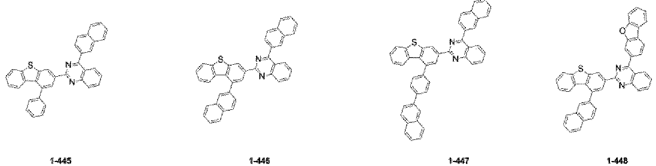

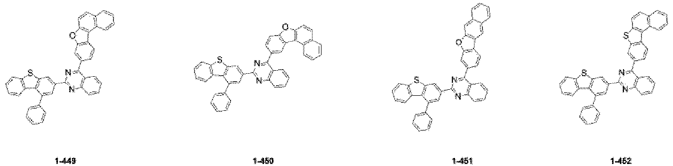

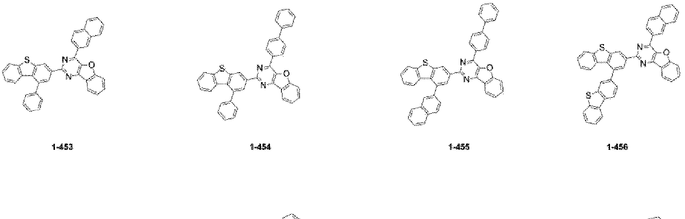

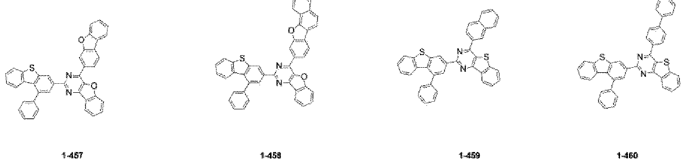

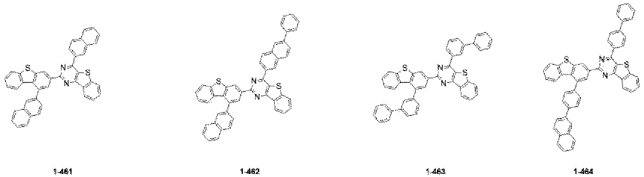

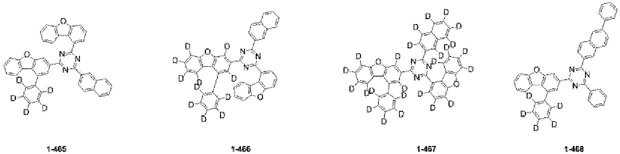

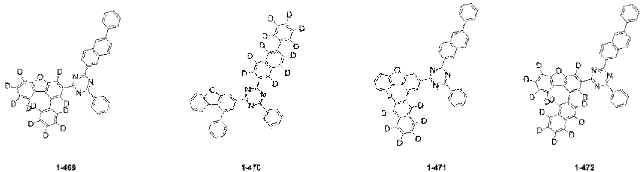

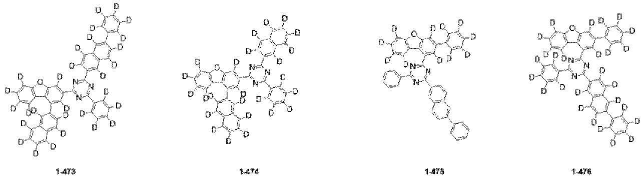

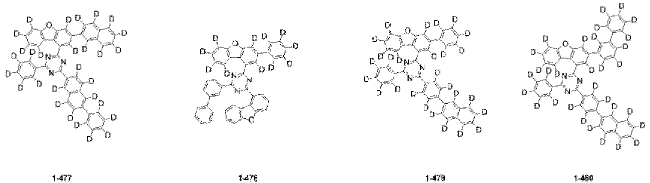

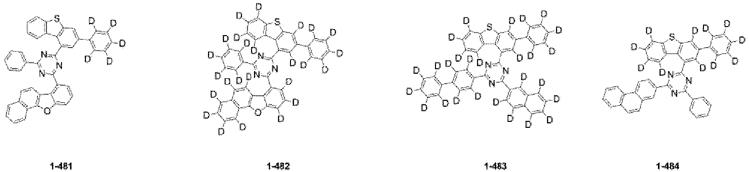

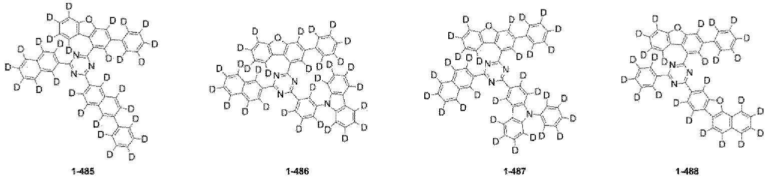

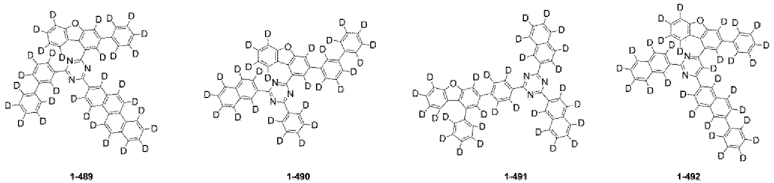

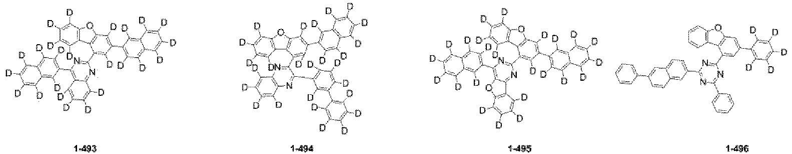

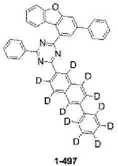

In an exemplary embodiment of the present application, Z2 and Z3 are each independently a substituted or unsubstituted amine group; a substituted or unsubstituted C6 to C40 aryl group; or a substituted or unsubstituted C2 to C40 heteroaryl group, any one of Z2 and Z3 is a substituted or unsubstituted amine group, and the other may be a substituted or unsubstituted C6 to C40 aryl group; or a substituted or unsubstituted C2 to C40 heteroaryl group.

In another exemplary embodiment, Z2 and Z3 are each independently a substituted or unsubstituted amine group; a substituted or unsubstituted C6 to C20 aryl group; or a substituted or unsubstituted C2 to C20 heteroaryl group, any one of Z2 and Z3 is a substituted or unsubstituted amine group, and the other may be a substituted or unsubstituted C6 to C20 aryl group; or a substituted or unsubstituted C2 to C20 heteroaryl group.

In still another exemplary embodiment, Z2 and Z3 are each independently an amine group substituted with a substituted or unsubstituted C6 to C60 aryl group or a substituted or unsubstituted C2 to C60 heteroaryl group; a substituted or unsubstituted phenyl group; a substituted or unsubstituted naphthyl group; a substituted or unsubstituted dibenzofuran group; or a substituted or unsubstituted dibenzothiophene group, any one of Z2 and Z3 is an amine group substituted with a substituted or unsubstituted C6 to C60 aryl group or a substituted or unsubstituted C2 to C60 heteroaryl group, and the other may be a substituted or unsubstituted phenyl group; a substituted or unsubstituted naphthyl group; a substituted or unsubstituted dibenzofuran group; or a substituted or unsubstituted dibenzothiophene group.

In yet another exemplary embodiment, Z2 and Z3 are each independently an amine group substituted with a substituted or unsubstituted C6 to C20 aryl group or a substituted or unsubstituted C2 to C20 heteroaryl group; a phenyl group unsubstituted or substituted with deuterium; a naphthyl group; a dibenzofuran group; or a dibenzothiophene group, any one of Z2 and Z3 is an amine group substituted with a substituted or unsubstituted C6 to C20 aryl group or a substituted or unsubstituted C2 to C20 heteroaryl group, and the other may be a phenyl group unsubstituted or substituted with deuterium; a naphthyl group; a dibenzofuran group; or a dibenzothiophene group.

In an exemplary embodiment of the present application, L3 and L4 are the same as or different from each other, and may be each independently a direct bond; or a substituted or unsubstituted C6 to C40 arylene group.

In yet another exemplary embodiment, L3 and L4 are the same as or different from each other, and may be each independently a direct bond; or a substituted or unsubstituted C6 to C20 arylene group.

In still another exemplary embodiment, L3 and L4 are the same as or different from each other, and may be each independently a direct bond; a substituted or unsubstituted phenylene group; or a substituted or unsubstituted naphthylene group.

In yet another exemplary embodiment, L3 and L4 are the same as or different from each other, and may be each independently a direct bond; a phenylene group which is unsubstituted or substituted with deuterium; or a naphthylene group.

In an exemplary embodiment of the present application, R7 and R8 are the same as or different from each other, and may be each independently hydrogen; deuterium; a halogen group; -CN; a substituted or unsubstituted C1 to C40 alkyl group; a substituted or unsubstituted C6 to C40 aryl group; or a substituted or unsubstituted C2 to C40 heteroaryl group.

In another exemplary embodiment, R7 and R8 are the same as or different from each other, and may be each independently hydrogen; deuterium; a halogen group; -CN; a substituted or unsubstituted C1 to C20 alkyl group; a substituted or unsubstituted C6 to C20 aryl group; or a substituted or unsubstituted C2 to C20 heteroaryl group.

In still another exemplary embodiment, R7 and R8 are the same as or different from each other, and may be each independently hydrogen; or deuterium.

In an exemplary embodiment of the present application, c and d are each an integer from 0 to 2, and when c is 2, L3's are the same as or different from each other, and when d is 2, L4's may be the same as or different from each other.

In another exemplary embodiment, c and d may be each 0 or 1.

In an exemplary embodiment of the present application, c and d are each an integer from 0 to 2, and when c is 2, L3's are the same as or different from each other, and when d is 2, L4's may be the same as or different from each other.

In another exemplary embodiment, c and d may be 1.

In an exemplary embodiment of the present application, r and s are each an integer from 0 to 2, and when s is 2, R7's are the same as or different from each other, and when t is 2, R8's may be the same as or different from each other.

In another exemplary embodiment, r and s may be each 0 or 1.

In an exemplary embodiment of the present application, p2 and p3 are each an integer from 1 to 2, and when p2 is 2, Z2's are the same as or different from each other, and when p3 is 2, Z3's may be the same as or different from each other.

In another exemplary embodiment, p2 and p3 may be 1.

In an exemplary embodiment of the present application, r is an integer from 0 to 4, and when r is 2 or higher, R7's may be the same as or different from each other.

In another exemplary embodiment, r is an integer from 0 to 3, and when r is 2 or higher, R7's may be the same as or different from each other.

In still another exemplary embodiment, r is an integer from 0 to 2, and when r is 2, R7's may be the same as or different from each other.

In yet another exemplary embodiment, r may be 1.

In an exemplary embodiment of the present application, s is an integer from 0 to 3, and when s is 2 or higher, R8's may be the same as or different from each other.

In another exemplary embodiment, s is an integer from 0 to 2, and when s is 2, R8's may be the same as or different from each other.

In still another exemplary embodiment, s may be 1.

In an exemplary embodiment of the present application, Chemical Formula 2 may be represented by the following Chemical Formula 2-1 or Chemical Formula 2-2.

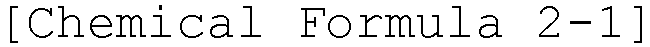

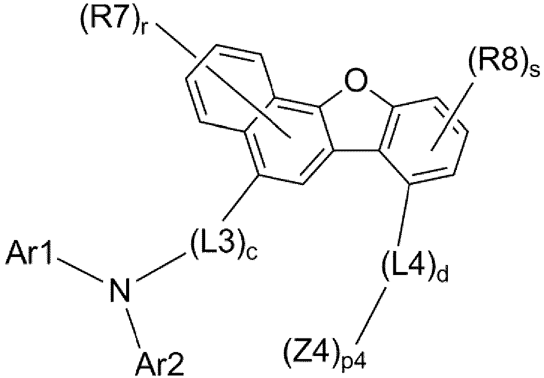

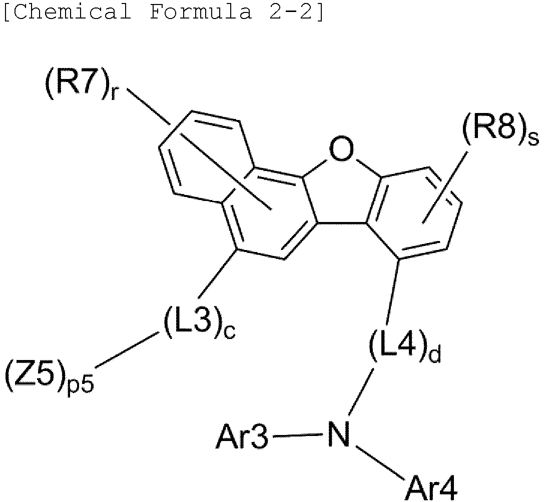

In Chemical Formulae 2-1 and 2-2,
L3, L4, R7, R8, c, d, r and s are the same as the definitions in Chemical Formula 2,
Ar1 to Ar4 are the same as or different from each other, and are each independently a substituted or unsubstituted C6 to C60 aryl group; or a substituted or unsubstituted C2 to C60 heteroaryl group,
Z4 and Z5 are the same as or different from each other, and are each independently a substituted or unsubstituted C6 to C60 aryl group; or a substituted or unsubstituted C2 to C60 heteroaryl group, and
p4 and p5 are each an integer from 1 to 3, and when p4 is 2 or higher, Z4's are the same as or different from each other, and when p5 is 2 or higher, Z5's are the same as or different from each other.

In an exemplary embodiment of the present application, Z4 and Z5 may be each independently a substituted or unsubstituted C6 to C40 aryl group; or a substituted or unsubstituted C2 to C40 heteroaryl group.

In another exemplary embodiment, Z4 and Z5 may be each independently a substituted or unsubstituted C6 to C20 aryl group; or a substituted or unsubstituted C2 to C20 heteroaryl group.

In still another exemplary embodiment, Z4 and Z5 may be each independently a substituted or unsubstituted phenyl group; a substituted or unsubstituted naphthyl group; a substituted or unsubstituted dibenzofuran group; or a substituted or unsubstituted dibenzothiophene group.

In yet another exemplary embodiment, Z4 and Z5 may be each independently a phenyl group which is unsubstituted or substituted with deuterium; a naphthyl group; a dibenzofuran group; or a dibenzothiophene group.

In an exemplary embodiment of the present application, Ar1 to Ar4 are the same as or different from each other, and are each independently a substituted or unsubstituted C6 to C40 aryl group; or a substituted or unsubstituted C2 to C40 heteroaryl group.

In another exemplary embodiment, Ar1 to Ar4 are the same as or different from each other, and are each independently a substituted or unsubstituted C6 to C20 aryl group; or a substituted or unsubstituted C2 to C20 heteroaryl group.

In still another exemplary embodiment, Ar1 to Ar4 are the same as or different from each other, and may be each independently a substituted or unsubstituted phenyl group; a substituted or unsubstituted biphenyl group; a substituted or unsubstituted terphenyl group; a substituted or unsubstituted naphthyl group; a substituted or unsubstituted fluorenyl group; a substituted or unsubstituted dibenzofuran group; a substituted or unsubstituted dibenzothiophene group; a substituted or unsubstituted naphthobenzofuran group; or a substituted or unsubstituted naphthobenzothiophene group.

In yet another exemplary embodiment, Ar1 to Ar4 are the same as or different from each other, and may be each independently a phenyl group unsubstituted or substituted with deuterium, a naphthyl group unsubstituted or substituted with deuterium, a phenanthrene group unsubstituted or substituted with deuterium, a dibenzofuran group or a dibenzothiophene group; a biphenyl group unsubstituted or substituted with deuterium or a dibenzofuran group; a terphenyl group unsubstituted or substituted with deuterium; a naphthyl group unsubstituted or substituted with deuterium or a phenyl group unsubstituted or substituted with deuterium; a fluorenyl group unsubstituted or substituted with one or more selected from the group consisting of deuterium, an alkyl group and an aryl group; a dibenzofuran group unsubstituted or substituted with deuterium; a dibenzothiophene group; a naphthobenzofuran group; or a naphthobenzothiophene group.

In an exemplary embodiment of the present application, any one of Ar1 and Ar2 is a substituted or unsubstituted C6 to C40 aryl group, and the other may be a substituted or unsubstituted C6 to C40 aryl group; or a substituted or unsubstituted C2 to C40 heteroaryl group.

In an exemplary embodiment of the present application, any one of Ar3 and Ar4 is a substituted or unsubstituted C6 to C40 aryl group, and the other may be a substituted or unsubstituted C6 to C40 aryl group; or a substituted or unsubstituted C2 to C40 heteroaryl group.

In an exemplary embodiment of the present application, the deuterium content of the compound of Chemical Formula 2 may be 0%, or 1% to 100%.

In an exemplary embodiment of the present application, the deuterium content of the compound of Chemical Formula 2 may be 0%, or 10% to 100%.

In an exemplary embodiment of the present application, the deuterium content of the compound of Chemical Formula 2 may be 0%, or 15% to 100%.

In an exemplary embodiment of the present application, the deuterium content of the compound of Chemical Formula 2 may be 0%, or 30% to 100%.

In an exemplary embodiment of the present application, the deuterium content of the compound of Chemical Formula 2 may be 0%, or 50% to 100%.

In an exemplary embodiment of the present application, the deuterium content of the compound of Chemical Formula 2 may be 0%, or 70% to 100%.

In an exemplary embodiment of the present application, the deuterium content of the compound of Chemical Formula 2 may be 0%, or 90% to 100%.

In an exemplary embodiment of the present application, the deuterium content of the compound of Chemical Formula 2 may be 0%.

In an exemplary embodiment of the present application, the deuterium content of the compound of Chemical Formula 2 may be 15% to 100%.

In an exemplary embodiment of the present application, the deuterium content of the compound of Chemical Formula 2 may be 30% to 100%.

In an exemplary embodiment of the present application, the deuterium content of the compound of Chemical Formula 2 may be 50% to 100%.

In an exemplary embodiment of the present application, the deuterium content of the compound of Chemical Formula 2 may be 70% to 100%.

In an exemplary embodiment of the present application, the deuterium content of the compound of Chemical Formula 2 may be 90% to 100%.

In an exemplary embodiment of the present application, provided is a compound in which Chemical Formula 2 is represented by any one of the following compounds.

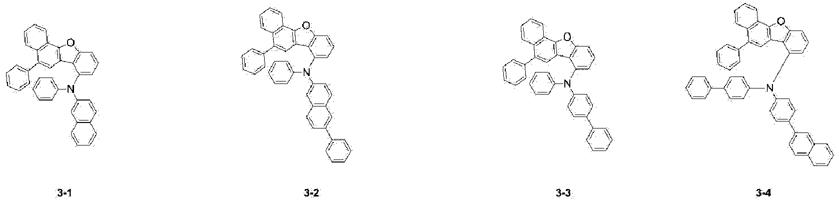

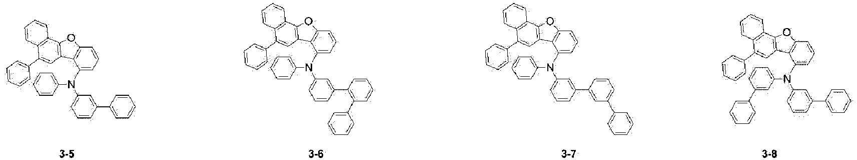

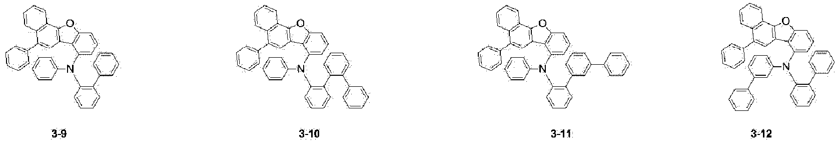

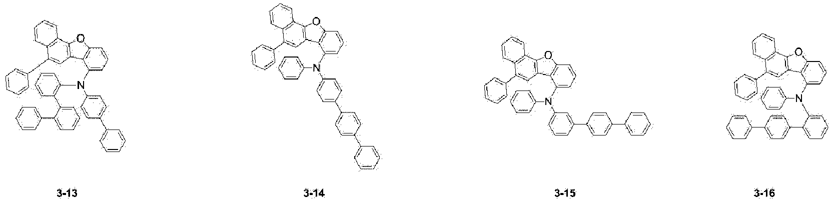

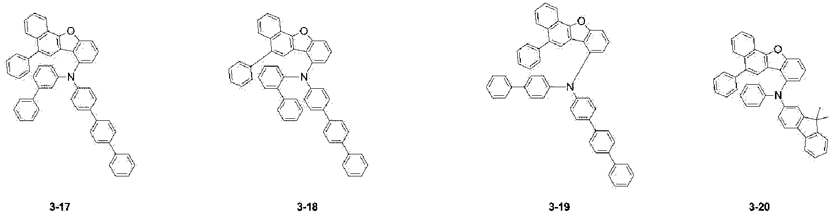

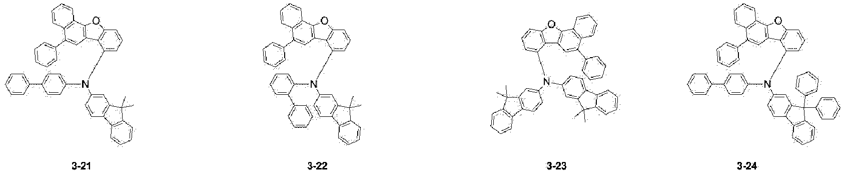

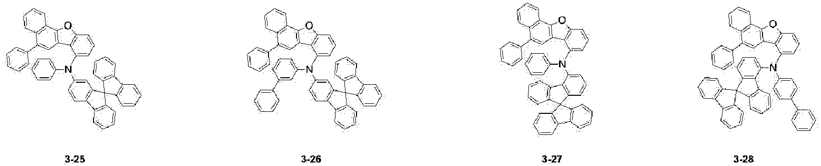

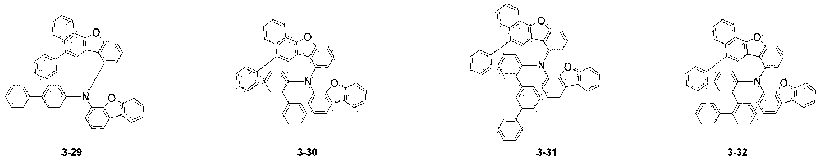

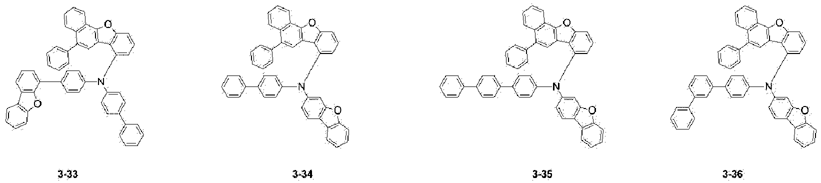

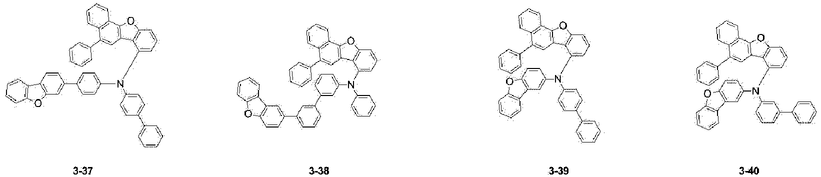

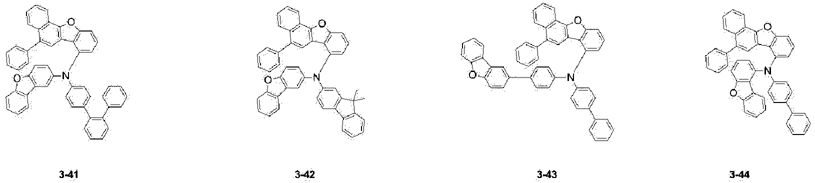

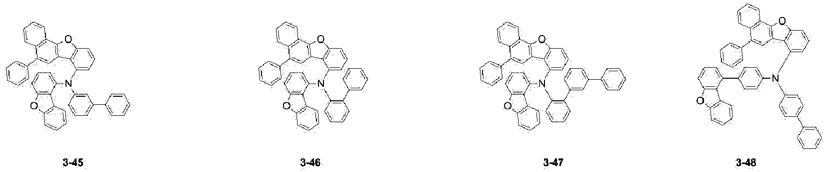

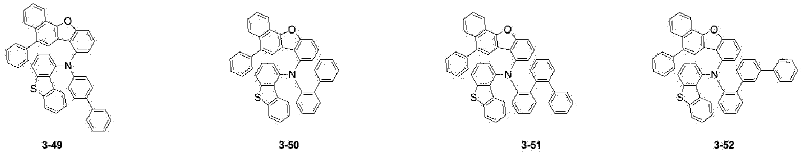

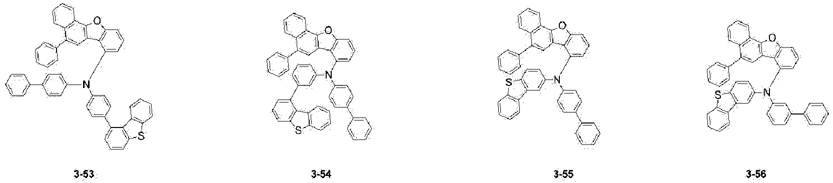

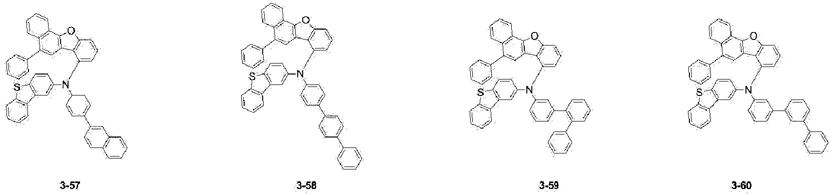

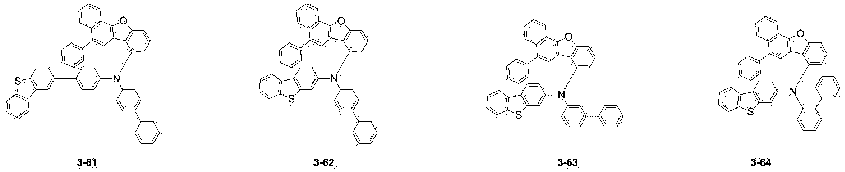

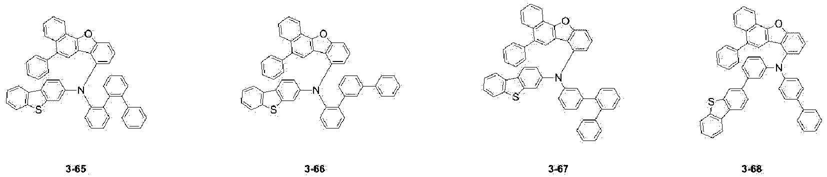

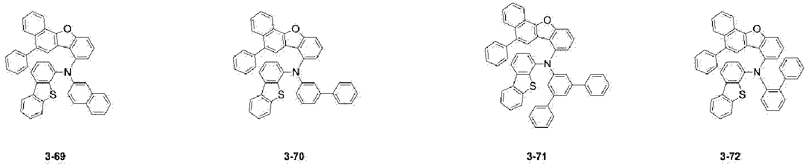

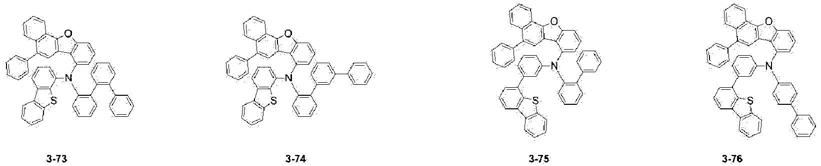

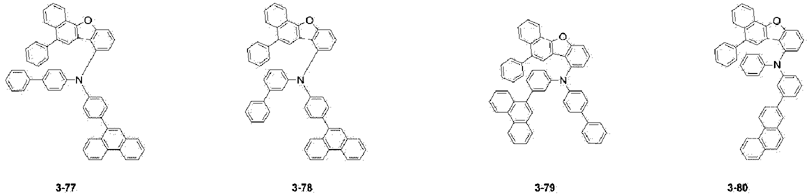

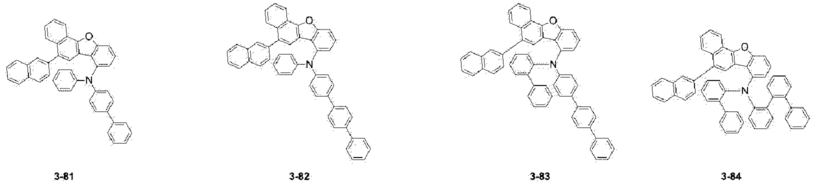

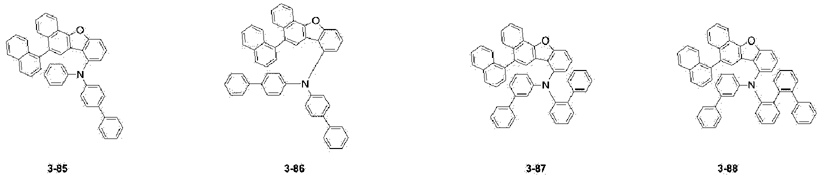

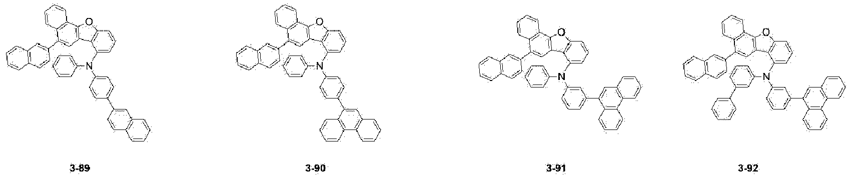

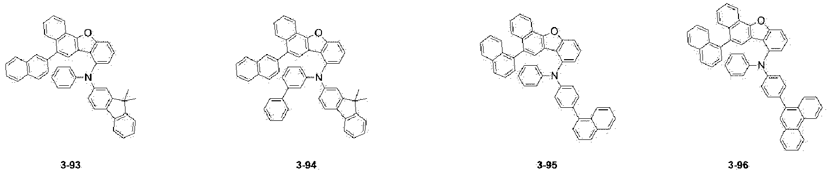

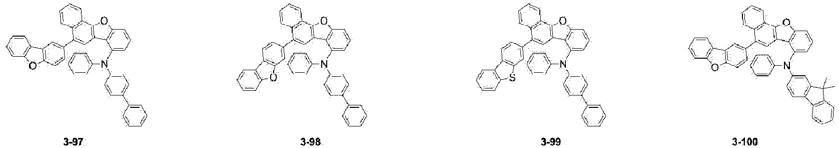

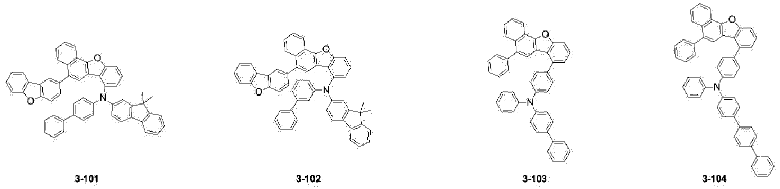

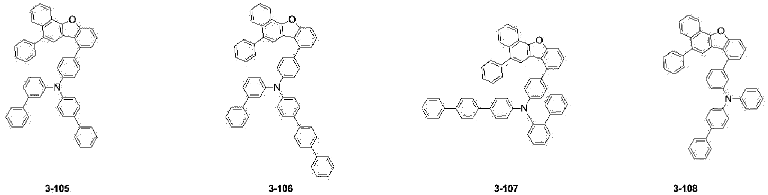

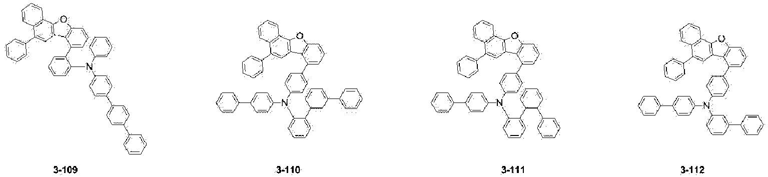

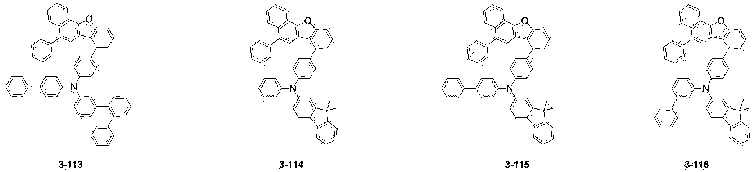

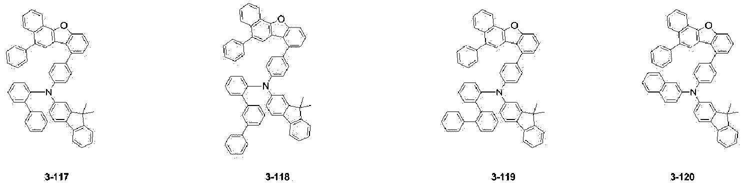

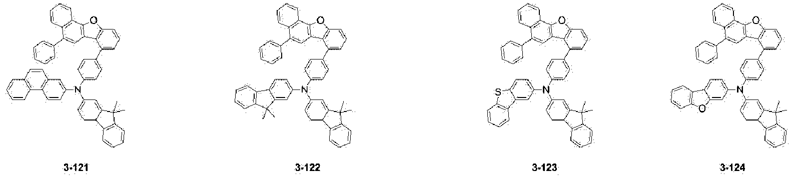

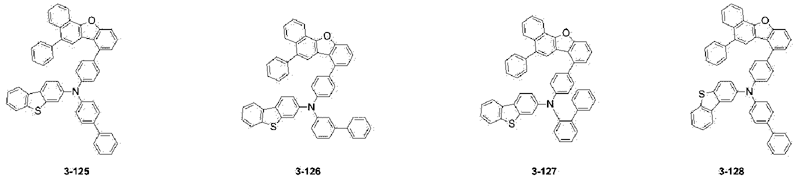

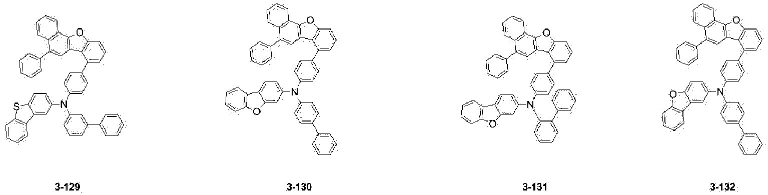

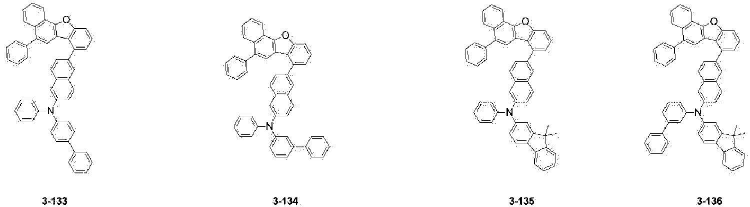

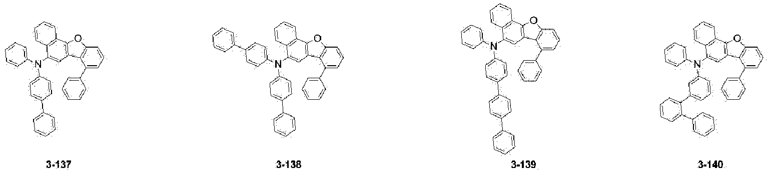

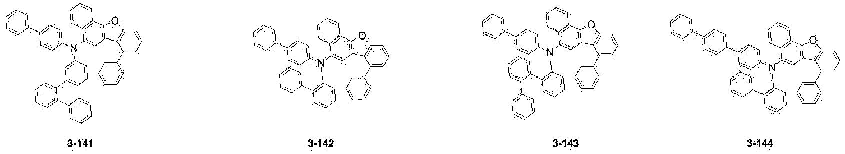

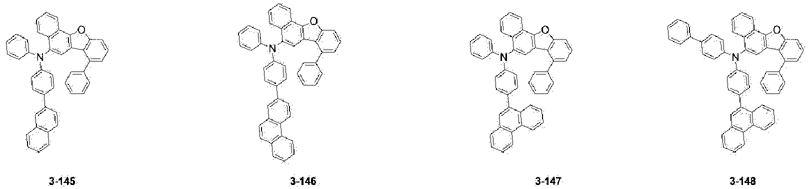

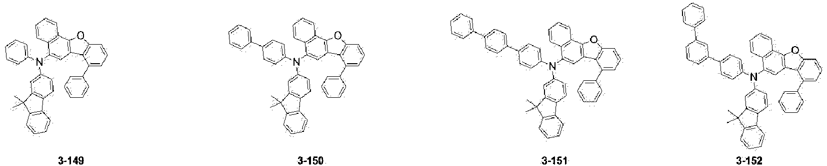

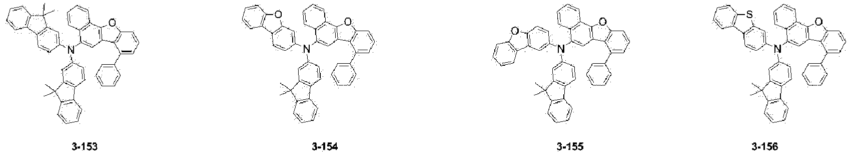

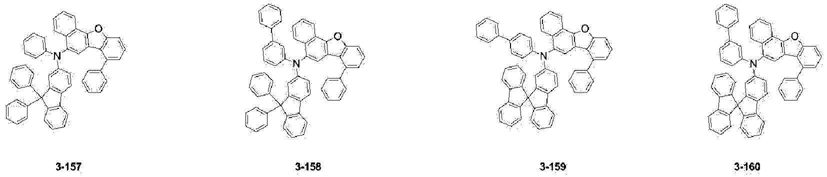

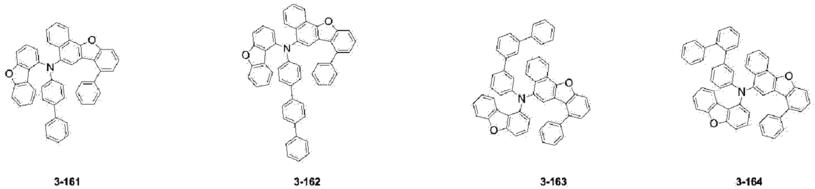

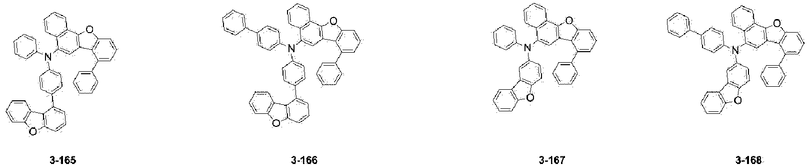

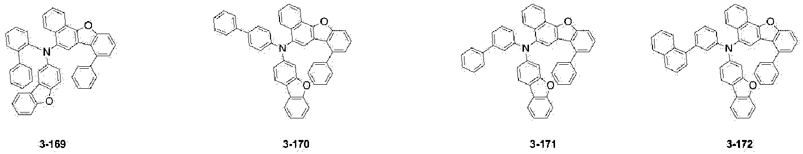

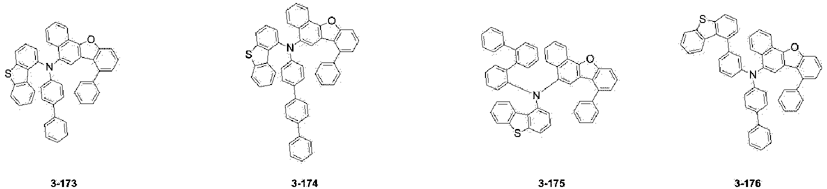

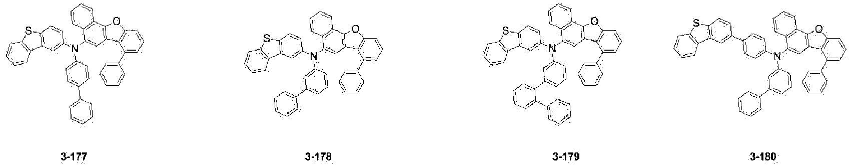

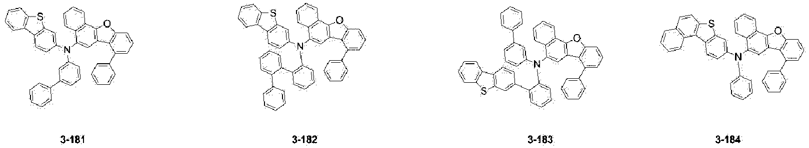

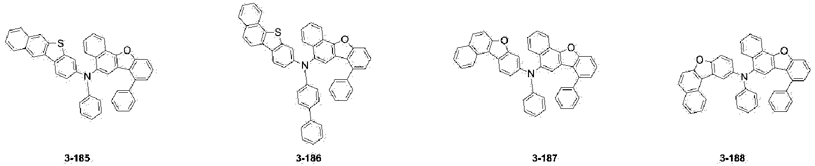

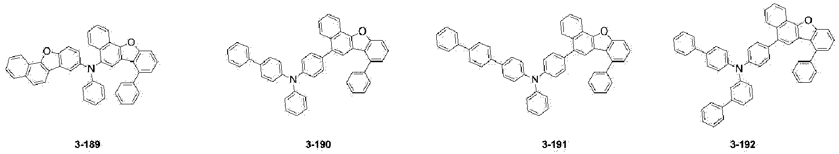

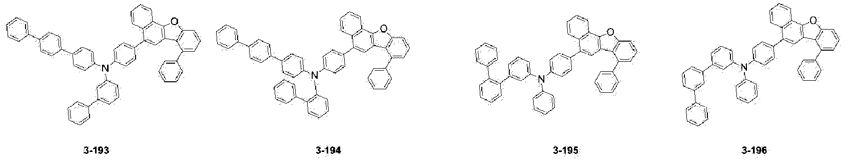

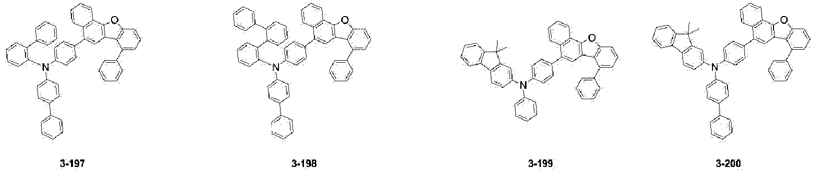

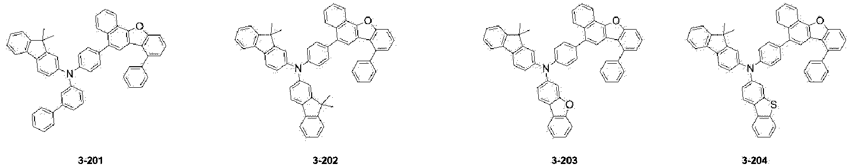

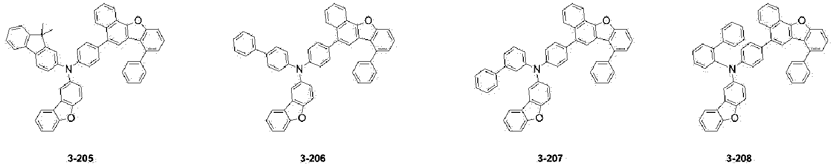

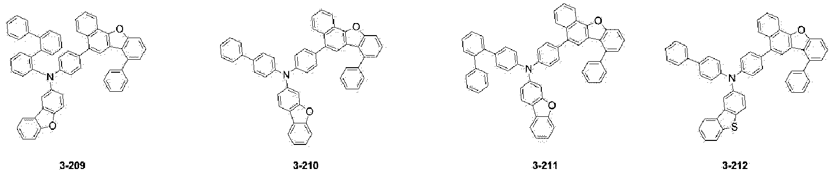

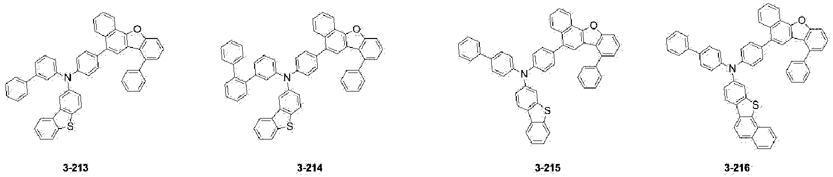

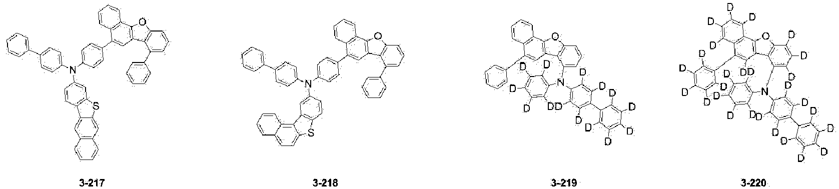

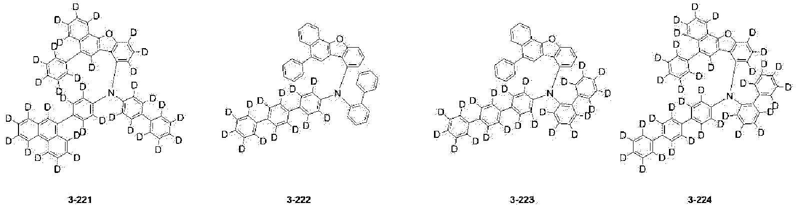

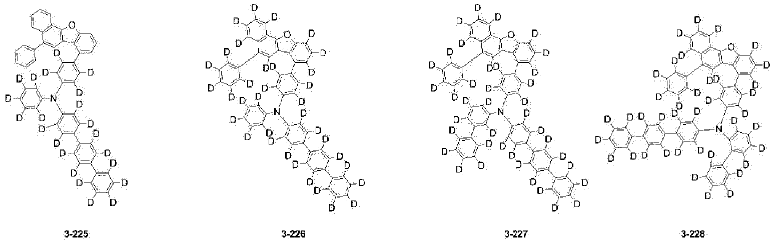

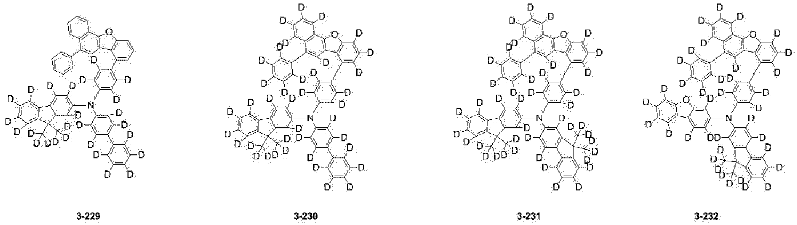

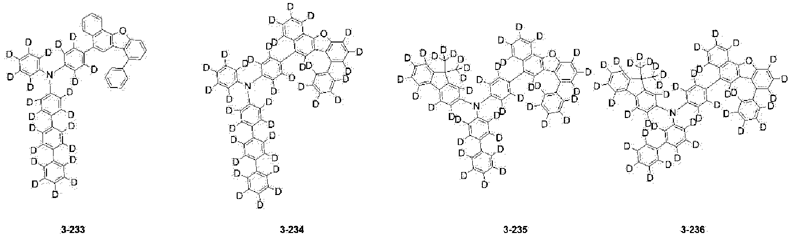

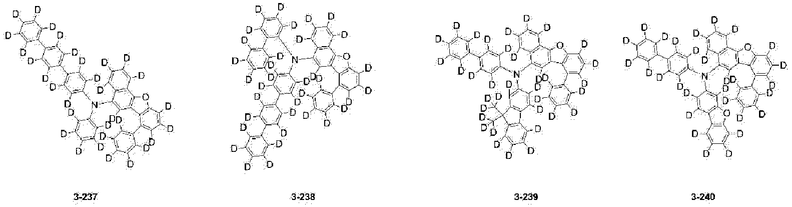

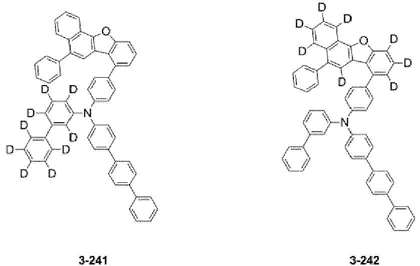

In an exemplary embodiment of the present application, the compound is just one example and is not limited thereto, and may include other compounds included in Chemical Formulae 1 and 2 which include an additional substituent. In addition, the substitution position of deuterium of the compound may be present while a specific position is excluded and hydrogen and deuterium are mixed during the process of deuterium substitution and synthesis.

Further, it is possible to synthesize a compound having inherent characteristics of a substituent introduced by introducing various substituents into the structures of Chemical Formulae 1 and 2. For example, a substituent usually used for a hole injection material, a hole transport material, a light emitting material, an electron transport material and an electron injection material, which are used when manufacturing an organic light emitting device, may be introduced into the core structure to synthesize a material which satisfies conditions required for each organic material layer.

In addition, by introducing various substituents into the structures of Chemical Formulae 1 and 2 or changing the binding position, the bandgap may be finely adjusted, and meanwhile, the characteristics at the interface between the organic material layers may be improved.

Furthermore, the compounds of Chemical Formulae 1 and 2 have excellent thermal stability, and such thermal stability provides driving stability to the organic light emitting device and improves service life characteristics.

In an exemplary embodiment of the present application, the organic material layer includes a light emitting layer, and the light emitting layer may include the compound of Chemical Formula 1 and the compound of Chemical Formula 2. That is, the compounds of Chemical Formulae 1 and 2 may be used as a light emitting material for the light emitting layer of the organic light emitting device.

In another exemplary embodiment, the compounds of Chemical Formulae 1 and 2 may be used as host materials for the light emitting layer of the organic light emitting device.
In an exemplary embodiment of the present application, the first electrode may be a positive electrode, and the second electrode may be a negative electrode.

In another exemplary embodiment, the first electrode may be a negative electrode, and the second electrode may be a positive electrode.

In an exemplary embodiment of the present application, the organic light emitting device may be a blue organic light emitting device, and the compounds according to Chemical Formulae 1 and 2 may be used as materials for the blue organic light emitting device.

In an exemplary embodiment of the present application, the organic light emitting device may be a green organic light emitting device, and the compounds according to Chemical Formulae 1 and 2 may be used as materials for the green organic light emitting device.

In an exemplary embodiment of the present application, the organic light emitting device may be a red organic light emitting device, and the compounds according to Chemical Formulae 1 and 2 may be used as materials for the red organic light emitting device.

In an exemplary embodiment of the present application, the organic light emitting device may be a blue organic light emitting device, and the compounds according to Chemical Formulae 1 and 2 may be used as materials for the light emitting layer of the blue organic light emitting device.

In an exemplary embodiment of the present application, the organic light emitting device may be a green organic light emitting device, and the compounds according to Chemical Formulae 1 and 2 may be used as materials for the light emitting layer of the green organic light emitting device.

In an exemplary embodiment of the present application, the organic light emitting device may be a red organic light emitting device, and the compounds according to Chemical Formulae 1 and 2 may be used as materials for the light emitting layer of the red organic light emitting device.

The organic light emitting device of the present invention may be manufactured using typical manufacturing methods and materials of an organic light emitting device, except that the above-described heterocyclic compound is used to form an organic material layer having one or more layers.

The heterocyclic compound may be formed as an organic material layer by not only a vacuum deposition method, but also a solution application method when an organic light emitting device is manufactured. Here, the solution application method means spin coating, dip coating, inkjet printing, screen printing, a spray method, roll coating, and the like, but is not limited thereto.

The organic material layer of the organic light emitting device of the present invention may be composed of a single-layered structure, but may be composed of a multilayered structure in which two or more organic material layers are stacked. For example, the organic light emitting device of the present invention may have a structure including a hole injection layer, a hole transport layer, a light emitting layer, an electron transport layer, an electron injection layer, and the like as organic material layers. However, the structure of the organic light emitting device is not limited thereto, and may include a fewer number of organic material layers.

In an exemplary embodiment of the present application, as the iridium-based dopant, Ir(ppy)₃, which is a green phosphorescent dopant, may be used.

In an exemplary embodiment of the present application, as the iridium-based dopant, (piq)₂(Ir)(acac), which is a red phosphorescent dopant, may be used.

In the organic light emitting device of the present application, the organic material layer includes an electron injection layer or an electron transport layer, and the electron injection layer or the electron transport layer may include the compound of Chemical Formula 1, the compound of Chemical Formula 2, or a combination thereof.

In another organic light emitting device, the organic material layer includes a hole blocking layer, and the hole blocking layer may include the compound of Chemical Formula 1, the compound of Chemical Formula 2, or a combination thereof.

In still another organic light emitting device, the organic material layer includes an electron blocking layer, and the electron blocking layer may include the compound of Chemical Formula 1, the compound of Chemical Formula 2, or a combination thereof.

In yet another organic light emitting device, the organic material layer includes a hole transport layer, a light emitting layer, or an electron blocking layer, and the hole transport layer, the light emitting layer, or the electron blocking layer may include the compound of Chemical Formula 1, the compound of Chemical Formula 2, or a combination thereof.

In still yet another organic light emitting device, the organic material layer includes a hole transport layer or a hole transport auxiliary layer, and the hole transport layer or the hole transport auxiliary layer may include the compound of Chemical Formula 1, the compound of Chemical Formula 2, or a combination thereof.

In the organic light emitting device of the present application, as a positive electrode material, materials having a relatively high work function may be used, and a transparent conductive oxide, a metal or a conductive polymer, and the like may be used. Specific examples of the positive electrode material include: a metal such as vanadium, chromium, copper, zinc, and gold, or an alloy thereof; a metal oxide such as zinc oxide, indium oxide, indium tin oxide (ITO), and indium zinc oxide (IZO); a combination of a metal and an oxide, such as ZnO:Al or SnO₂:Sb; a conductive polymer such as poly(3-methylthiophene), poly[3,4-(ethylene-1,2-dioxy)thiophene] (PEDOT), polypyrrole, and polyaniline; and the like, but are not limited thereto.

As a negative electrode material, materials having a relatively low work function may be used, and a metal, a metal oxide, or a conductive polymer, and the like may be used. Specific examples of the negative electrode material include: a metal such as magnesium, calcium, sodium, potassium, titanium, indium, yttrium, lithium, gadolinium, aluminum, silver, tin, and lead, or an alloy thereof; a multi-layer structured material, such as LiF/Al or LiO₂/Al; and the like, but are not limited thereto.

As a hole injection material, a publicly-known hole injection material may also be used, and it is possible to use, for example, a phthalocyanine compound such as copper phthalocyanine disclosed in US Patent No. 4,356,429 or starburst-type amine derivatives described in the document [Advanced Material, 6, p. 677 (1994)], for example, tris(4-carbazoyl-9-ylphenyl)amine (TCTA), 4,4',4"-tri[phenyl(m-tolyl)amino]triphenylamine (m-MTDATA), 1,3,5-tris[4-(3-methylphenylphenylamino)phenyl]benzene (m-MTDAPB), polyaniline/dodecylbenzenesulfonic acid or poly(3,4-ethylenedioxythiophene)/poly(4-styrenesulfonate), which is a soluble conductive polymer, polyaniline/camphor sulfonic acid or polyaniline/poly(4-styrene-sulfonate), and the like.

As a hole transport material, a pyrazoline derivative, an arylamine-based derivative, a stilbene derivative, a triphenyldiamine derivative, and the like may be used, and a low-molecular weight or polymer material may also be used.

As an electron transport material, it is possible to use an oxadiazole derivative, anthraquinodimethane and a derivative thereof, benzoquinone and a derivative thereof, naphthoquinone and a derivative thereof, anthraquinone and a derivative thereof, tetracyanoanthraquinodimethane and a derivative thereof, a fluorenone derivative, diphenyldicyanoethylene and a derivative thereof, a diphenoquinone derivative, a metal complex of 8-hydroxyquinoline and a derivative thereof, and the like, and a low-molecular weight material and a polymer material may also be used.

As an electron injection material, for example, LiF is representatively used in the art, but the present application is not limited thereto.

As a light emitting material, a red, green, or blue light emitting material may be used, and if necessary, two or more light emitting materials may be mixed and used. In this case, two or more light emitting materials are deposited or used as an individual supply source, or premixed to be deposited and used as one supply source. Further, a fluorescent material may also be used as the light emitting material, but may also be used as a phosphorescent material. As the light emitting material, it is also possible to use alone a material which emits light by combining holes and electrons each injected from a positive electrode and a negative electrode, but materials in which a host material and a dopant material are involved in light emission together may also be used.

When hosts of the light emitting material are mixed and used, the same series of hosts may also be mixed and used, and different series of hosts may also be mixed and used. For example, two or more types of materials selected from n-type host materials or p-type host materials may be used as a host material for a light emitting layer.

The organic light emitting device according to an exemplary embodiment of the present application may be a top emission type, a bottom emission type, or a dual emission type according to the material to be used.

The compound of Chemical Formula 1 and the compound of Chemical Formula 2 according to an exemplary embodiment of the present application may act even in organic electronic devices including organic solar cells, organic photoconductors, organic transistors, and the like, based on the principle similar to those applied to organic light emitting devices.

The organic light emitting device of the present invention may further include one or two or more layers selected from the group consisting of a light emitting layer, a hole injection layer, a hole transport layer, a hole transport auxiliary layer, an electron blocking layer, a hole blocking layer, an electron transport layer and an electron injection layer.

In another exemplary embodiment, the compound represented by Chemical Formula 1 may be used as a light emitting material for a light emitting layer of an organic light emitting device, and may be used as an n-type host material.

In still another exemplary embodiment, the heterocyclic compound represented by Chemical Formula 2 may be used as a light emitting material for a light emitting layer of an organic light emitting device, and may be used as a p-type host material.

In the organic light emitting device of the present application, the organic material layer may include the compound represented by Chemical Formula 1 and the compound represented by Chemical Formula 2. The organic material layer may be formed by pre-mixing the compound represented by Chemical Formula 1 and the compound represented by Chemical Formula 2 and using a thermal vacuum deposition method.

In an exemplary embodiment of the present application, provided is a method for manufacturing an organic light emitting device, the method including: preparing a substrate; forming a first electrode on the substrate; forming an organic material layer having one or more layers on the first electrode; and forming a second electrode on the organic material layer, in which the forming of the organic material layer includes forming the organic material layer having one or more layers by using the composition for an organic material layer according to an exemplary embodiment of the present application.

In an exemplary embodiment of the present application, provided is a method for manufacturing an organic light emitting device, in which the forming of the organic material layer forms the organic material layer by supplying the compound represented by Chemical Formula 1 and the compound represented by Chemical Formula 2 as each individual supply source, and then using a thermal vacuum deposition method.

In an exemplary embodiment of the present application, provided is a method for manufacturing an organic light emitting device, in which the forming of the organic material layer forms the organic material layer by pre-mixing the compound represented by Chemical Formula 1 and the compound represented by Chemical Formula 2, and using a thermal vacuum deposition method.

FIGS. 1 to 4 exemplify the stacking sequence of the electrodes and the organic material layer of the organic light emitting device according to an exemplary embodiment of the present application. However, the scope of the present application is not intended to be limited by these drawings, and the structure of the organic light emitting device known in the art may also be applied to the present application.

According to FIG. 1, an organic light emitting device in which a positive electrode 200, an organic material layer 300, and a negative electrode 400 are sequentially stacked on a substrate 100 is illustrated. However, the organic light emitting device is not limited only to such a structure, and as in FIG. 2, an organic light emitting device in which a negative electrode, an organic material layer, and a positive electrode are sequentially stacked on a substrate may also be implemented.

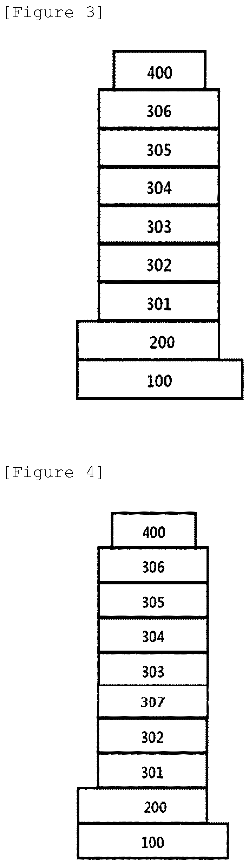

FIGS. 3 and 4 exemplify a case where an organic material layer is a multilayer.

An organic light emitting device according to FIG. 3 includes a hole injection layer 301, a hole transport layer 302, a light emitting layer 303, a hole blocking layer 304, an electron transport layer 305, and an electron injection layer 306.

An organic light emitting device according to FIG. 4 includes a hole injection layer 301, a hole transport layer 302, an electron blocking layer 307, a light emitting layer 303, a hole blocking layer 304, an electron transport layer 305, and an electron injection layer 306.

However, the scope of the present application is not limited by the stacking structure as described above, and if necessary, the other layers except for the light emitting layer may be omitted, and another necessary functional layer may be further added.

In an exemplary embodiment of the present application, provided is a composition for forming an organic material layer including the compound of Chemical Formula 1 and the compound of Chemical Formula 2.

The compound of Chemical Formula 1 and the compound of Chemical Formula 2 of the composition for forming an organic material layer are the same as the definitions in Compounds 1 and 2 described above.

The composition for forming an organic material layer according to an exemplary embodiment of the present application may include the compound of Chemical Formula 1 and the compound of Chemical Formula 2 at a weight ratio of 1:10 to 10:1, specifically at a weight ratio of 1:5 to 5:1 and 1:3 to 3:1.

The composition for forming an organic material layer according to an exemplary embodiment of the present application may be used as a material for a light emitting layer of an organic light emitting device.

The composition may be used when an organic material layer of an organic light emitting device is formed, and particularly, may be more preferably used as a host material for the light emitting layer.

The composition is in a form in which two or more compounds are simply mixed, materials in a powder state may also be mixed before an organic material layer of an organic light emitting device is formed, and it is possible to mix compounds in a liquid state at a temperature which is equal to or more than a suitable temperature. The composition is in a solid state at a temperature which is equal to or less than the melting point of each material, and may be maintained as a liquid phase when the temperature is adjusted.

The composition may additionally include materials publicly known in the art such as solvents and additives.

Hereinafter, the present specification will be described in more detail through Examples, but these Examples are provided only for exemplifying the present application, and are not intended to limit the scope of the present application.

### <Synthesis Examples>

### Preparation Example 1. Preparation of Compound 1-4

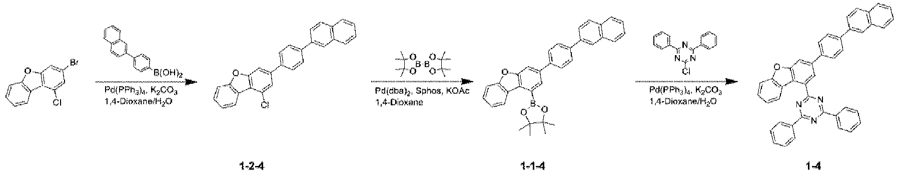

### Preparation Example 1-1. Preparation of Compound 1-2-4

After 30.0 g (106.6 mM) of 3-bromo-1-chlorodibenzo[b,d]furan, 26.4 g (106.6 mM) of (4-(naphthalen-2-yl)phenyl)boronic acid, 6.2 g (5.3 mM) of Pd(PPh₃)₄, and 29.5 g (213.2 mM) of K₂CO₃ were put into a 1 L two-neck flask and dissolved in 1,4-dioxane/H₂O (300 ml/600 ml), the resulting solution was refluxed for 1 hour. The reaction product was purified by column chromatography (DCM : Hex = 1 : 1) and 36.5g (84.6%) of Target Compound 1-2-4 was obtained.

### Preparation Example 1-2. Preparation of Compound 1-1-4

After 36.0 g (88.9 mM) of Compound 1-2-4, 33.9 g (133.4 mM) of 4,4,4',4',5,5,5',5'-octamethyl-2,2'-bi(1,3,2-dioxaborolane), 2.5 g (4.4 mM) of Pd(dba)₂, 3.7 g (8.9 mM) of Sphos, and 17.4 g (177.8 mM) of KOAc were put into a 1 L two-neck flask and dissolved in 1,4-dioxane (350 ml), the resulting solution was refluxed for 1 hour. The reaction product was purified by column chromatography (DCM : Hex = 1 : 4) and 35.3 g (80.0%) of Target Compound 1-1-4 was obtained.

### Preparation Example 1-3. Preparation of Compound 1-4

After 8.0 g (16.1 mM) of Compound 1-1-4, 4,3 g (16.1 mM) of 2-chloro-4,6-diphenyl-1,3,5-triazine, 0.9 g (0.8 mM) of Pd(PPh₃)₄, and 4.5 g (32.2 mM) of K₂CO₃ were put into a 250 ml two-neck flask and dissolved in 1,4-dioxane/H₂O (80 ml/15 ml), the resulting solution was refluxed for 1 hour. The reaction product was purified by recrystallization with methanol, and 8.3 g (85.7%) of Target Compound 1-4 was obtained.

The target compounds in the following Table 1 were synthesized by performing synthesis in the same manner as in Preparation Example 1, except that Intermediate A in the following Table 1 was used instead of (4-(naphthalen-2-yl)phenyl)boronic acid in Preparation Example 1 and Intermediate B in the following Table 1 was used instead of 2-chloro-4,6-diphenyl-1,3,5-triazine in Preparation Example 1.

**[Table 1]**

| **Compound No.** | **Intermediate A** | **Intermediate B** | **Target Comound** | **Yield** |
|---|---|---|---|---|
| 1-4 | 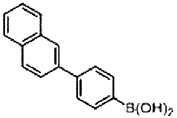 | 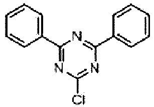 | 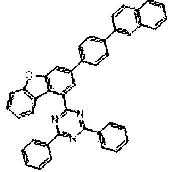 | 85.7% |
| 1-5 | | 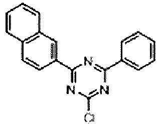 | 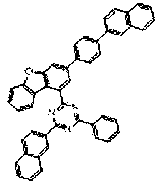 | 85.3% |
| 1-6 | | 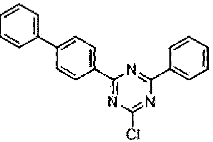 | 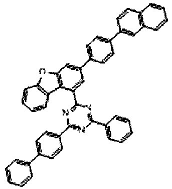 | 85.5% |
| 1-13 | 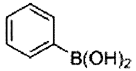 | 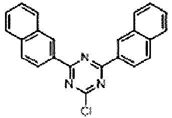 | 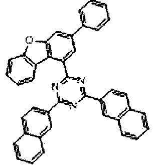 | 85.1% |
| 1-14 | | 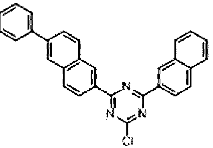 | 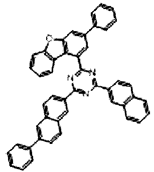 | 85.3% |
| 1-15 | | 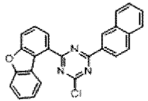 | 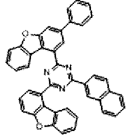 | 84.9% |
| 1-22 | | 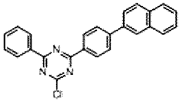 | 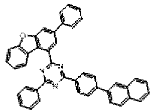 | 84.1% |
| 1-23 | | 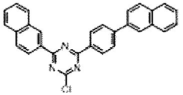 | 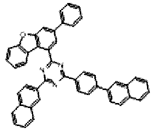 | 84.3% |
| 1-52 | 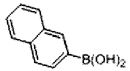 | 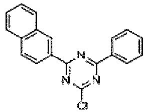 | 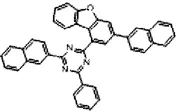 | 80.5% |
| 1-54 | | 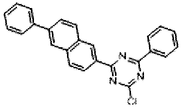 | 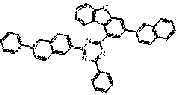 | 80.6% |
| 1-82 | | 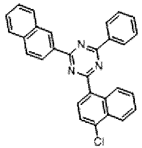 | 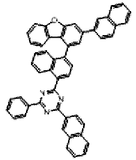 | 80.9% |
| 1-132 | 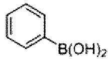 | 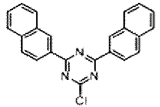 | 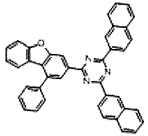 | 86.1% |
| 1-133 | | 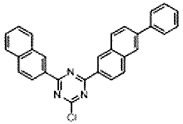 | 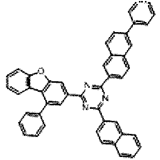 | 86.0% |
| 1-135 | | 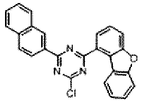 | 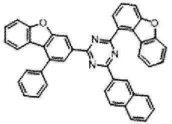 | 85.3% |
| 1-141 | | 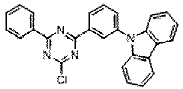 | 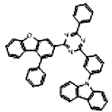 | 85.1% |
| 1-145 | | 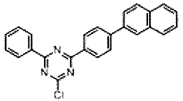 | 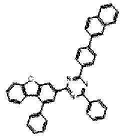 | 84.3% |
| 1-168 | 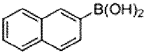 | 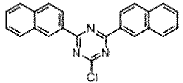 | 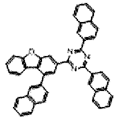 | 81.9% |
| 1-217 | 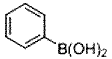 | 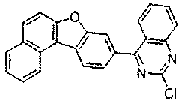 | 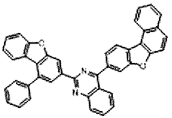 | 75.5% |
| 1-247 | | 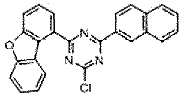 | 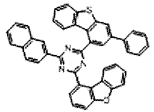 | 81.5% |
| 1-254 | | 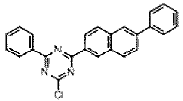 | 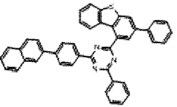 | 81.3% |
| 1-3 | 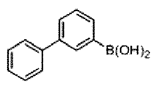 | 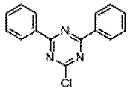 | 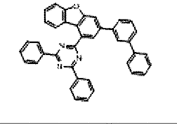 | 85.3% |
| 1-8 | 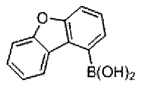 | | 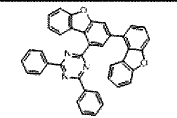 | 81.9% |
| 1-21 | 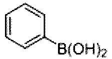 | 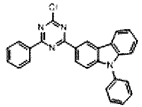 | 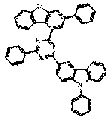 | 81.5% |
| 1-27 | | 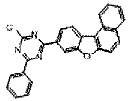 | 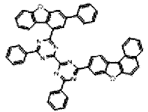 | 79.3% |
| 1-34 | | 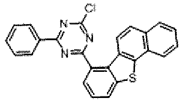 | 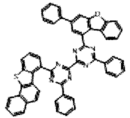 | 75.5% |
| 1-47 | | 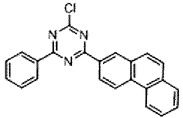 | 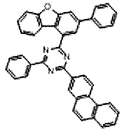 | 70.9% |
| 1-61 | | 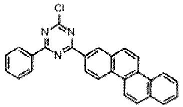 | 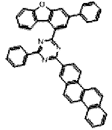 | 75.9% |
| 1-64 | 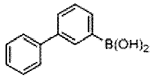 | 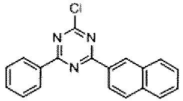 | 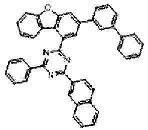 | 80.3% |
| 1-104 | 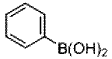 | 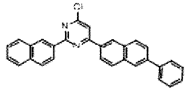 | 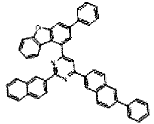 | 73.1% |
| 1-108 | 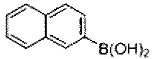 | 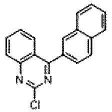 | 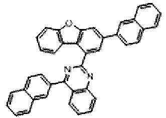 | 70.9% |
| 1-111 | | 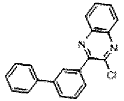 | 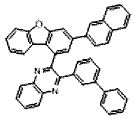 | 70.5% |
| 1-115 | | 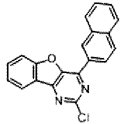 | 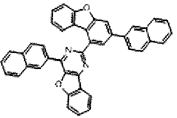 | 71.3% |
| 1-124 | 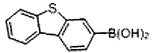 | 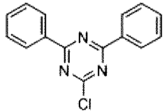 | 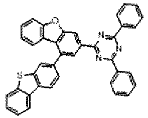 | 73.1% |
| 1-125 | 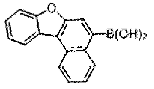 | | 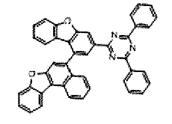 | 71.0% |
| 1-128 | 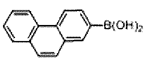 | | 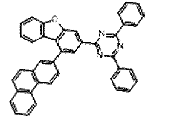 | 70.3% |
| 1-185 | 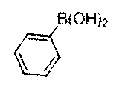 | 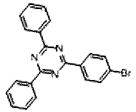 | 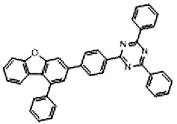 | 70.0% |
| 1-190 | | 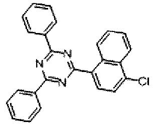 | 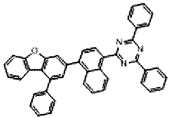 | 70.1% |
| 1-233 | | 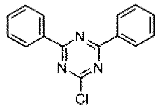 | 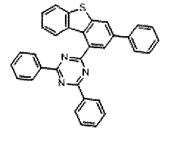 | 72.5% |
| 1-235 | 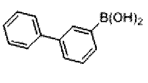 | | 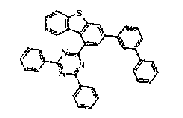 | 71.9% |
| 1-236 | 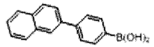 | | 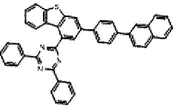 | 72.1% |
| 1-238 | 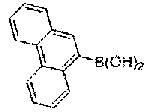 | | 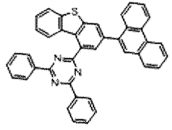 | 70.9% |
| 1-242 | 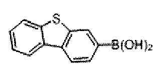 | | 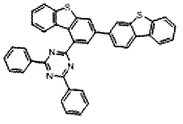 | 75.3% |
| 1-246 | 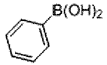 | 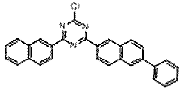 | 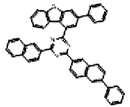 | 72.3% |
| 1-250 | | 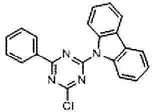 | 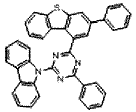 | 70.1% |
| 1-253 | | 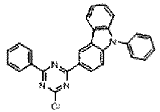 | 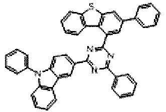 | 70.0% |
| 1-264 | | 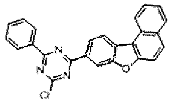 | 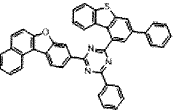 | 72.1% |
| 1-266 | | 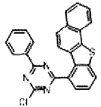 | 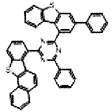 | 71.1% |
| 1-306 | | 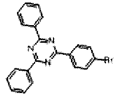 | 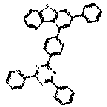 | 70.3% |
| 1-307 | 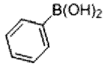 | 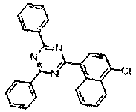 | 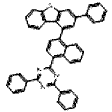 | 70.5% |
| 1-325 | | 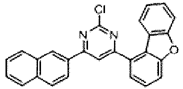 | 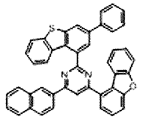 | 72.5% |
| 1-339 | | 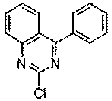 | 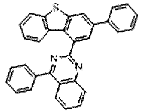 | 70.3% |
| 1-342 | | 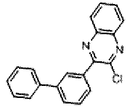 | 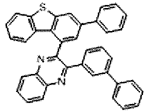 | 70.1% |
| 1-345 | | 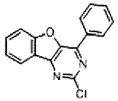 | 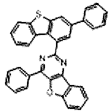 | 70.0% |
| 1-352 | 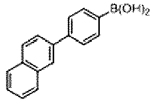 | 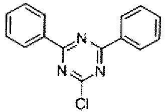 | 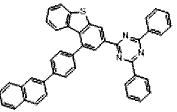 | 73.9% |
| 1-354 | 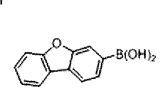 | | 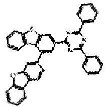 | 75.1% |
| 1-365 | 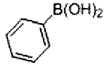 | 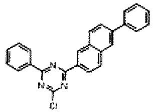 | 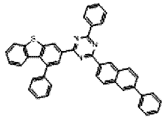 | 75.2% |
| 1-496 | 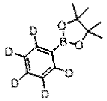 | 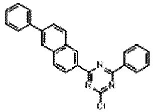 | 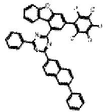 | 80.3% |
| 1-497 | 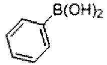 | 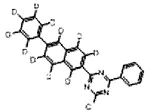 | 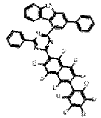 | 80.1% |

### Preparation Example 2. Preparation of Compound 1-467

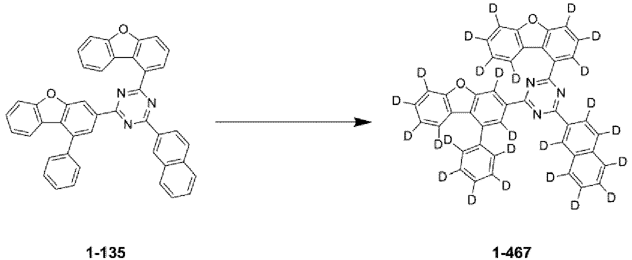

After 10.0 g (16.2 mM) of Compound 1-135 was dissolved in d₆-benzene (100 ml) in a 250 ml two-neck flask, 9.7 ml (110.2 mM) of triflic acid was slowly added thereto, and then the resulting solution was refluxed. After completion of the reaction, the resulting product was purified by recrystallization with methanol and 9.9 g (95.1%) of Target Compound 1-467 was obtained.

The target compounds in the following Table 2 were synthesized by performing synthesis in the same manner as in Preparation Example 2, except that Intermediate A in the following Table 2 was used instead of Compound 1-135 in Preparation Example 2.

**[Table 2]**

| **Compound No.** | **Intermediate A** | **Target Comound** | **Yield** |
|---|---|---|---|
| 1-467 | 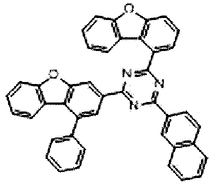 | 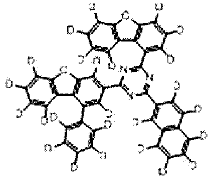 | 95.1% |
| 1-476 | 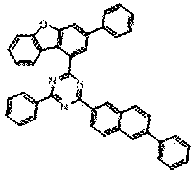 | 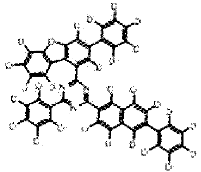 | 96.7% |
| 1-477 | 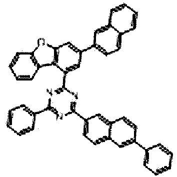 | 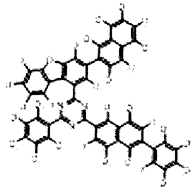 | 95.3% |
| 1-479 | 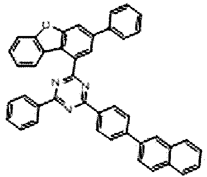 | 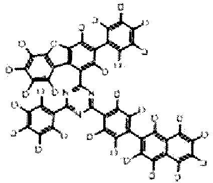 | 95.5% |
| 3-226 | 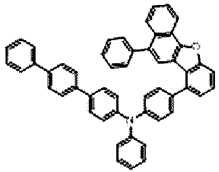 | 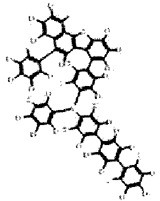 | 95.3% |
| 3-228 | 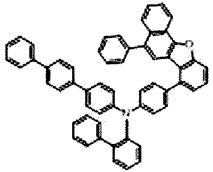 | 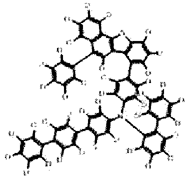 | 95.2% |
| 3-230 | 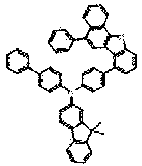 | 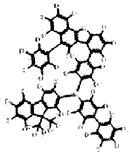 | 96.1% |
| 3-234 | 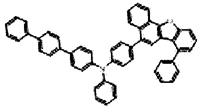 | 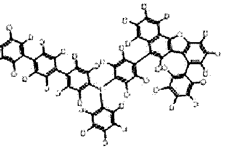 | 95.3% |
| 1-485 | 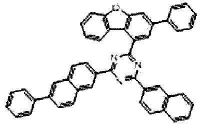 | 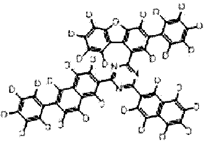 | 95.1% |
| 1-496 | 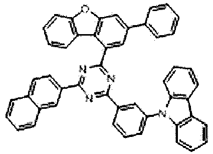 | 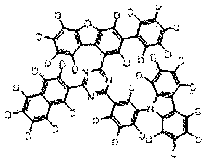 | 96.3% |
| 1-487 | 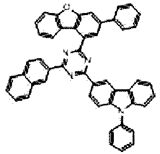 | 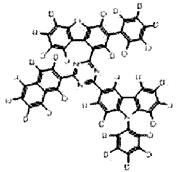 | 96.9% |
| 1-488 | 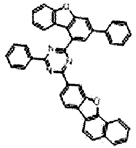 | 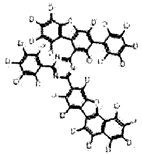 | 95.7% |
| 1-489 | 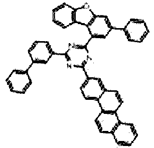 | 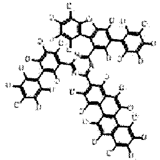 | 96.3% |
| 1-490 | 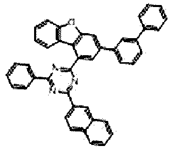 | 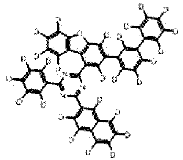 | 96.4% |
| 1-491 | 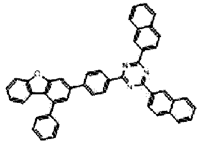 | 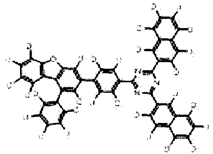 | 96.3% |
| 1-492 | 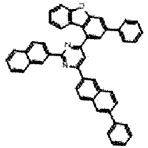 | 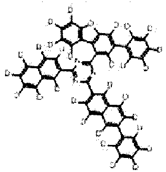 | 97.1% |
| 1-493 | 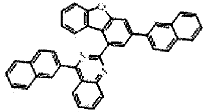 | 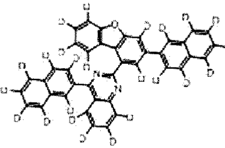 | 95.3% |
| 1-494 | 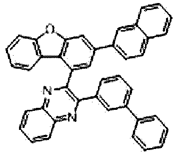 | 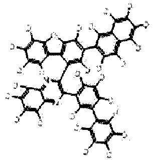 | 96.1% |
| 1-495 | 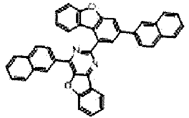 | 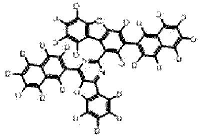 | 95.5% |
| 3-221 | 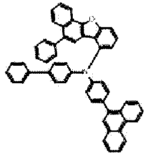 | 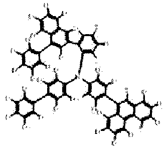 | 96.1% |
| 3-227 | 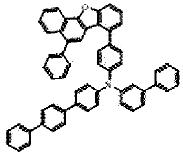 | 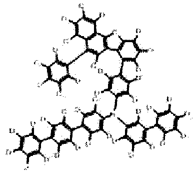 | 95.8% |
| 3-237 | 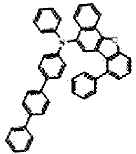 | 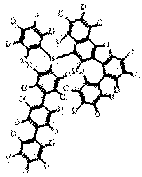 | 95.3% |
| 3-239 | 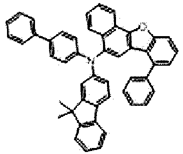 | 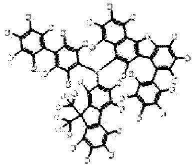 | 95.1% |
| 3-240 | 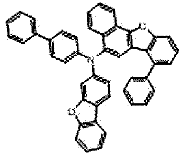 | 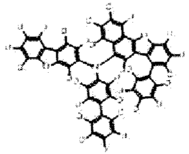 | 95.2% |

### Preparation Example 3. Preparation of Compound 3-4

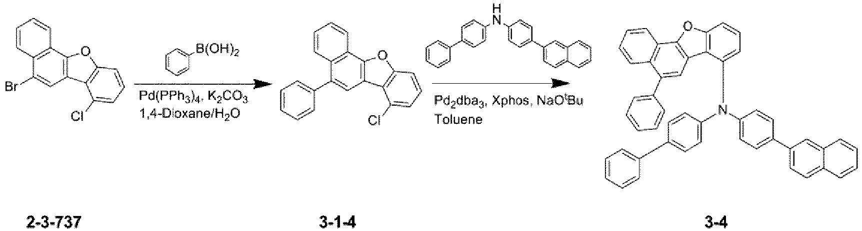

### Preparation Example 3-1. Preparation of Compound 3-1-4

After 30.0 g (90.5 mM) of Compound 2-3-737, 12.1 g (99.6 mM) of phenylboronic acid, 5.2 g (4.5 mM) of Pd(PPh₃)₄, and 25.0 g (181.0 mM) of K₂CO₃ were dissolved in 1,4-dioxane/H₂O (300 ml/60 ml) in a 1 L two-neck flask, the resulting solution was refluxed for 1 hour. The reaction product was purified by recrystallization with methanol, and 24.8g (83.3%) of Target Compound 3-1-4 was obtained.

### Preparation Example 3-2. Preparation of Compound 3-4

After 10.0 g (30.4 mM) of Compound 3-1-4, 11.3 g (30.4 mM) of N-(4-(naphthalen-2-yl)phenyl)-[1,1'-biphenyl]-4-amine, 1.4 g (1.5 mM) of Pd₂dba₃, 1.4 g (3.0 mM) of Xphos, and 5.8 g (60.8 mM) of NaO^{t}Bu were put into a 250 ml two-neck flask and dissolved in toluene (150 ml), the resulting solution was refluxed for 1 hour. The reaction product was purified by recrystallization with methanol, and 17.6g (87.2%) of Target Compound 3-4 was obtained.

The target compounds in the following Table 3 were synthesized by performing synthesis in the same manner as in Preparation Example 3, except that Intermediate A in the following Table 3 was used instead of phenylboronic acid in Preparation Example 3 and Intermediate B in the following Table 3 was used instead of N-(4-(naphthalen-2-yl)phenyl)-[1,1'-biphenyl]-4-amine in Preparation Example 3.

**[Table 3]**

| **Compou nd No.** | **Intermediate A** | **Intermediate B** | **Target compound** | **Yield** |
|---|---|---|---|---|
| 3-4 | 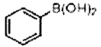 | 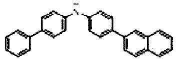 | 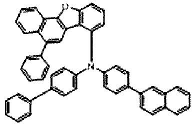 | 87.2% |
| 3-14 | | 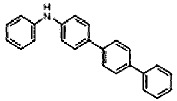 | 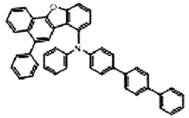 | 87.1% |
| 3-19 | 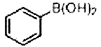 | 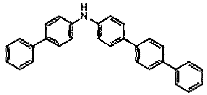 | 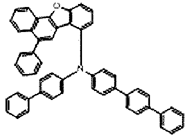 | 86.3% |
| 3-20 | | 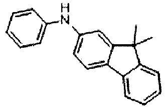 | 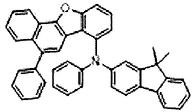 | 86.6% |
| 3-21 | | 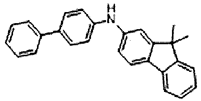 | 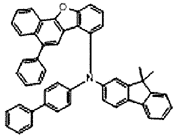 | 86.1% |
| 3-22 | | 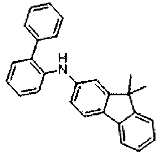 | 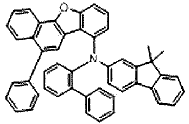 | 85.9% |
| 3-23 | | 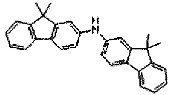 | 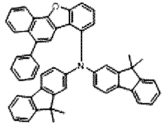 | 86.1% |
| 3-25 | | 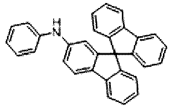 | 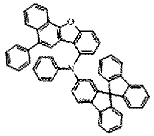 | 86.3% |
| 3-27 | | 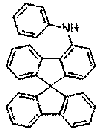 | 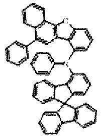 | 79.5% |
| 3-34 | 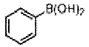 | 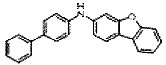 | 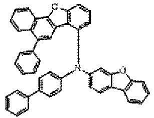 | 81.1% |
| 3-39 | | 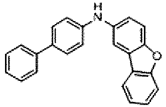 | 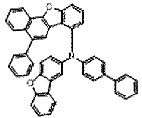 | 81.0% |
| 3-55 | | 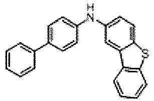 | 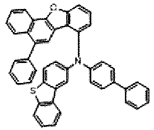 | 81.9% |
| 3-62 | | 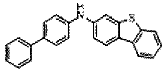 | 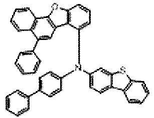 | 80.3% |
| 3-64 | | 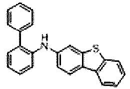 | 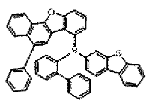 | 80.9% |
| 3-76 | | 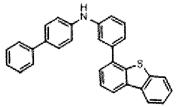 | 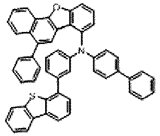 | 82.3% |
| 3-77 | | 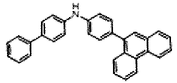 | 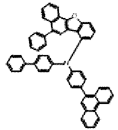 | 81.5% |
| 3-29 | | 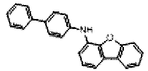 | 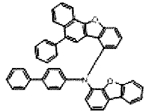 | 82.9% |
| 3-82 | 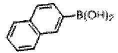 | 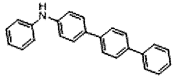 | 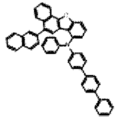 | 81.0% |
| 3-88 | 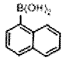 | 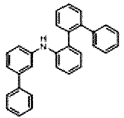 | 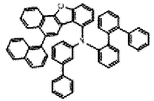 | 79.1% |
| 3-89 | 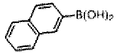 | 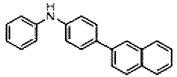 | 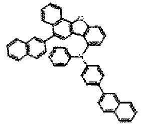 | 78.5% |
| 3-97 | 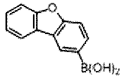 | 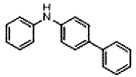 | 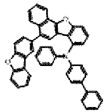 | 79.1% |
| 3-99 | 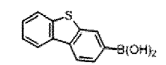 | | 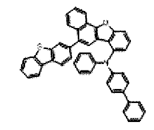 | 79.3% |

### Preparation Example 4. Preparation of Compound 3-103

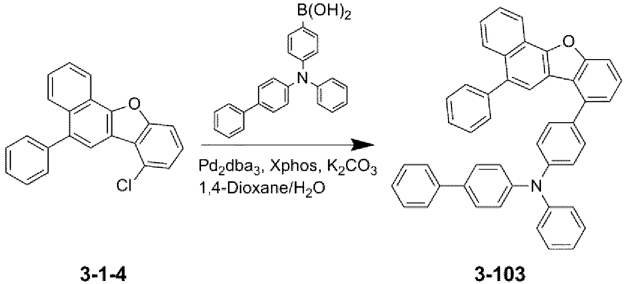

After 10.0 g (30.4 mM) of Compound 3-1-4, 11.1 g (30.4 mM) of (4-([1,1'-biphenyl]-4-yl(phenyl)amino)phenyl)boronic acid, 1.4 g (1.5 mM) of Pd₂dba₃, 1.4 g (3.0 mM) of Xphos and 8.4 g (60.8 mM) of K₂CO₃ were dissolved in 1,4-dioxane/H₂O (100 ml/20 ml) in a 250 ml two-neck flask, the resulting solution was refluxed for 1 hour. The reaction product was purified by recrystallization with methanol, and 15.1g (80.9%) of Target Compound 3-103 was obtained.

The target compounds in the following Table 4 were synthesized by performing synthesis in the same manner as in Preparation Examples 3 and 4, except that Intermediate A in the following Table 4 was used instead of phenylboronic acid in Preparation Example 3 and Intermediate B in the following Table 4 was used instead of (4-([1,1'-biphenyl]-4-yl(phenyl)amino)phenyl)boronic acid in Preparation Example 4.

**[Table 4]**

| **Compou nd No.** | **Intermediate A** | **Intermediate B** | **Target Compound** | **Yield** |
|---|---|---|---|---|
| 3-103 | 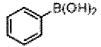 | 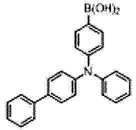 | 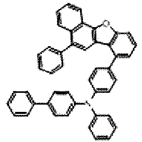 | 80.9% |
| 3-104 | | 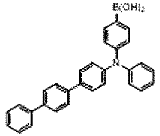 | 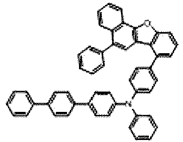 | 81.1% |
| 3-105 | | 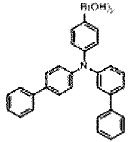 | 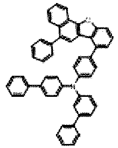 | 79.5% |
| 3-114 | | 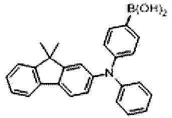 | 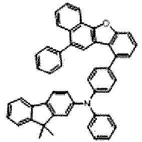 | 79.9% |
| 3-115 | 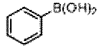 | 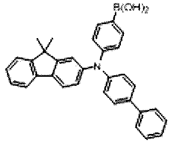 | 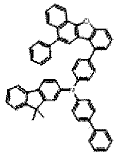 | 80.3% |
| 3-116 | | 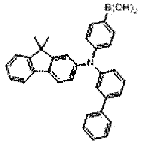 | 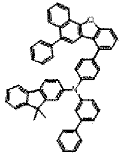 | 80.1% |
| 3-117 | | 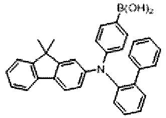 | 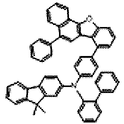 | 81.5% |
| 3-120 | | 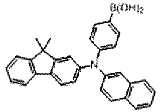 | 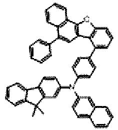 | 80.9% |
| 3-133 | | 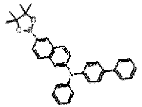 | 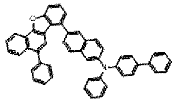 | 70.3% |

### Preparation Example 5. Preparation of Compound 3-191

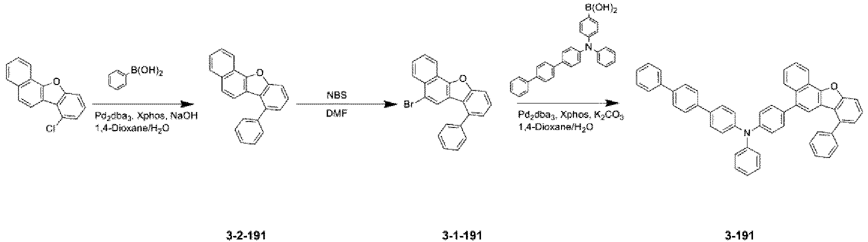

### Preparation Example 5-1. Preparation of Compound 3-2-191

After 30.0 g (118.7 mM) of 7-chloronaphtho[1,2-b]benzofuran, 15.9 g (130.6 mM) of phenylboronic acid, 5.4 g (5.9 mM) of Pd₂dba₃, 5.7 g (11.9 mM) of Xphos, and 9.5 g (237.4 mM) of NaOH were dissolved in 1,4-dioxane/H₂O (300 ml/60 ml) in a 1 L two-neck flask, the resulting solution was refluxed for 1 hour. The reaction product was purified by recrystallization with methanol, and 31.5g (90.1%) of Target Compound 3-2-191 was obtained.

### Preparation Example 5-2. Preparation of Compound 3-1-191

After 31.0 g (105.3 mM) of Compound 3-2-191 and 18.7 g (105.3 mM) of N-bromosuccinimide were dissolved in DMF (300 ml) in a 1 L two-neck flask, the resulting solution was refluxed. After completion of the reaction, the resulting product was purified by recrystallization with methanol and 34.5 g (87.7%) of Target Compound 3-1-191 was obtained.

### Preparation Example 5-3. Preparation of Compound 3-191

After 10.0 g (26.8 mM) of Compound 3-1-191, 11.8 g (26.8 mM) of (4-([1,1':4',1"-terphenyl]-4-yl(phenyl)amino)phenyl)boronic acid, 1.2 g (1.3 mM) of Pd₂dba₃, 1.3 g (2.7 mM) of Xphos and 7.4 g (53.6 mM) of K₂CO₃ were dissolved in 1,4-dioxane/H₂O (100 ml/20 ml) in a 250 ml two-neck flask, the resulting solution was refluxed for 1 hour. The reaction product was purified by recrystallization with methanol, and 16.1g (86.9%) of Target Compound 3-191 was obtained.

The target compounds in the following Table 5 were synthesized by performing synthesis in the same manner as in Preparation Example 5, except that Intermediate A in the following Table 5 was used instead of phenylboronic acid in Preparation Example 5 and Intermediate B in the following Table 5 was used instead of (4-([1,1':4',1"-terphenyl]-4-yl(phenyl)amino)phenyl)boronic acid in Preparation Example 5.

**[Table 5]**

| **Compou nd No.** | **Intermediate A** | **Intermediate B** | **Target Compound** | **Yield** |
|---|---|---|---|---|
| 3-191 | 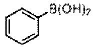 | 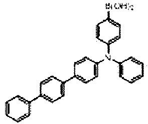 | 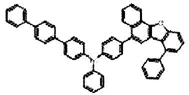 | 86.9% |
| 3-192 | | 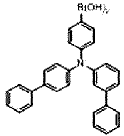 | 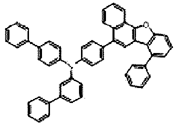 | 80.5% |
| 3-194 | | 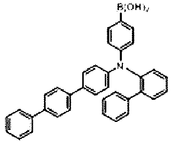 | 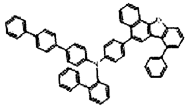 | 80.9% |
| 3-200 | | 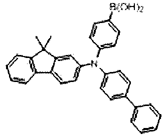 | 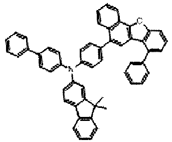 | 81.5% |
| 3-202 | 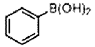 | 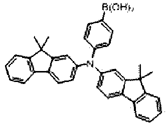 | 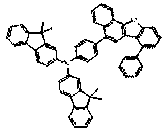 | 81.1% |
| 3-213 | | 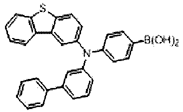 | 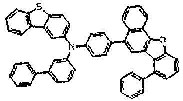 | 81.0% |
| 3-193 | | 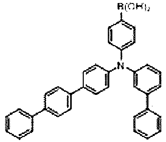 | 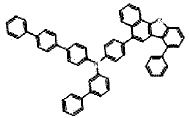 | 80.2% |

### Preparation Example 6. Preparation of Compound 3-139

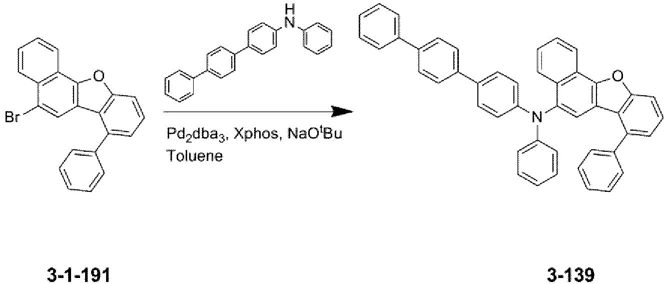

After 10.0 g (26.8 mM) of Compound 3-1-191, 8.6 g (26.8 mM) of N-phenyl-[1,1':4',1"-terphenyl]-4-amine, 1.2 g (1.3 mM) of Pd₂dba₃, 1.3 g (2.7 mM) of Xphos, and 5.2 g (53.6 mM) of NaO^{t}Bu were dissolved in 100 ml of toluene in a 250 ml two-neck flask, the resulting solution was refluxed for 1 hour. The reaction product was purified by recrystallization with methanol, and 14.1g (85.8%) of Target Compound 3-139 was obtained.

The target compounds in the following Table 6 were synthesized by performing synthesis in the same manner as in Preparation Example 6, except that Intermediate A in the following Table 6 was used instead of phenylboronic acid in Preparation Example 3 and Intermediate B in the following Table 6 was used instead of N-phenyl-[1,1':4',1"-terphenyl]-4-amine in Preparation Example 6.

**[Table 6]**

| **Compou nd No.** | **Intermediate A** | **Intermediate B** | **Target Compound** | **Yield** |
|---|---|---|---|---|
| 3-139 | 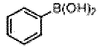 | 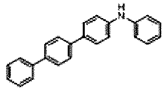 | 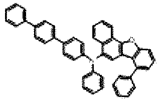 | 85.8% |
| 3-144 | | 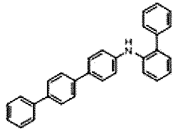 | 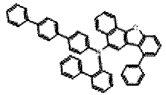 | 85.9% |
| 3-150 | 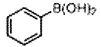 | 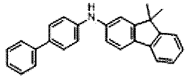 | 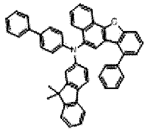 | 85.1% |
| 3-155 | | 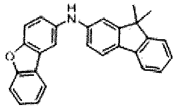 | 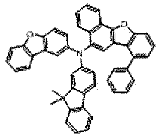 | 81.3% |
| 3-156 | | 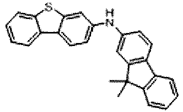 | 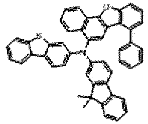 | 85.2% |
| 3-170 | | 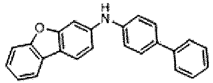 | 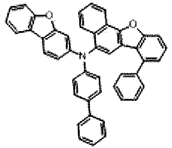 | 81.9% |
| 3-177 | | 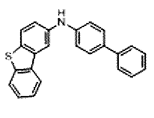 | 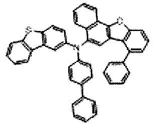 | 82.3% |
| 3-186 | | 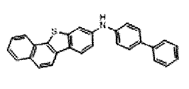 | 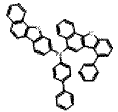 | 81.1% |
| 3-187 | | 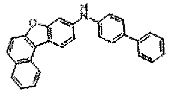 | 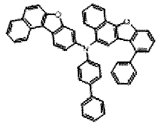 | 82.3% |

The other compounds other than the compounds described in Preparation Examples 1 to 6 and Tables 1 to 6 were also prepared in the same manner as in the above-described Preparation Examples, and synthesis results are shown in the following Tables 7 and 8. The following Table 7 shows the measured values of ¹H NMR (CDCl₃, 400 Mz), and the following Table 8 shows the measured values of field desorption mass spectrometry (FD-MS).

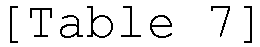

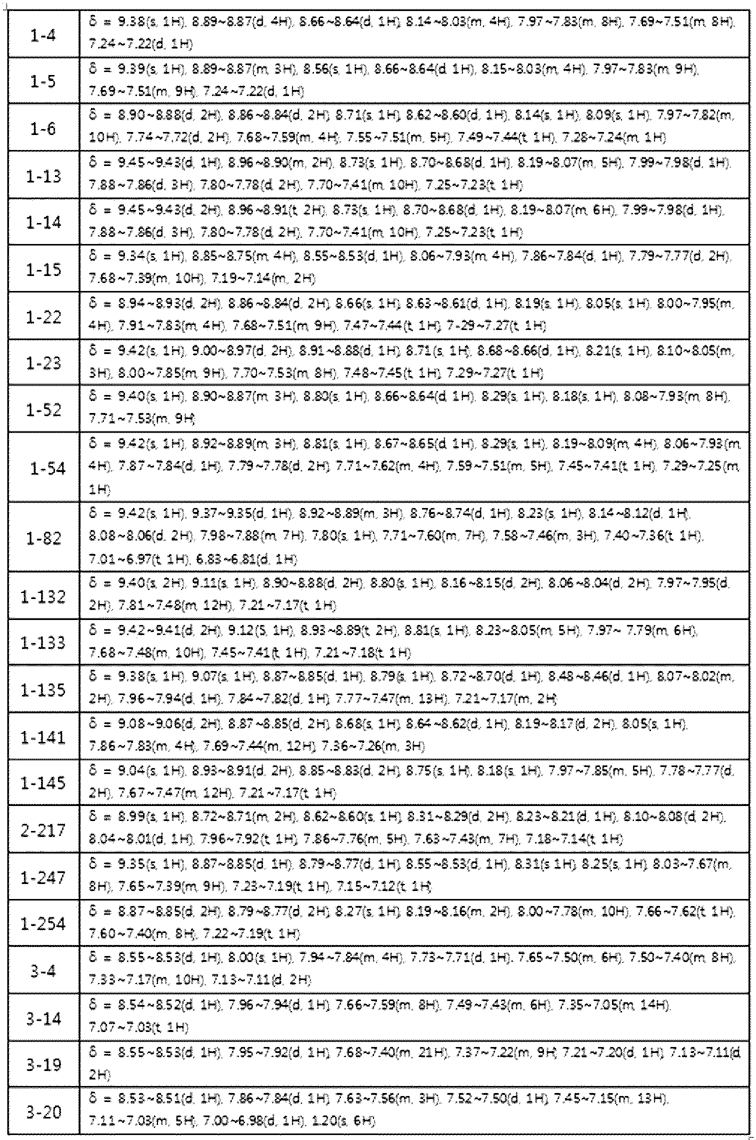

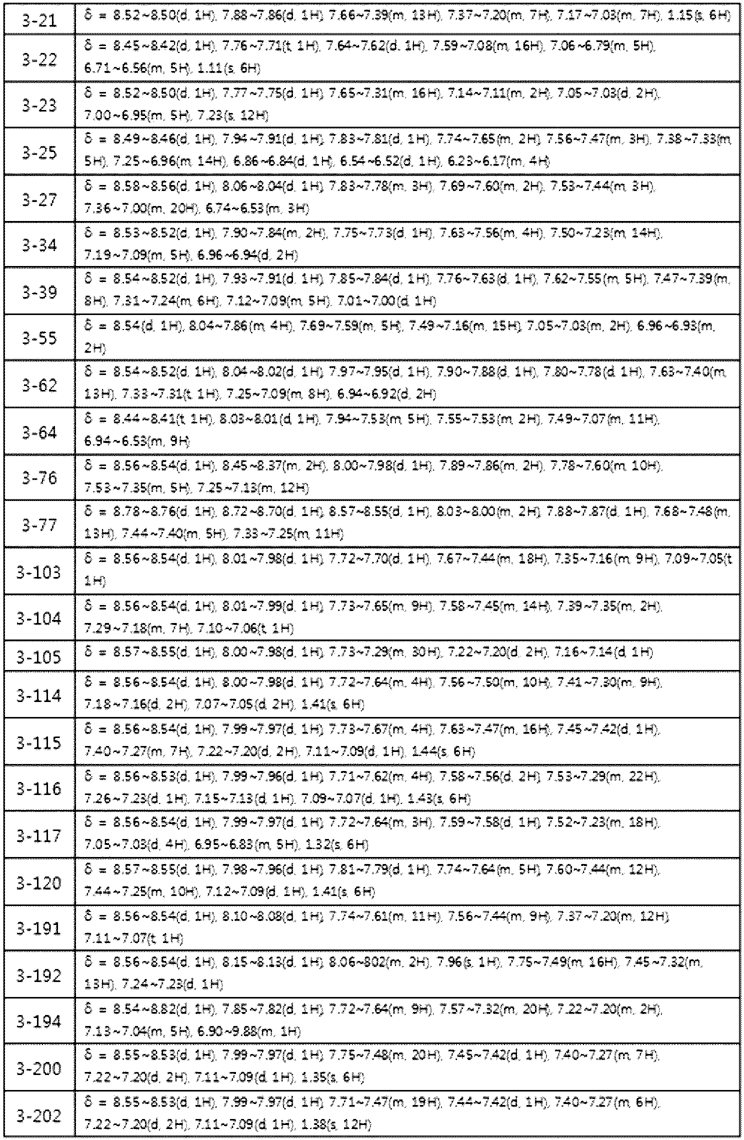

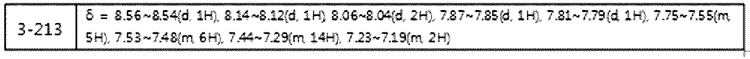

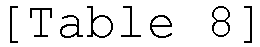

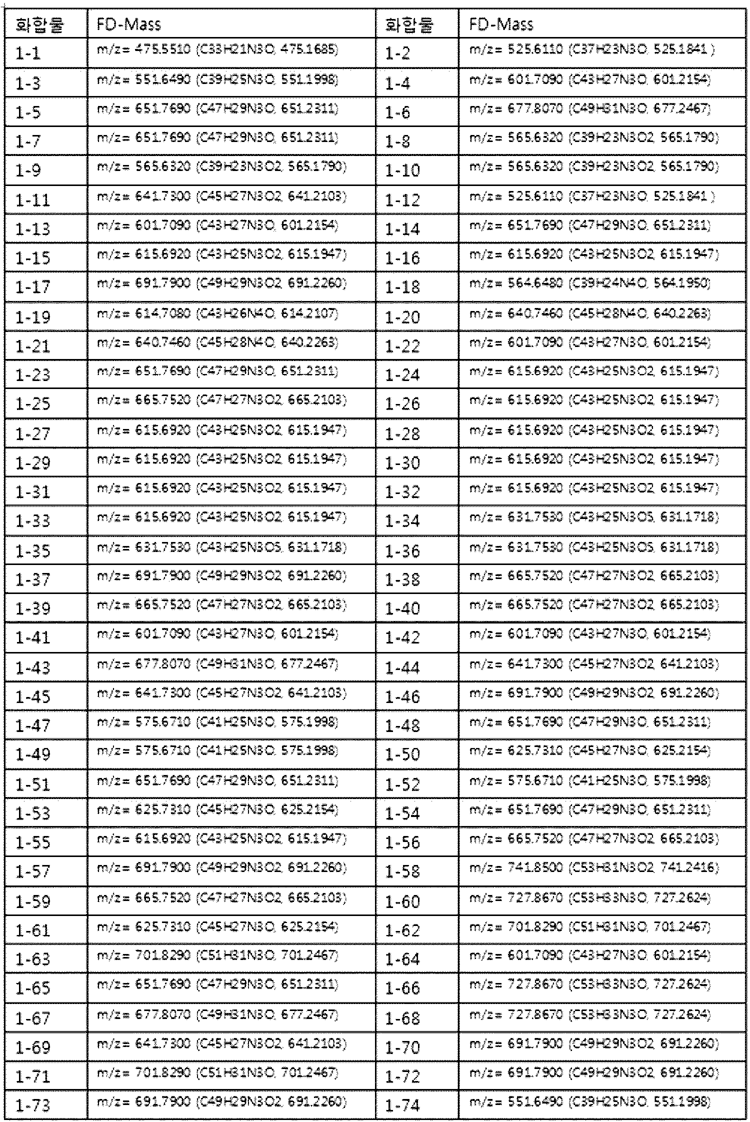

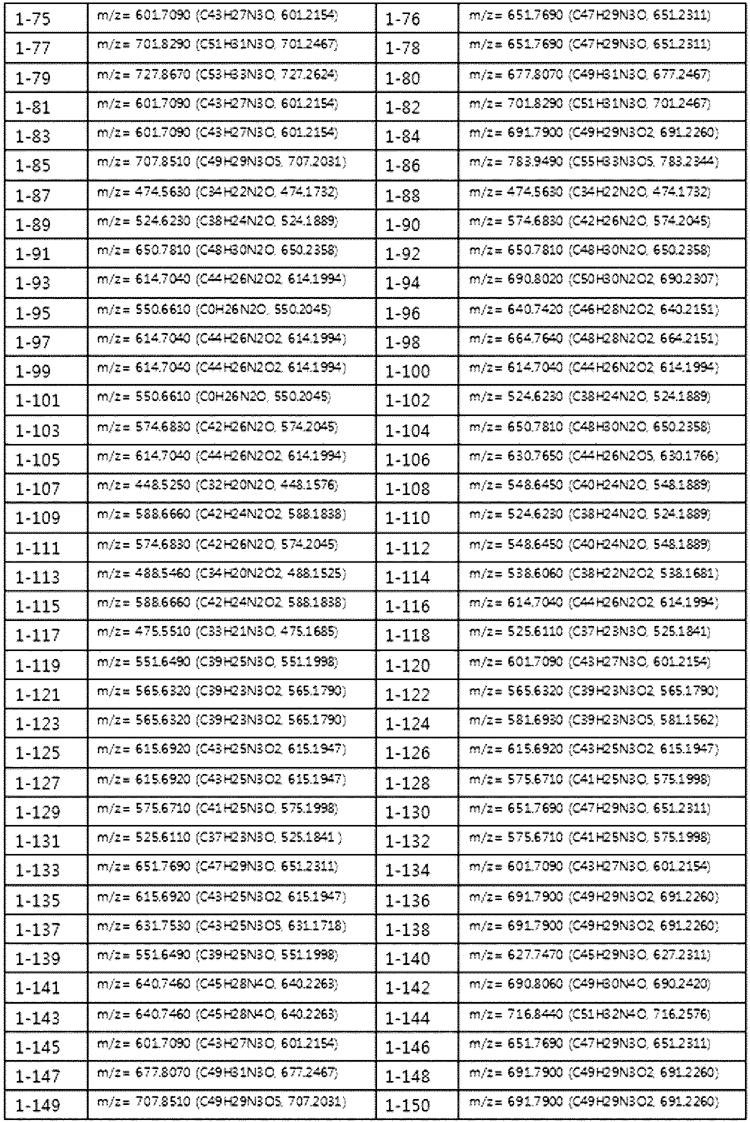

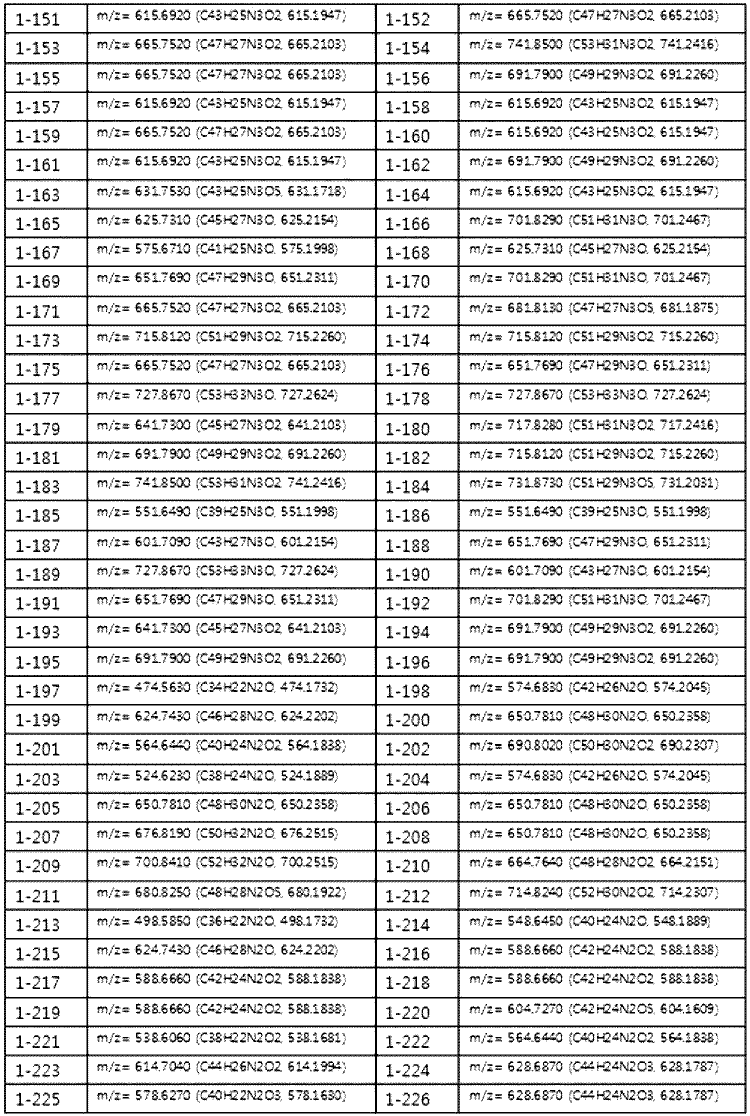

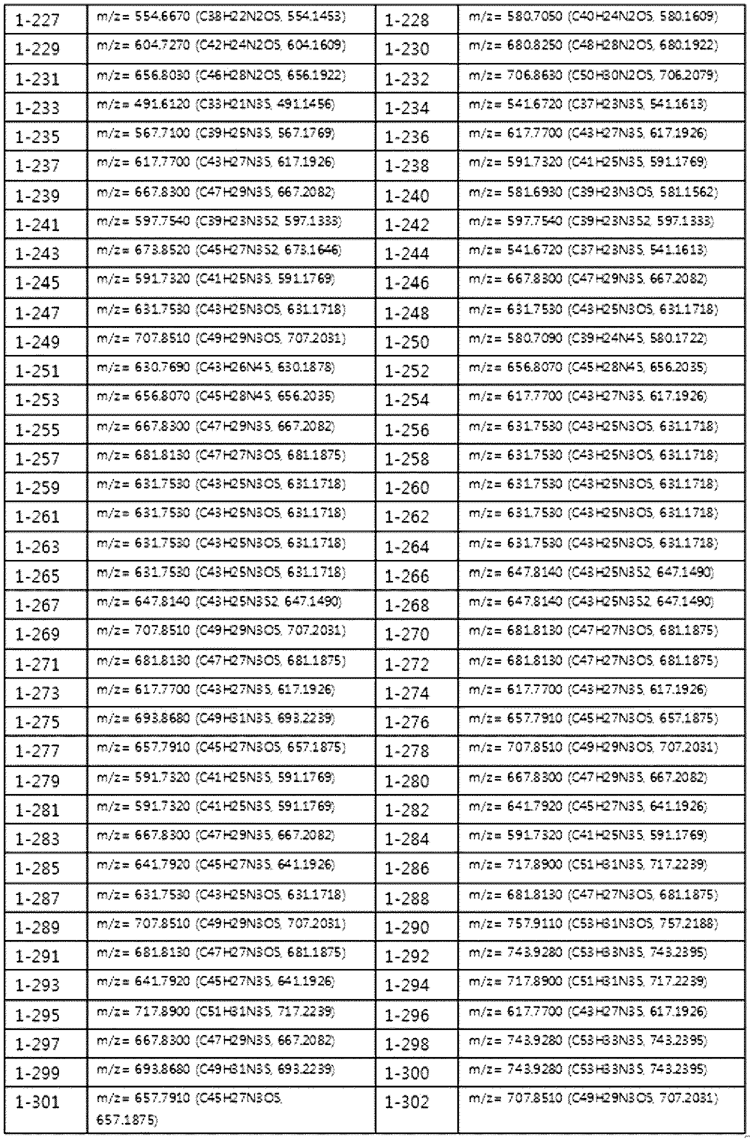

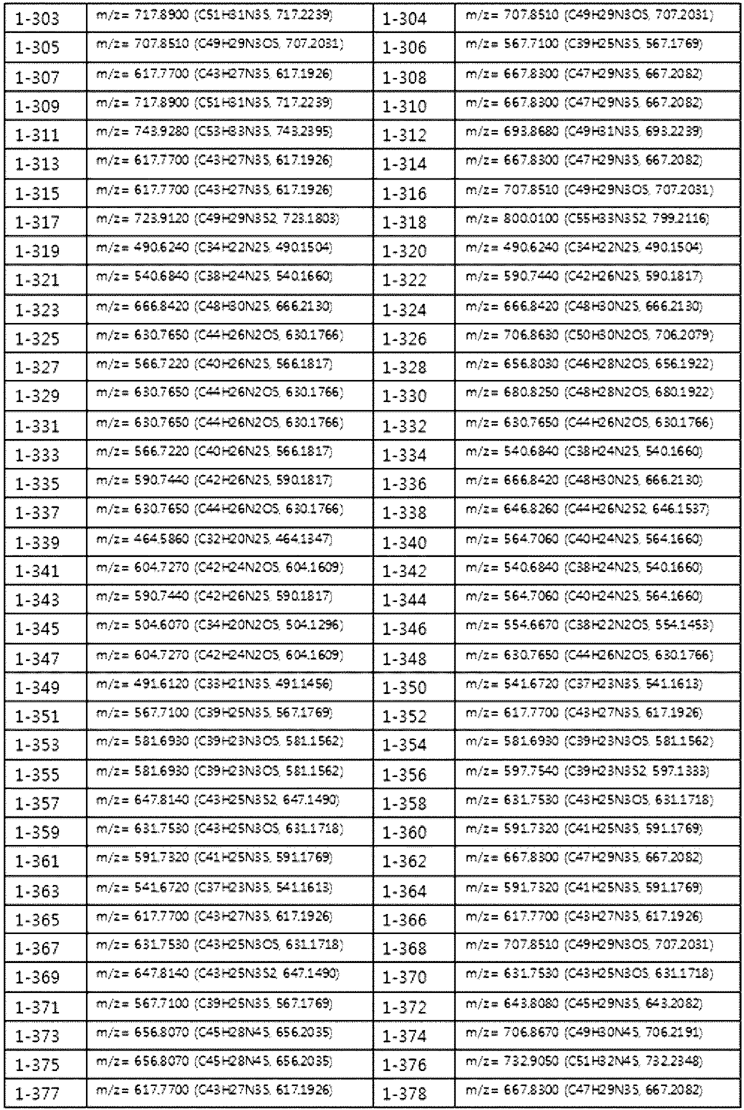

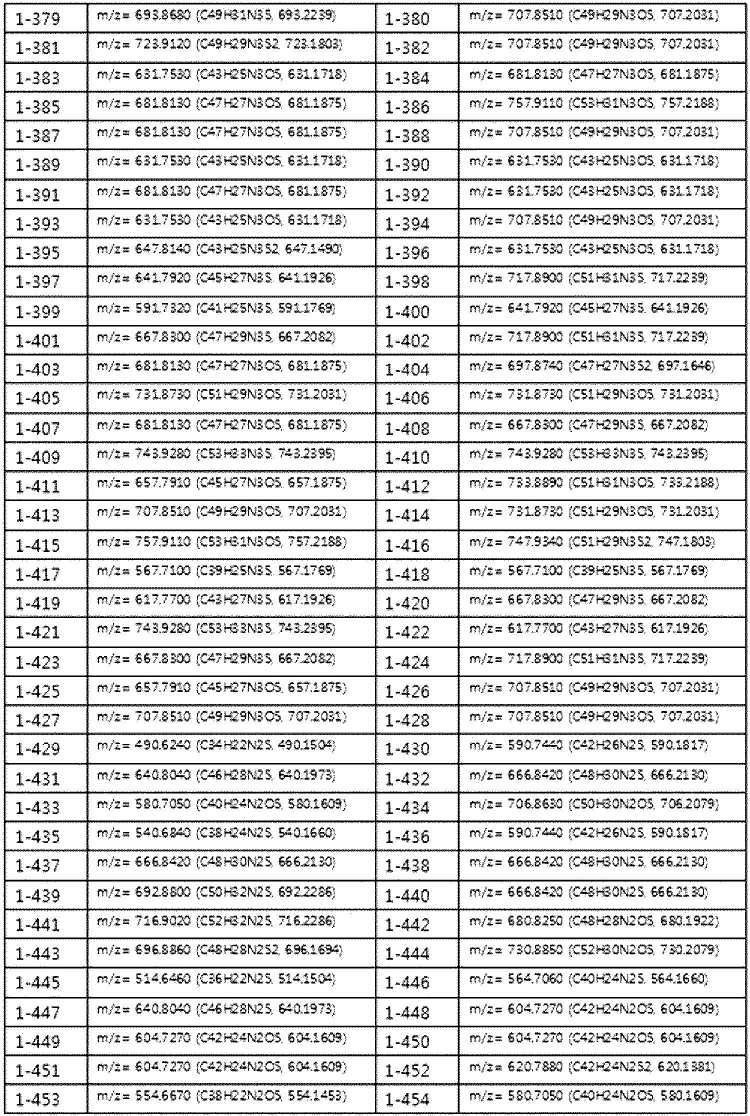

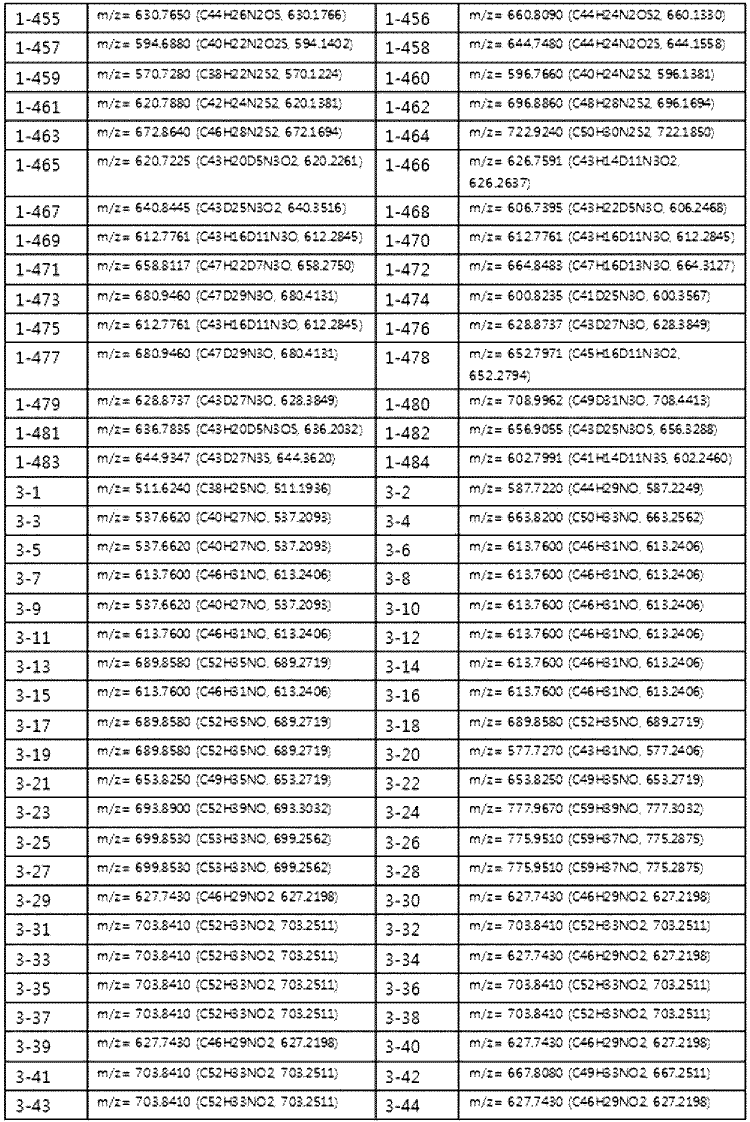

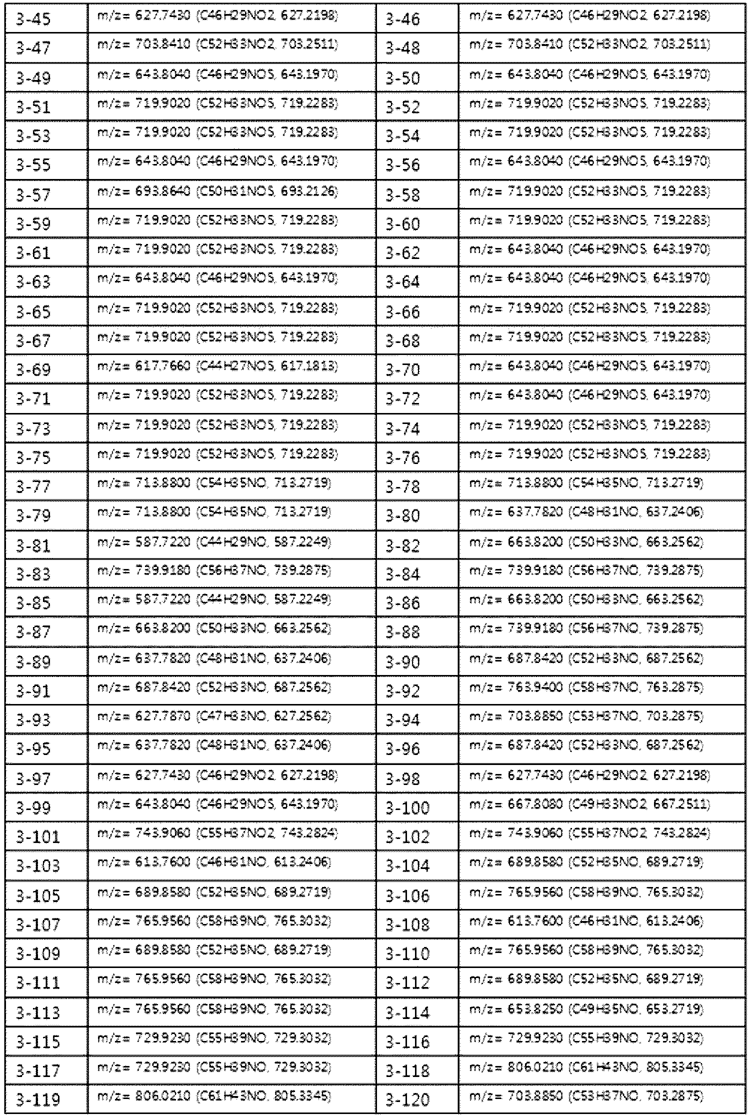

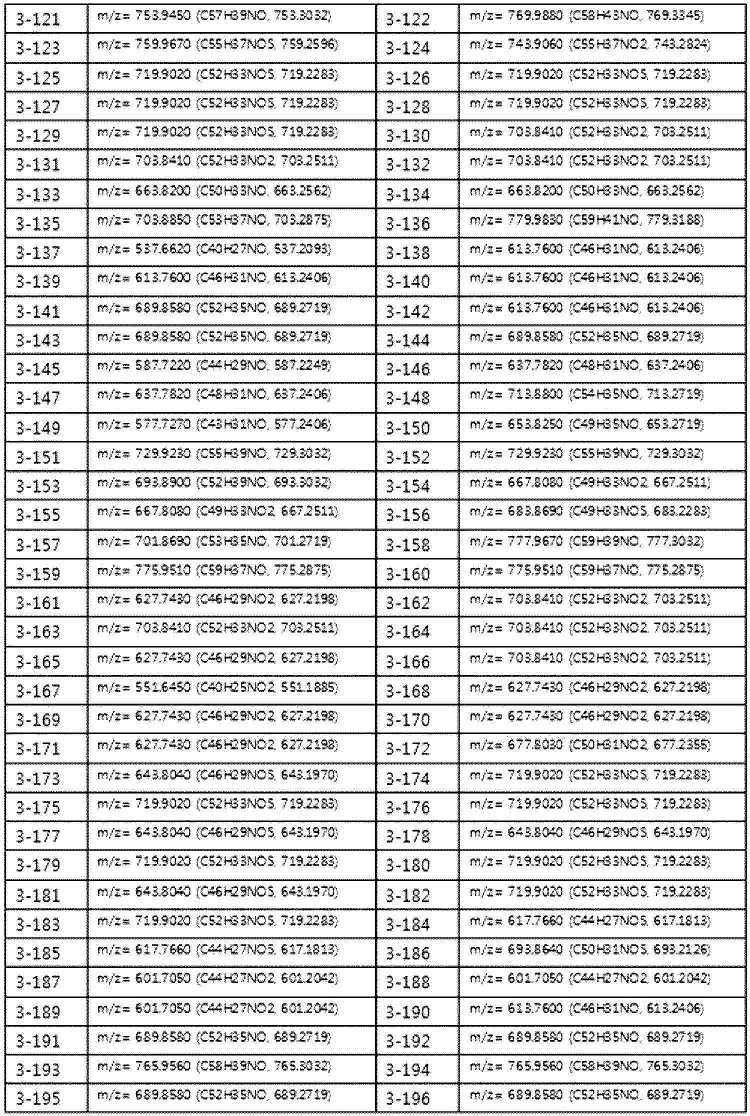

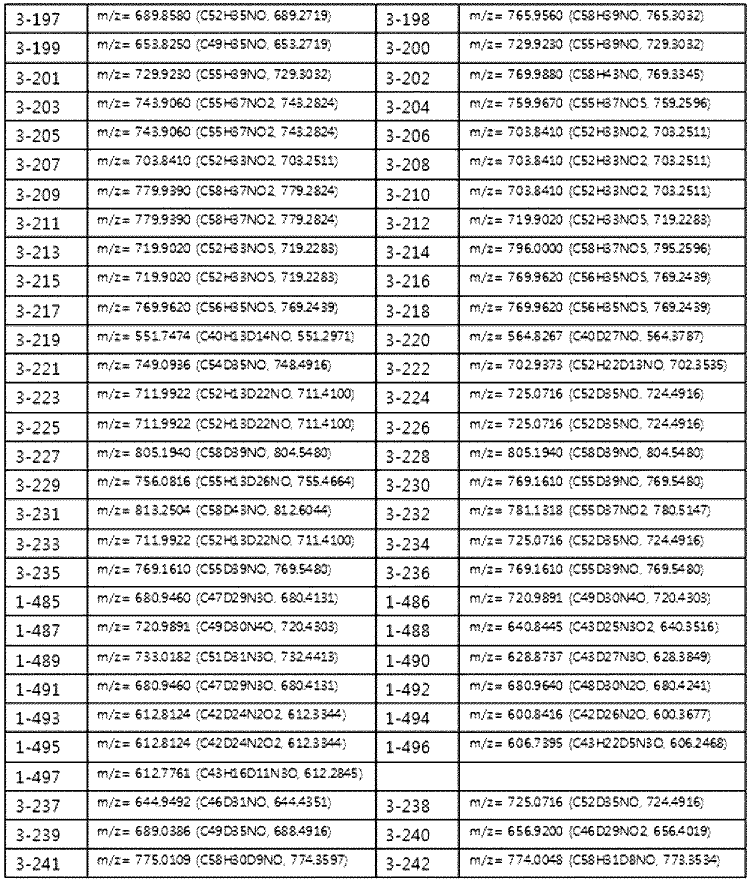

### <Experimental Example 1>

### 1) Manufacture of organic light emitting device (Red Host)

A glass substrate, in which ITO was thinly coated to have a thickness of 1,500 Å, was ultrasonically washed with distilled water. When the washing with distilled water was finished, the glass substrate was ultrasonically washed with a solvent such as acetone, methanol, and isopropyl alcohol, dried and then was subjected to UVO treatment for 5 minutes using UV in a UV cleaning machine. Thereafter, the substrate was transferred to a plasma washing machine (PT), and then was subjected to plasma treatment in a vacuum state for an ITO surface treatment and in order to remove a residual film, and was transferred to a thermal deposition apparatus for organic deposition.

As the common layers, the hole injection layer 4,4',4"-tris[2-naphthyl(phenyl)amino]triphenylamine (2-TNATA) and the hole transport layer N,N'-di(1-naphthyl)-N,N'-diphenyl-(1,1''-biphenyl)-4,4'-diamine (NPB) were formed on the ITO transparent electrode (positive electrode).

A light emitting layer was thermally vacuum deposited thereon as follows. The light emitting layer was deposited to have a thickness of 400 Å by depositing one or two of the compounds described in the following Table 9 as a red host from a single supply source and doping the host with an Ir compound at 3 wt% using (piq)₂(Ir)_{(acac)} as a red phosphorescent dopant. Thereafter, Bphen as a hole blocking layer was deposited to have a thickness of 30 Å, and Alq₃ as an electron transport layer was deposited to have a thickness of 250 Å thereon. Finally, lithium fluoride (LiF) was deposited to have a thickness of 10 Å on the electron transport layer to form an electron injection layer, and then aluminum (Al) negative electrode was deposited to have a thickness of 1,200 Å on the electron injection layer to form a negative electrode, thereby manufacturing an organic electroluminescence device.

In this case, Comparative Compounds A to R used in Comparative Examples 1 to 15 and 25 to 38 are as follows.

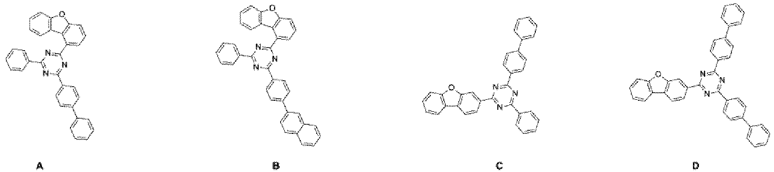

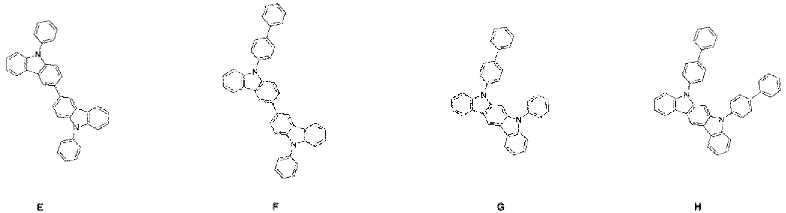

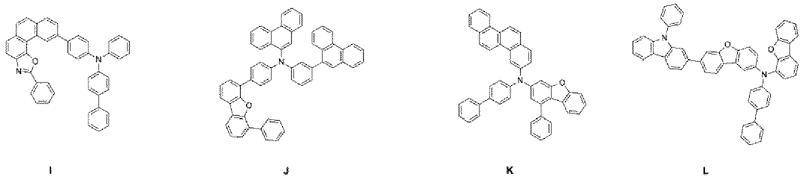

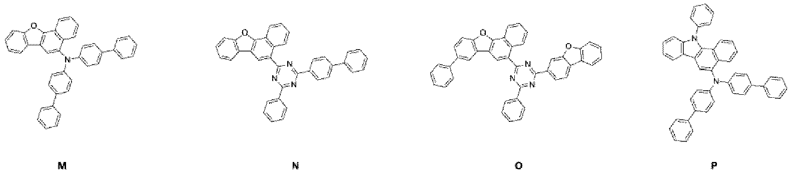

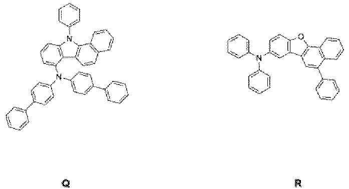

### 2) Driving Voltage and Light Emitting Efficiency of Organic Electroluminescence Device

For the organic electroluminescence device manufactured as described above, electroluminescence (EL) characteristics were measured by M7000 manufactured by McScience Inc., and based on the measurement result thereof, T95 was measured by a service life measurement device (M6000) manufactured by McScience Inc., when the reference luminance was 6,000 cd/m². As described above, T₉₅ means the service life (unit: hour) of the device measured at the time when the luminance reaches 95% relative to the initial luminance.

The following Table 9 shows Experimental Examples or Comparative Examples in which the compounds of Chemical Formulae 1 and 2 of the present invention are used as the host material of the light emitting layer.

**[Table 9]**

| | Light emitting layer | Ratio (N:P) | Turn-on M | Driving voltage (V) | Efficiency (cd/A) | Color coordinate (x, y) | Service life (T₉₀) |
|---|---|---|---|---|---|---|---|
| Comparative Example 1 | A | | 3.50 | 5.71 | 28.50 | (0.684, 0.316) | 30 |
| Comparative Example 2 | B | | 3.40 | 5.60 | 33.11 | (0.684, 0.316) | 35 |
| Comparative Example 3 | C | | 3.71 | 6.01 | 26.10 | (0.684. 0.316) | 20 |
| Comparative Example 4 | D | | 3.58 | 5.89 | 29.30 | (0.685. 0.315) | 25 |
| Comparative Example 5 | E | | 4.50 | 6.81 | 10.12 | (0.685, 0.315) | 5 |
| Comparative Example 6 | G | | 4.41 | 6.72 | 10.15 | (0.685, 0.315) | 5 |
| Comparative Example 7 | I | | 4.40 | 6.73 | 10.11 | (0.685, 0.315) | 5 |
| Comparative Example 8 | J | | 4.55 | 6.90 | 10.11 | (0.685, 0.315) | 5 |
| Comparative Example 9 | K | | 4.45 | 6.80 | 10.05 | (0.684. 0.316) | 3 |
| Comparative Example 10 | M | | 4.61 | 6.95 | 9.55 | (0.685. 0.315) | 3 |
| Comparative Example 11 | N | | 3.80 | 6.15 | 25.10 | (0.685, 0.315) | 20 |
| Comparative Example 12 | O | | 3.72 | 6.05 | 33.15 | (0.685, 0.315) | 10 |
| Comparative Example 13 | P | | 4.72 | 7.05 | 6.15 | (0.684. 0.316) | 3 |
| Comparative Example 14 | Q | | 4.55 | 6.85 | 9.53 | (0.684. 0.316) | 3 |
| Comparative Example 15 | R | | 4.30 | 6.56 | 10.25 | (0.685. 0.315) | 10 |
| Comparative Example 16 | 1-4 | | 3.15 | 5.40 | 37.95 | (0.685, 0.315) | 40 |
| Comparative Example 17 | 1-5 | | 3.23 | 5.55 | 35.62 | (0.685, 0.315) | 35 |
| Comparative Example 18 | 1-14 | | 3.05 | 5.27 | 50.11 | (0.685, 0.315) | 40 |
| Comparative Example 19 | 1-15 | | 2.81 | 5.00 | 45.13 | (0.685, 0.315) | 60 |
| Comparative Example 20 | 1-54 | | 3.20 | 5.45 | 40.31 | (0.685, 0.315) | 35 |
| Comparative Example 21 | 1-82 | | 3.35 | 5.59 | 33.50 | (0.685, 0.315) | 35 |
| Comparative Example 22 | 3-21 | | 4.10 | 6.25 | 10.56 | (0.685, 0.315) | 10 |
| Comparative Example 23 | 3-29 | | 4.25 | 6.50 | 10.35 | (0.685, 0.315) | 10 |
| Comparative Example 24 | 3-104 | | 4.25 | 6.45 | 10.58 | (0.685, 0.315) | 15 |
| Comparative Example 25 | B:E | 1 : 1 | 3.35 | 5.75 | 38.15 | (0.685, 0.315) | 70 |
| Comparative Example 26 | 1-14 : E | 1 : 1 | 3.00 | 5.26 | 50.56 | (0.684. 0.316) | 95 |
| Comparative Example 27 | B : 3-4 | 1 : 1 | 2.80 | 5.05 | 42.50 | (0.685, 0.315) | 90 |
| Comparative Example 28 | B : 3-115 | 1:3 | 2.85 | 5.06 | 38.95 | (0.685, 0.315) | 75 |
| Comparative | | 1 : 1 | 2.70 | 4.95 | 42.95 | (0.684. | 90 |
| Example 29 | | | | | | 0.316) | |
| Comparative Example 30 | | 3 : 1 | 2.71 | 4.99 | 40.05 | (0.684. 0.316) | 80 |
| Comparative Example 31 | B: I | 1 : 1 | 3.20 | 5.44 | 38.55 | (0.685, 0.315) | 75 |
| Comparative Example 32 | B : J | 1 : 1 | 3.42 | 5.80 | 38.11 | (0.685, 0.315) | 75 |
| Comparative Example 33 | D : K | 1 : 1 | 3.57 | 5.91 | 30.15 | (0.684. 0.316) | 55 |
| Comparative Example 34 | D : L | 1 : 1 | 3.60 | 6.05 | 30.15 | (0.684. 0.316) | 55 |
| Comparative Example 35 | 1-14 : M | 1 : 1 | 2.95 | 5.35 | 39.55 | (0.685, 0.315) | 40 |
| Comparative Example 36 | 1-14 : Q | 1 : 1 | 2.92 | 5.29 | 40.11 | (0.685, 0.315) | 40 |
| Comparative Example 37 | 1-14 : I | 1 : 1 | 2.85 | 5.20 | 44.10 | (0.684. 0.316) | 80 |
| Comparative Example 38 | 1-14 : R | 1 : 1 | 2.73 | 4.99 | 47.95 | (0.684. 0.316) | 100 |
| Example 1 | | 1 : 9 | 2.45 | 4.66 | 53.05 | (0.684. 0.316) | 170 |
| Example 2 | | 1 : 7 | 2.41 | 4.61 | 54.55 | (0.685, 0.315) | 280 |
| Example 3 | | 1 : 5 | 2.38 | 4.58 | 55.80 | (0.685, 0.315) | 435 |
| Example 4 | | 1:3 | 2.30 | 4.50 | 59.95 | (0.685, 0.315) | 595 |
| Example 5 | 1-14 : 3-115 | 1 : 1 | 2.20 | 4.10 | 66.15 | (0.685, 0.315) | 660 |
| Example 6 | | 3 : 1 | 2.26 | 4.15 | 62.35 | (0.685, 0.315) | 500 |
| Example 7 | | 5 : 1 | 2.33 | 4.49 | 59.35 | (0.685, 0.315) | 355 |
| Example 8 | | 7 : 1 | 2.38 | 4.55 | 56.95 | (0.684. 0.316) | 200 |
| Example 9 | | 9 : 1 | 2.43 | 4.63 | 55.15 | (0.685, 0.315) | 145 |
| Example 10 | 1-13 : 3-104 | 1 : 1 | 2.23 | 4.43 | 55.35 | (0.684. 0.316) | 250 |
| Example 11 | 1-14 : 3-104 | 1 : 1 | 2.25 | 4.44 | 60.10 | (0.685, 0.315) | 450 |
| Example 12 | 1-15 : 3-104 | 1 : 1 | 2.20 | 4.29 | 56.14 | (0.685, 0.315) | 520 |
| Example 13 | 1-22 : 3-104 | 1 : 1 | 2.25 | 4.45 | 61.50 | (0.684. 0.316) | 300 |
| Example 14 | 1-23 : 3-104 | 1 : 1 | 2.27 | 4.47 | 64.56 | (0.684. 0.316) | 375 |
| Example 15 | 1-14 : 3-77 | 1 : 1 | 2.50 | 4.71 | 52.65 | (0.685, 0.315) | 180 |
| Example 16 | 1-14 : 3-62 | 1 : 1 | 2.40 | 4.61 | 52.50 | (0.684. 0.316) | 155 |
| Example 17 | 1-14 : 3-64 | 1 : 1 | 2.45 | 4.66 | 51.50 | (0.684. 0.316) | 160 |
| Example 18 | 1-479 : 3-230 | 1 : 5 | 2.40 | 4.67 | 58.00 | (0.684. 0.316) | 500 |
| Example 19 | | 1:3 | 2.33 | 4.56 | 62.50 | (0.684. 0.316) | 610 |
| Example 20 | | 1 : 1 | 2.25 | 4.46 | 69.85 | (0.684. 0.316) | 730 |
| Example 21 | | 3 : 1 | 2.27 | 4.48 | 65.15 | (0.684. 0.316) | 550 |
| Example 22 | | 5 : 1 | 2.35 | 4.58 | 59.99 | (0.684. 0.316) | 425 |
| Example 23 | 1-479 : 3-62 | 1 : 1 | 2.41 | 4.63 | 51.85 | (0.684. 0.316) | 195 |
| Example 24 | 1-479 : 3-77 | 1 : 1 | 2.51 | 4.73 | 51.00 | (0.684. 0.316) | 225 |
| Example 25 | 1-14 : 3-226 | 1 : 1 | 2.27 | 4.47 | 59.15 | (0.684. 0.316) | 540 |
| Example 26 | 1-14 : 3-230 | 1 : 1 | 2.22 | 4.13 | 65.00 | (0.685, 0.315) | 770 |
| Example 27 | 1-15 : 3-230 | 1 : 1 | 2.21 | 4.30 | 59.55 | (0.685, 0.315) | 950 |
| Example 28 | 1-23 : 3-14 | 1 : 1 | 2.42 | 4.62 | 53.55 | (0.684. 0.316) | 220 |
| Example 29 | 1-23 : 3-20 | 1 : 1 | 2.35 | 4.55 | 53.95 | (0.685, 0.315) | 155 |
| Example 30 | 1-23 : 3-21 | 1 : 1 | 2.35 | 4.52 | 58.15 | (0.685, 0.315) | 255 |
| Example 31 | 1-23 : 3-27 | 1 : 1 | 2.41 | 4.62 | 53.82 | (0.684. 0.316) | 150 |
| Example 32 | 1-23 : 3-115 | 1:2 | 2.29 | 4.48 | 66.00 | (0.684. | 550 |
| | | | | | | 0.316) | |
| Example 33 | | 1 : 1 | 2.22 | 4.14 | 70.95 | (0.684. 0.316) | 600 |
| Example 34 | | 2 : 1 | 2.24 | 4.24 | 68.10 | (0.685, 0.315) | 400 |
| Example 35 | 1-479 : 3-14 | 1 : 1 | 2.43 | 4.64 | 52.95 | (0.685, 0.315) | 270 |
| Example 36 | 1-479 : 3-21 | 1 : 1 | 2.36 | 4.55 | 57.15 | (0.684. 0.316) | 185 |
| Example 37 | 1-82 : 3-104 | 1 : 1 | 2.50 | 4.75 | 55.15 | (0.684. 0.316) | 150 |
| Example 38 | 1-141 : 3-104 | 1 : 1 | 2.62 | 4.85 | 51.00 | (0.684. 0.316) | 150 |
| Example 39 | 1-217 : 3-104 | 1 : 1 | 2.50 | 4.72 | 58.50 | (0.685, 0.315) | 200 |
| Example 40 | 1-217 : 3-230 | 1 : 1 | 2.40 | 4.55 | 60.05 | (0.685, 0.315) | 255 |
| Example 41 | 1-5 : 3-106 | 1 : 1 | 2.33 | 4.55 | 72.50 | (0.684. 0.316) | 500 |
| Example 42 | 1-6 : 3-106 | 1 : 1 | 2.30 | 4.50 | 74.51 | (0.684. 0.316) | 550 |
| Example 43 | 1-8 : 3-106 | 1 : 1 | 2.40 | 4.62 | 58.30 | (0.684. 0.316) | 255 |
| Example 44 | 1-3 : 3-106 | 1 : 1 | 2.32 | 4.53 | 68.10 | (0.685, 0.315) | 325 |
| Example 45 | 1-64 : 3-106 | 1 : 1 | 2.35 | 4.57 | 68.12 | (0.685, 0.315) | 460 |
| Example 46 | 1-124 : 3-106 | 1 : 1 | 2.50 | 4.72 | 55.90 | (0.684. 0.316) | 300 |
| Example 47 | 1-125 : 3-106 | 1 : 1 | 2.55 | 4.78 | 51.95 | (0.685, 0.315) | 175 |
| Example 48 | 1-128 : 3-106 | 1 : 1 | 2.55 | 4.77 | 52.05 | (0.685, 0.315) | 165 |
| Example 49 | 1-21 : 3-106 | 1 : 1 | 2.39 | 4.61 | 58.85 | (0.684. 0.316) | 250 |
| Example 50 | 1-27 : 3-106 | 1 : 1 | 2.42 | 4.61 | 58.86 | (0.684. 0.316) | 400 |
| Example 51 | 1-34 : 3-106 | 1 : 1 | 2.50 | 4.75 | 53.10 | (0.684. 0.316) | 155 |
| Example 52 | 1-47 : 3-106 | 1 : 1 | 2.42 | 4.63 | 53.15 | (0.685, 0.315) | 160 |
| Example 53 | 1-61 : 3-106 | 1 : 1 | 2.45 | 4.67 | 53.14 | (0.685, 0.315) | 160 |
| Example 54 | 1-185 : 3-106 | 1 : 1 | 2.65 | 4.89 | 51.00 | (0.684. 0.316) | 145 |
| Example 55 | 1-190 : 3-106 | 1 : 1 | 2.65 | 4.89 | 51.95 | (0.684. 0.316) | 350 |
| Example 56 | 1-108 : 3-106 | 1 : 1 | 2.45 | 4.67 | 55.93 | (0.685, 0.315) | 250 |
| Example 57 | 1-111 : 3-106 | 1 : 1 | 2.45 | 4.68 | 53.55 | (0.685, 0.315) | 145 |
| Example 58 | 1-115 : 3-106 | 1 : 1 | 2.46 | 4.70 | 54.35 | (0.685, 0.315) | 200 |
| Example 59 | 1-104 : 3-106 | 1 : 1 | 2.51 | 4.76 | 55.95 | (0.685, 0.315) | 145 |
| Example 60 | 1-485 : 3-106 | 1 : 1 | 2.28 | 4.39 | 68.10 | (0.685, 0.315) | 550 |
| Example 61 | 1-486 : 3-106 | 1 : 1 | 2.52 | 4.73 | 52.55 | (0.684. 0.316) | 145 |
| Example 62 | 1-487 : 3-106 | 1 : 1 | 2.40 | 4.62 | 58.00 | (0.684. 0.316) | 300 |
| Example 63 | 1-488 : 3-106 | 1 : 1 | 2.43 | 4.63 | 57.99 | (0.685, 0.315) | 475 |
| Example 64 | 1-489 : 3-106 | 1 : 1 | 2.48 | 4.73 | 52.59 | (0.685, 0.315) | 245 |
| Example 65 | 1-490 : 3-106 | 1 : 1 | 2.36 | 4.58 | 67.00 | (0.685, 0.315) | 550 |
| Example 66 | 1-491 : 3-106 | 1 : 1 | 2.58 | 4.91 | 51.55 | (0.685, 0.315) | 425 |
| Example 67 | 1-492 : 3-106 | 1 : 1 | 2.53 | 4.78 | 55.00 | (0.684. 0.316) | 170 |
| Example 68 | 1-493 : 3-106 | 1 : 1 | 2.47 | 4.72 | 53.88 | (0.684. 0.316) | 245 |
| Example 69 | 1-494 : 3-106 | 1 : 1 | 2.46 | 4.70 | 52.85 | (0.684. 0.316) | 170 |
| Example 70 | 1-495 : 3-106 | 1 : 1 | 2.47 | 4.72 | 53.35 | (0.685, 0.315) | 245 |
| Example 71 | 1-233 : 3-106 | 1 : 1 | 2.51 | 4.72 | 54.10 | (0.685, 0.315) | 165 |
| Example 72 | 1-235 : 3-106 | 1 : 1 | 2.45 | 4.65 | 58.89 | (0.684. 0.316) | 215 |
| Example 73 | 1-236 : 3-106 | 1 : 1 | 2.40 | 4.62 | 65.56 | (0.684. 0.316) | 315 |
| Example 74 | 1-238 : 3-106 | 1 : 1 | 2.55 | 4.80 | 51.19 | (0.685, 0.315) | 140 |
| Example 75 | 1-242 : 3-106 | 1 : 1 | 2.55 | 4.75 | 55.25 | (0.685, 0.315) | 175 |
| Example 76 | 1-246 : 3-106 | 1 : 1 | 2.29 | 4.52 | 59.55 | (0.685, 0.315) | 395 |
| Example 77 | 1-247 : 3-106 | 1 : 1 | 2.22 | 4.43 | 56.99 | (0.684. 0.316) | 495 |
| Example 78 | 1-250 : 3-106 | 1 : 1 | 2.59 | 4.79 | 51.95 | (0.685, 0.315) | 140 |
| Example 79 | 1-253 : 3-106 | 1 : 1 | 2.49 | 4.70 | 54.30 | (0.685, 0.315) | 200 |
| Example 80 | 1-264 : 3-106 | 1 : 1 | 2.49 | 4.71 | 54.44 | (0.685, 0.315) | 270 |
| Example 81 | 1-266 : 3-106 | 1 : 1 | 2.52 | 4.76 | 52.20 | (0.685, 0.315) | 180 |
| Example 82 | 1-6 : 3-133 | 1 : 1 | 2.65 | 4.88 | 51.05 | (0.684. 0.316) | 140 |
| Example 83 | 1-6 : 3-139 | 1 : 1 | 2.43 | 4.64 | 57.95 | (0.684. 0.316) | 195 |
| Example 84 | 1-6 : 3-144 | 1 : 1 | 2.48 | 4.69 | 58.00 | (0.685, 0.315) | 250 |
| Example 85 | 1-6 : 3-150 | 1 : 1 | 2.38 | 4.65 | 61.55 | (0.685, 0.315) | 295 |
| Example 86 | 1-6 : 3-155 | 1 : 1 | 2.45 | 4.77 | 52.65 | (0.685, 0.315) | 140 |
| Example 87 | 1-6 : 3-156 | 1 : 1 | 2.49 | 4.80 | 51.65 | (0.684. 0.316) | 140 |
| Example 88 | 1-6 : 3-170 | 1 : 1 | 2.43 | 4.68 | 56.50 | (0.685, 0.315) | 160 |
| Example 89 | 1-6 : 3-177 | 1 : 1 | 2.44 | 4.70 | 55.34 | (0.685, 0.315) | 145 |
| Example 90 | 1-6 : 3-186 | 1 : 1 | 2.52 | 4.78 | 55.00 | (0.685, 0.315) | 170 |
| Example 91 | 1-6 : 3-187 | 1 : 1 | 2.50 | 4.75 | 56.51 | (0.685, 0.315) | 195 |
| Example 92 | 1-6 : 3-191 | 1 : 1 | 2.33 | 4.49 | 64.59. | (0.684. 0.316) | 300 |
| Example 93 | 1-6 : 3-193 | 1 : 1 | 2.40 | 4.60 | 70.55 | (0.684. 0.316) | 445 |
| Example 94 | 1-6 : 3-82 | 1 : 1 | 2.46 | 4.70 | 56.15 | (0.684. 0.316) | 155 |
| Example 95 | 1-6 : 3-88 | 1 : 1 | 2.52 | 4.76 | 54.35 | (0.685, 0.315) | 145 |
| Example 96 | 1-6 : 3-89 | 1 : 1 | 2.54 | 4.80 | 53.18 | (0.685, 0.315) | 140 |
| Example 97 | 1-14 : 3-221 | 1 : 1 | 2.51 | 4.73 | 50.50 | (0.685, 0.315) | 240 |
| Example 98 | 1-6 : 3-227 | 1 : 1 | 2.32 | 4.53 | 73.25 | (0.684. 0.316) | 690 |
| Example 99 | 1-6 : 3-234 | 1 : 1 | 2.34 | 4.50 | 63.69 | (0.685, 0.315) | 375 |
| Example 100 | 1-6 : 3-237 | 1 : 1 | 2.44 | 4.66 | 57.00 | (0.684. 0.316) | 240 |
| Example 101 | 1-6 : 3-239 | 1 : 1 | 2.39 | 4.66 | 60.85 | (0.685, 0.315) | 370 |
| Example 102 | 1-6 : 3-240 | 1 : 1 | 2.44 | 4.70 | 55.66 | (0.685, 0.315) | 200 |
| Example 103 | 1-496 : 3-104 | 1 : 1 | 2.25 | 4.45 | 55.34 | (0.685, 0.315) | 250 |
| Example 104 | 1-475 : 3-104 | 1 : 1 | 2.26 | 4.46 | 55.00 | (0.684. 0.316) | 290 |
| Example 105 | 1-497 : 3-104 | 1 : 1 | 2.26 | 4.46 | 55.05 | (0.684. 0.316) | 290 |
| Example 106 | 1-476 : 3-104 | 1 : 1 | 2.27 | 4.48 | 54.31 | (0.684. 0.316) | 320 |
| Example 107 | 1-352 : 3-106 | 1 : 1 | 2.42 | 4.65 | 62.55 | (0.685, 0.315) | 410 |
| Example 108 | 1-354 : 3-106 | 1 : 1 | 2.47 | 4.68 | 57.95 | (0.685, 0.315) | 295 |
| Example 109 | 1-365 : 3-106 | 1 : 1 | 2.35 | 4.55 | 58.00 | (0.685, 0.315) | 485 |
| Example 110 | 1-306 : 3-106 | 1 : 1 | 2.59 | 4.83 | 51.09 | (0.684. 0.316) | 140 |
| Example 111 | 1-307 : 3-106 | 1 : 1 | 2.59 | 4.82 | 56.35 | (0.685, 0.315) | 200 |
| Example 112 | 1-325 : 3-106 | 1 : 1 | 2.45 | 4.73 | 55.15 | (0.684. 0.316) | 175 |
| Example 113 | 1-339 : 3-106 | 1 : 1 | 2.56 | 4.82 | 54.00 | (0.685, 0.315) | 155 |
| Example 114 | 1-342 : 3-106 | 1 : 1 | 2.58 | 4.85 | 53.12 | (0.685, 0.315) | 140 |
| Example 115 | 1-345 : 3-106 | 1 : 1 | 2.59 | 4.87 | 53.65 | (0.685, 0.315) | 140 |
| Example 116 | 1-23 : 3-24 | 1 : 1 | 2.36 | 4.54 | 56.55 | (0.684. 0.316) | 215 |
| Example 117 | 1-23 : 3-25 | 1 : 1 | 2.37 | 4.55 | 54.30 | (0.685, 0.315) | 150 |
| Example 118 | 1-14 : 3-97 | 1 : 1 | 2.47 | 4.75 | 55.00 | (0.684. 0.316) | 145 |
| Example 119 | 1-14 : 3-99 | 1 : 1 | 2.50 | 4.82 | 52.55 | (0.685, 0.315) | 140 |
| Example 120 | 1-6 : 3-241 | 1 : 1 | 2.31 | 4.52 | 73.95 | (0.685, 0.315) | 615 |
| Example 121 | 1-6 : 3-242 | 1 : 1 | 2.31 | 4.51 | 74.15 | (0.685, 0.315) | 600 |

In Table 9, the ratio (N:P) means the weight ratio of an N-type host and a P-type host, for example, the N-type host corresponds to the compound of Chemical Formula 1 of the present application, and the P-type host corresponds to the compound of Chemical Formula 2 of the present application.

In Table 9, Turn-on (V) means the voltage required to produce 1 nit brightness.

As can be seen in Table 9, it can be confirmed that in the case of an organic light emitting device in which the heterocyclic compound of Chemical Formula 1 and the heterocyclic compound of Chemical Formula 2 of the present invention are included in an organic material layer, the driving voltage and the light emitting efficiency are excellent and the service life is improved compared to the Comparative Examples.

This shows that when the compound of Chemical Formula 1 as an acceptor (n-host) with good electron transport ability and the compound of Chemical Formula 2 as a donor (p-host) with good hole transport ability are used as a co-host of a light emitting layer, the driving voltage can be lowered because electrons and holes are smoothly injected into the light emitting layer, and the efficiency and service life of the device are improved through the formation of an effective recombination zone.

In particular, as shown in Comparative Examples 25 to 38 in Table 9, it can be confirmed that when two types of compounds are used as materials for the light emitting layer, but only any one of Chemical Formulae 1 and 2 of the present application is used, the efficiency and service life of the device are inferior to those in the Examples.

When only the compound of Chemical Formula 1 with good electron transport ability is present in the light emitting layer, the electrons entering from the electron transport layer accumulate at the interface between the light emitting layer and the hole transport layer, causing a deterioration phenomenon at the interface to reduce the efficiency and service life.

When only the compound of Chemical Formula 2 with good hole transport ability is present in the light emitting layer, it is difficult to inject electrons into the light emitting layer and a deterioration phenomenon occurs at the interface between the light emitting layer and the electron transport layer to reduce the efficiency and service life.

### <Experimental Example 2>

### 1) Manufacture of organic light emitting device (Red Host)

A glass substrate, in which ITO was thinly coated to have a thickness of 1,500 Å, was ultrasonically washed with distilled water. When the washing with distilled water was finished, the glass substrate was ultrasonically washed with a solvent such as acetone, methanol, and isopropyl alcohol, dried and then was subjected to UVO treatment for 5 minutes using UV in a UV cleaning machine. Thereafter, the substrate was transferred to a plasma washing machine (PT), and then was subjected to plasma treatment in a vacuum state for an ITO work function and in order to remove a residual film, and was transferred to a thermal deposition apparatus for organic deposition.

As the common layers, the hole injection layer 4,4',4"-tris[2-naphthyl(phenyl)amino]triphenylamine (2-TNATA) and the hole transport layer N,N'-di(1-naphthyl)-N,N'-diphenyl-(1,1''-biphenyl)-4,4'-diamine (NPB) were formed on the ITO transparent electrode (positive electrode).

A light emitting layer was thermally vacuum deposited thereon as follows. The light emitting layer was deposited to have a thickness of 400 Å by depositing one or two of the compounds described in the following Table 10 as a red host from a single supply source and doping the host with an Ir compound at 3 wt% using (piq)₂(Ir)_{(acac)} as a red phosphorescent dopant. Thereafter, Bphen as a hole blocking layer was deposited to have a thickness of 30 Å, and TPBI as an electron transport layer was deposited to have a thickness of 250 Å thereon. Finally, lithium fluoride (LiF) was deposited to have a thickness of 10 Å on the electron transport layer to form an electron injection layer, and then aluminum (Al) negative electrode was deposited to have a thickness of 1,200 Å on the electron injection layer to form a negative electrode, thereby manufacturing an organic electroluminescence device.

### 2) Driving Voltage and Light Emitting Efficiency of Organic Electroluminescence Device

For the organic electroluminescence device manufactured as described above, electroluminescence (EL) characteristics were measured by M7000 manufactured by McScience Inc., and based on the measurement result thereof, T95 was measured by a service life measurement device (M6000) manufactured by McScience Inc., when the reference luminance was 6,000 cd/m². As described above, T₉₅ means the service life (unit: hour) of the device measured at the time when the luminance reaches 95% relative to the initial luminance.

The following Table 10 shows Experimental Examples or Comparative Examples in which the compounds of Chemical Formulae 1 and 2 of the present invention are used as the host material of the light emitting layer.

**[Table 10]**

| | Light emitting layer | Ratio (N:P) | Turn-on M | Driving voltage (V) | Efficiency (cd/A) | Color coordinate (x, y) | Service life (T₉₀) |
|---|---|---|---|---|---|---|---|
| Comparative Example 1 | B | | 3.45 | 5.66 | 34.12 | (0.684. 0.316) | 35 |
| Comparative Example 2 | I | | 4.49 | 6.78 | 10.10 | (0.684. 0.316) | 5 |
| Comparative Example 3 | 1-14 | | 3.06 | 5.28 | 50.55 | (0.684. 0.316) | 55 |
| Comparative Example 4 | B : I | 1 : 1 | 3.25 | 5.35 | 39.15 | (0.685, 0.315) | 80 |
| Comparative Example 5 | B : 3-115 | 1 : 1 | 2.75 | 4.90 | 43.59 | (0.684. 0.316) | 120 |
| Comparative Example 6 | 1-14 : K | 1 : 1 | 3.00 | 5.27 | 51.15 | (0.685, 0.315) | 60 |
| Example 1 | 1-14 : 3-115 | 1:3 | 2.55 | 4.60 | 47.25 | (0.685, 0.315) | 520 |
| Example 2 | | 1 : 1 | 2.44 | 4.50 | 68.31 | (0.685, 0.315) | 950 |
| Example 3 | | 3 : 1 | 2.43 | 4.45 | 57.12 | (0.685, 0.315) | 670 |
| Example 4 | 1-14 : 3-226 | 1:3 | 2.72 | 5.05 | 48.95 | (0.684. 0.316) | 455 |
| Example 5 | | 1 : 2 | 2.63 | 4.90 | 52.10 | (0.685, 0.315) | 600 |
| Example 6 | | 1 : 1 | 2.58 | 4.80 | 61.55 | (0.685, 0.315) | 800 |
| Example 7 | | 2 : 1 | 2.57 | 4.78 | 56.15 | (0.684. 0.316) | 690 |
| Example 8 | | 3 : 1 | 2.65 | 4.91 | 52.95 | (0.685, 0.315) | 550 |
| Example 9 | 1-14 : 3-77 | 1 : 1 | 2.63 | 4.90 | 52.05 | (0.685, 0.315) | 250 |
| Example 10 | 1-14 : 3-62 | 1 : 1 | 2.65 | 4.89 | 53.10 | (0.684. 0.316) | 210 |
| Example 11 | 1-14 : 3-64 | 1 : 1 | 2.67 | 4.95 | 50.05 | (0.684. 0.316) | 225 |
| Example 12 | 1-22 : 3-115 | 1 : 1 | 2.47 | 4.58 | 72.59 | (0.684. 0.316) | 800 |
| Example 13 | 1-479 : 3-230 | 1 : 2 | 2.58 | 4.72 | 50.11 | (0.684. 0.316) | 695 |
| Example 14 | | 1 : 1 | 2.50 | 4.63 | 71.66 | (0.684. 0.316) | 1005 |
| Example 15 | | 2 : 1 | 2.49 | 4.64 | 63.45 | (0.684. 0.316) | 810 |

Experimental Example 2 is an experiment in which an electron blocking layer is additionally included in the organic material layer, and when the electron blocking layer was inserted in the middle, the effect is excellent because the recombination of holes and electrons is effectively formed by effectively preventing electrons from moving to the common layer to confine the electrons inside the light emitting layer.

That is, it can be confirmed that the service life is improved because electrons are effectively formed in the light emitting layer to improve the charge balance.

### [Explanation of Reference Numerals and Symbols]

100: Substrate
200: Positive electrode
300: Organic material layer
301: Hole injection layer
302: Hole transport layer
303: Light emitting layer
304: Hole blocking layer
305: Electron transport layer
306: Electron injection layer
307: Electron blocking layer
400: Negative electrode

## Claims

1. An organic light emitting device comprising: a first electrode; a second electrode; and an organic material layer provided between the first electrode and the second electrode,
wherein the organic material layer comprises a compound of the following Chemical Formula 1 and a compound of the following Chemical Formula 2: 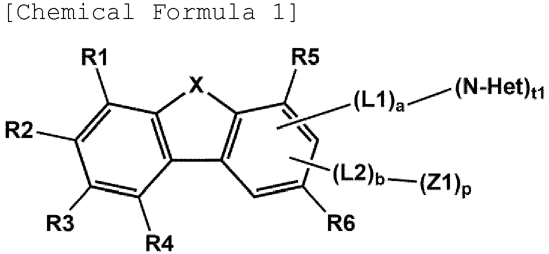 in Chemical Formula 1,
X is O or S,
L1 and L2 are the same as or different from each other, and are each independently a direct bond; a substituted or unsubstituted C6 to C60 arylene group; or a substituted or unsubstituted C2 to C60 heteroarylene group,
Z1 is a substituted or unsubstituted C6 to C60 aryl group; or a substituted or unsubstituted C2 to C60 heteroaryl group,
N-Het is a monocyclic or polycyclic C2 to C60 heteroaryl group which is substituted or unsubstituted and includes one or more N's,
R1 to R6 are the same as or different from each other, and are each independently hydrogen; deuterium; a halogen group; -CN; a substituted or unsubstituted C1 to C60 alkyl group; a substituted or unsubstituted C6 to C60 aryl group; or a substituted or unsubstituted C2 to C60 heteroaryl group,
a and b are each an integer from 0 to 3, and when a is 2 or higher, L1's are the same as or different from each other, and when b is 2 or higher, L2's are the same as or different from each other,
p and t1 are each an integer from 1 to 3, and when p is 2 or higher, Z1's are the same as or different from each other, and when t1 is 2 or higher, N-Het's are the same as or different from each other, 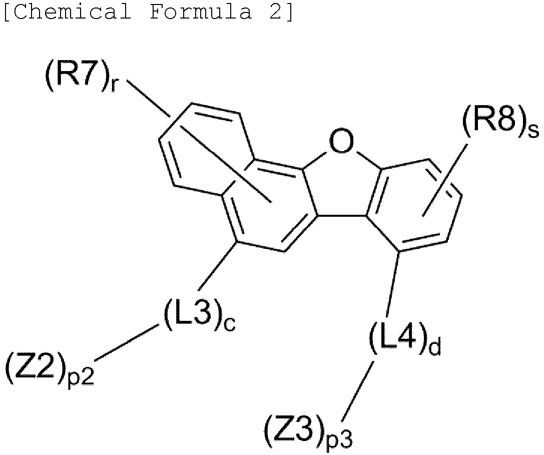 in Chemical Formula 2,
L3 and L4 are the same as or different from each other, and are each independently a direct bond; or a substituted or unsubstituted C6 to C60 arylene group,
Z2 and Z3 are each independently a substituted or unsubstituted amine group; a substituted or unsubstituted C6 to C60 aryl group; or a substituted or unsubstituted C2 to C60 heteroaryl group,
any one of Z2 and Z3 is a substituted or unsubstituted amine group, and the other is a substituted or unsubstituted C6 to C60 aryl group; or a substituted or unsubstituted C2 to C60 heteroaryl group,
R7 and R8 are the same as or different from each other, and are each independently hydrogen; deuterium; a halogen group; -CN; a substituted or unsubstituted C1 to C60 alkyl group; a substituted or unsubstituted C6 to C60 aryl group; or a substituted or unsubstituted C2 to C60 heteroaryl group,
c and d are each an integer from 0 to 3, and when c is 2 or higher, L3's are the same as or different from each other, and when d is 2 or higher, L4's are the same as or different from each other,
p2 and p3 are each an integer from 1 to 3, and when p2 is 2 or higher, Z2's are the same as or different from each other, and when p3 is 2 or higher, Z3's are the same as or different from each other,
r is an integer from 0 to 5, and when r is 2 or higher, R7's are the same as or different from each other, and
s is an integer from 0 to 3, and when s is 2 or higher, R8's are the same as or different from each other.

2. The organic light emitting device of claim 1, wherein Chemical Formula 1 is represented by any one of the following Chemical Formulae 1-1 and 1-2: 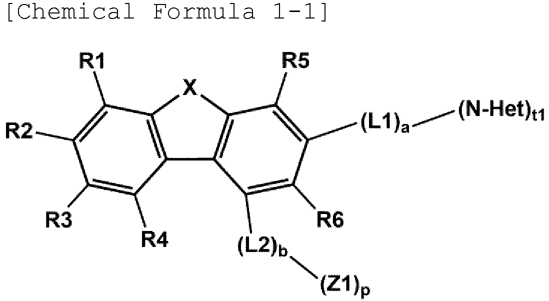 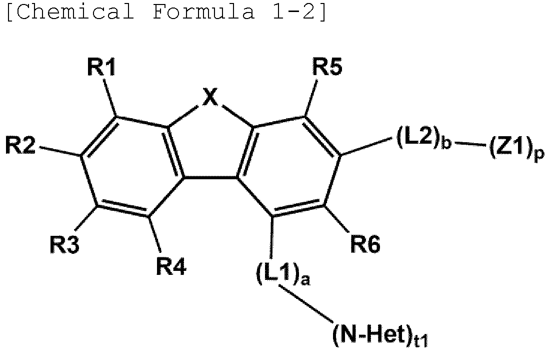 in Chemical Formulae 1-1 and 1-2,
X, R1 to R6, L1, L2, Z1, N-Het, a, b, p and t1 are the same as the definitions in Chemical Formula 1.

3. The organic light emitting device of claim 1,
wherein the N-Het is represented by the following Chemical Formula 3: 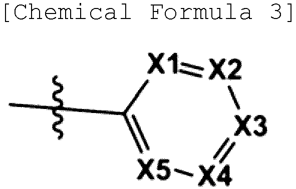 in Chemical Formula 3,
X1 is CR11 or N, X2 is CR12 or N, X3 is CR13 or N, X4 is CR14 or N, and X5 is CR15 or N,
at least one of X1 to X5 is N, and
R11 to R15 are the same as or different from each other, and are each independently selected from the group consisting of hydrogen; deuterium; a halogen group; -CN; **a** substituted or unsubstituted C1 to C60 alkyl group; a substituted or unsubstituted C6 to C60 aryl group; a substituted or unsubstituted C2 to C60 heteroaryl group; and an amine group which is unsubstituted or substituted with a substituted or unsubstituted alkyl group, a substituted or unsubstituted aryl group or a substituted or unsubstituted heteroaryl group, or two or more adjacent groups are bonded to each other to form a substituted or unsubstituted aromatic hydrocarbon ring or a substituted or unsubstituted hetero ring.

4. The organic light emitting device of claim 3,
wherein Chemical Formula 3 is represented by any one of the following Chemical Formulae 3-1 to 3-3: 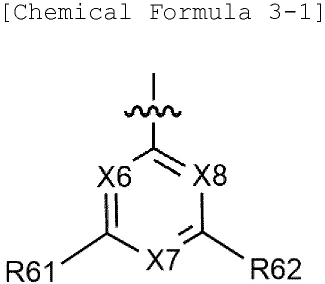 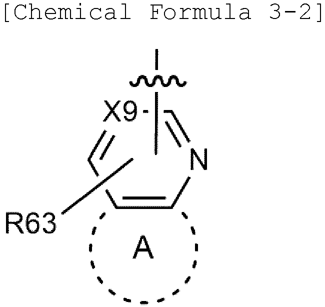 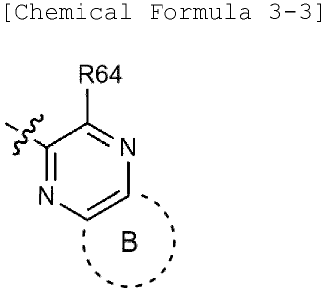 in Chemical Formulae 3-1 to 3-3,
X6 to X9 are each N or CR16,
at least one of X6 to X8 is N, A and B are the same as or different from each other, and are each independently a substituted or unsubstituted monocyclic or polycyclic C6 to C60 aryl ring; or a substituted or unsubstituted monocyclic or polycyclic C2 to C60 hetero ring, and
R16 and R61 to R64 are the same as or different from each other, and are each independently hydrogen; deuterium; a halogen group; a cyano group; a substituted or unsubstituted C1 to C60 alkyl group; a substituted or unsubstituted C6 to C60 aryl group; or a substituted or unsubstituted C2 to C60 heteroaryl group.

5. The organic light emitting device of claim 1, wherein Z1 is a substituted or unsubstituted phenyl group; a substituted or unsubstituted biphenyl group; a substituted or unsubstituted terphenyl group; a substituted or unsubstituted naphthyl group; a substituted or unsubstituted phenanthrene group; a substituted or unsubstituted triphenylene group; a substituted or unsubstituted fluorenyl group; a substituted or unsubstituted dibenzofuran group; a substituted or unsubstituted dibenzothiophene group; a substituted or unsubstituted naphthobenzofuran group; a substituted or unsubstituted naphthobenzothiophene group; or a substituted or unsubstituted carbazole group.

6. The organic light emitting device of claim 1,
wherein a deuterium content of the compound of Chemical Formula 1 is 0% or 1% to 100%.

7. The organic light emitting device of claim 1,
wherein Chemical Formula 1 is represented by any one of the following compounds:

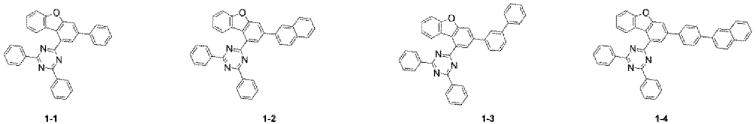

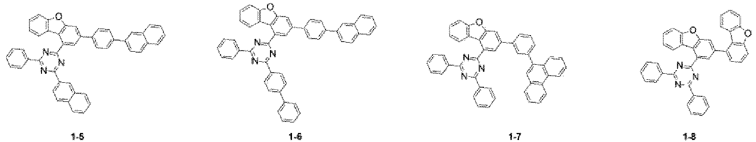

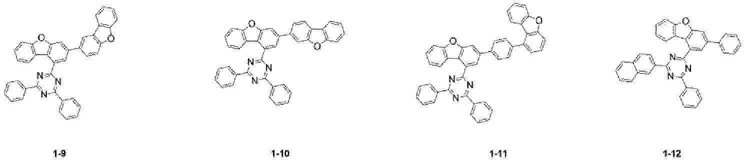

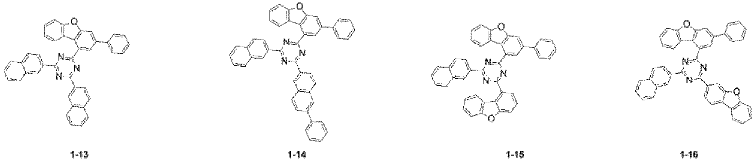

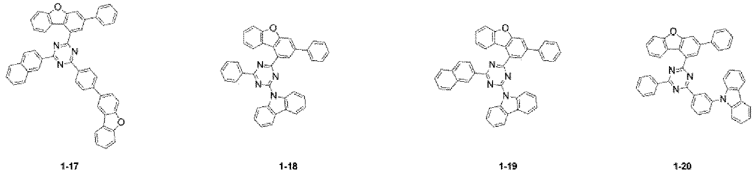

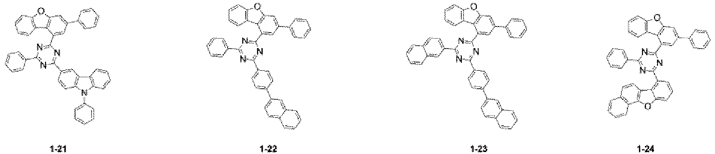

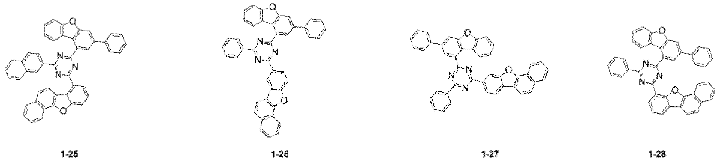

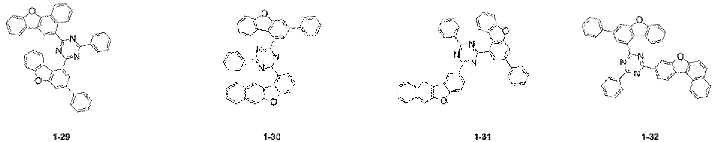

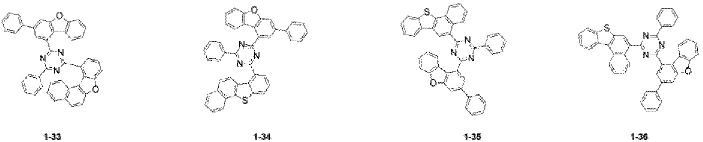

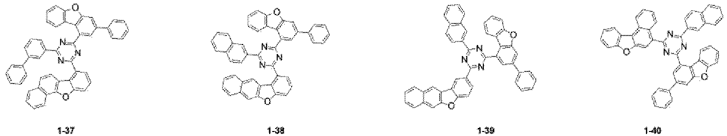

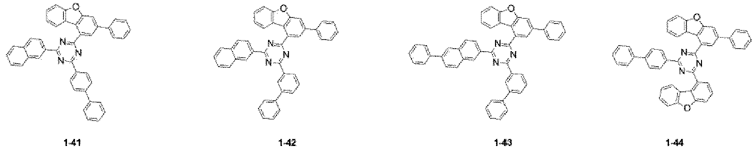

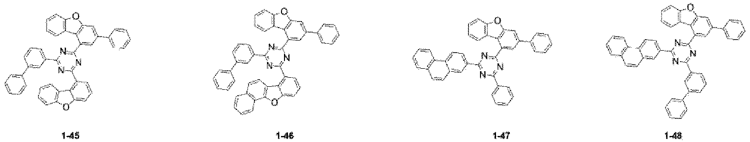

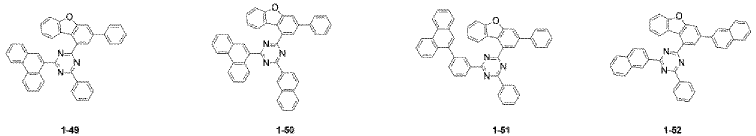

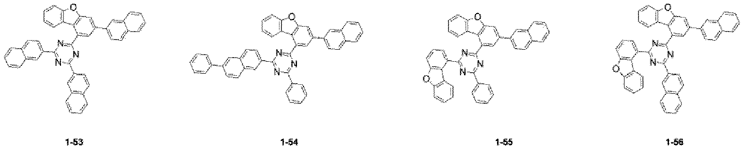

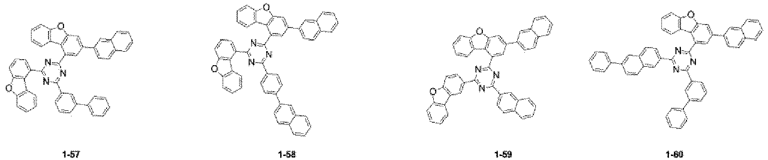

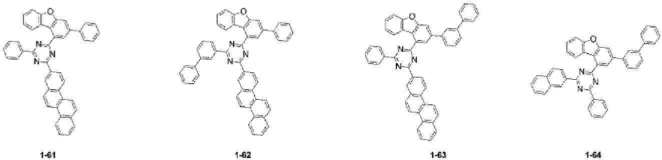

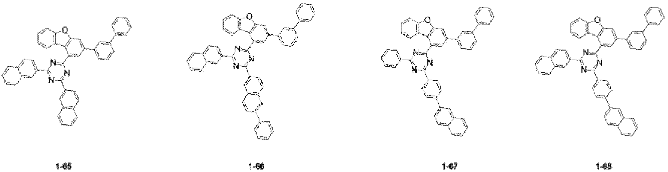

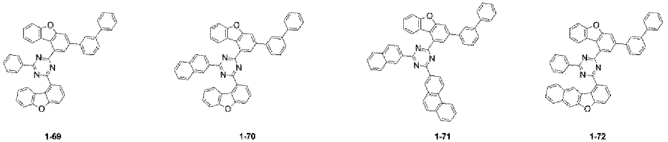

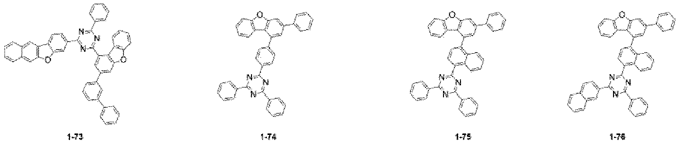

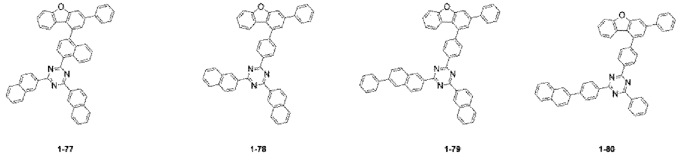

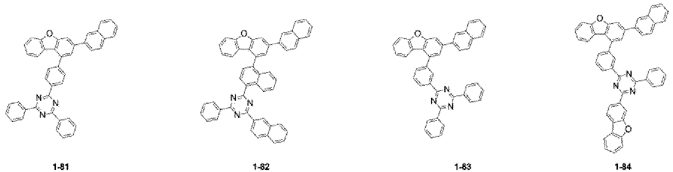

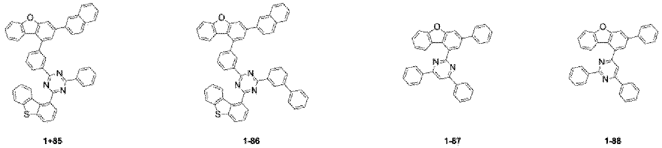

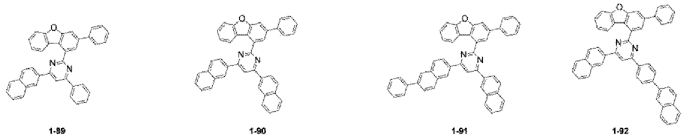

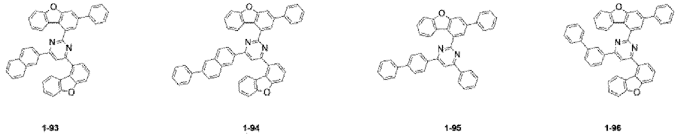

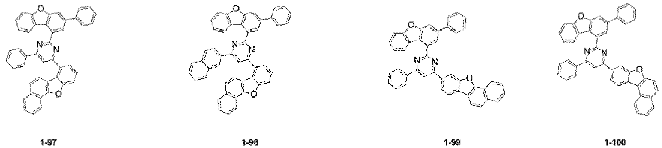

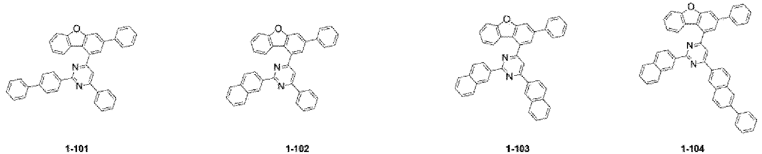

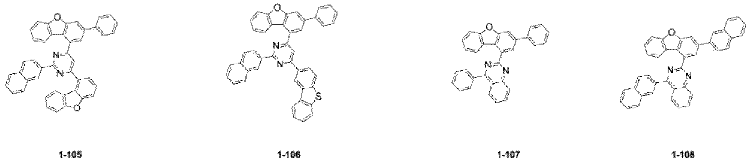

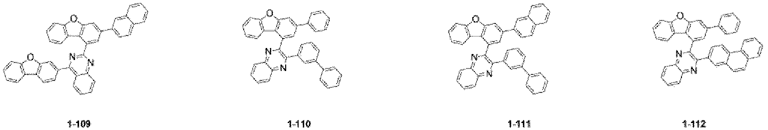

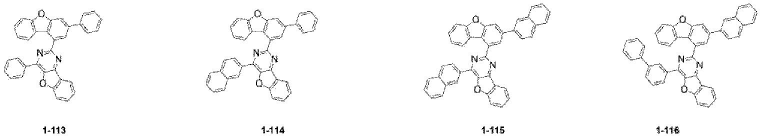

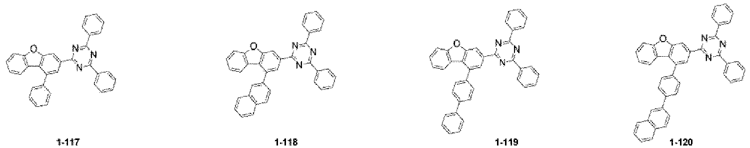

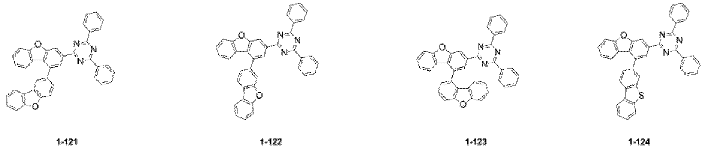

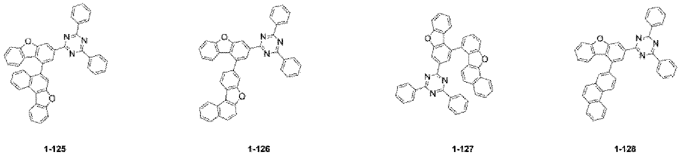

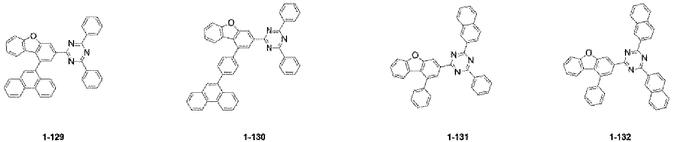

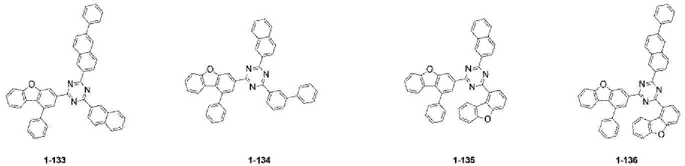

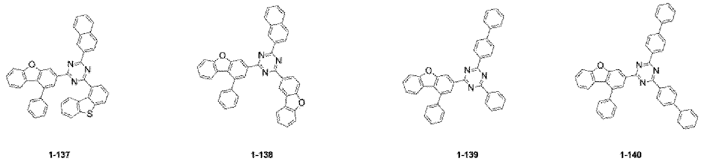

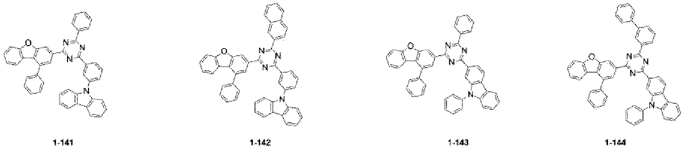

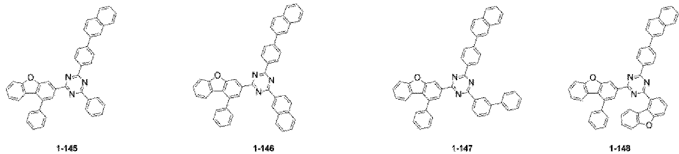

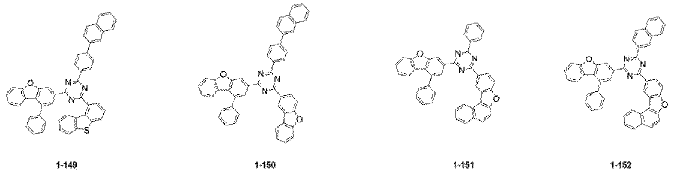

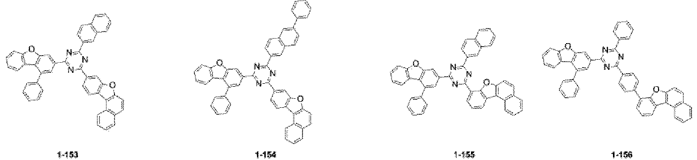

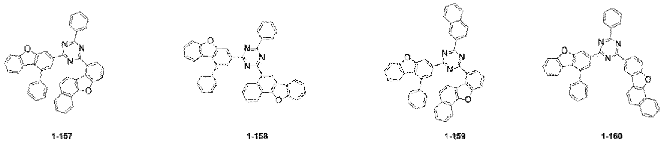

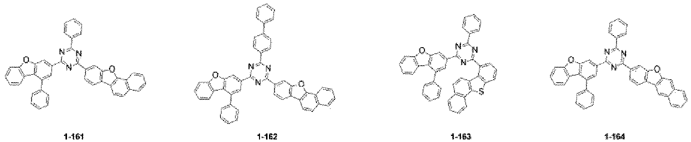

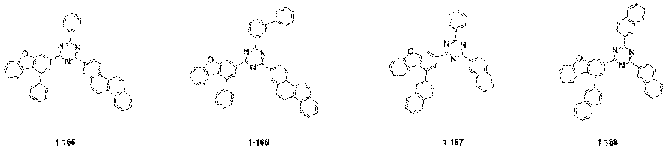

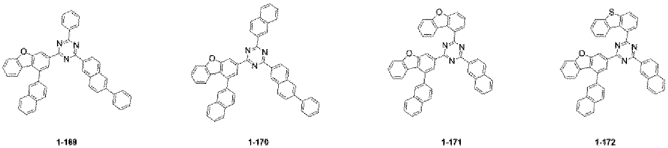

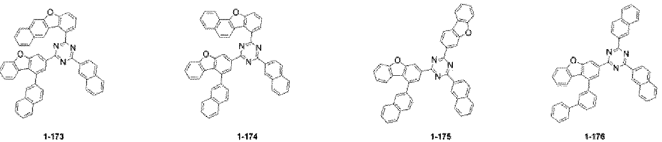

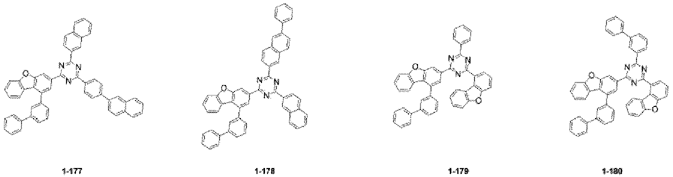

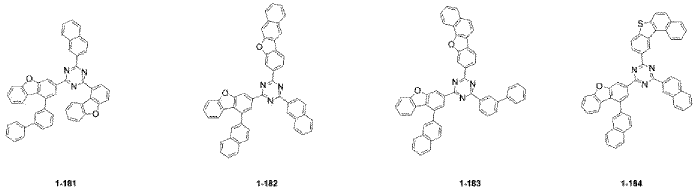

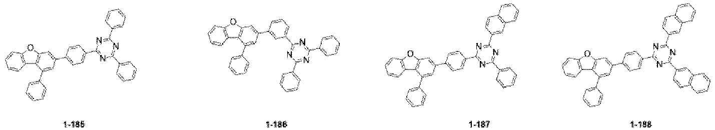

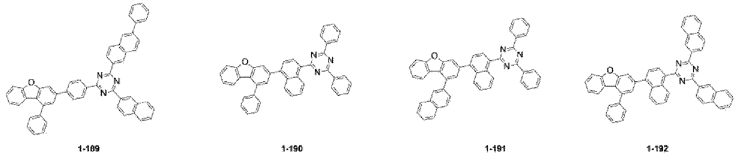

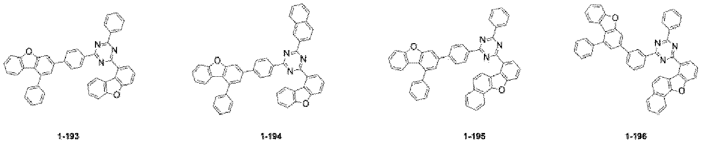

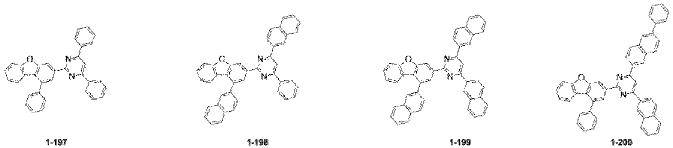

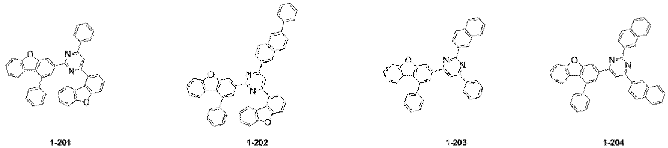

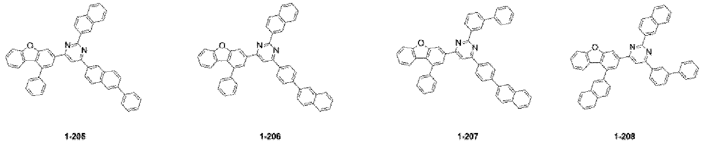

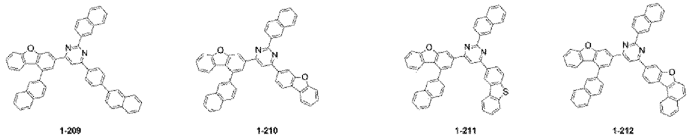

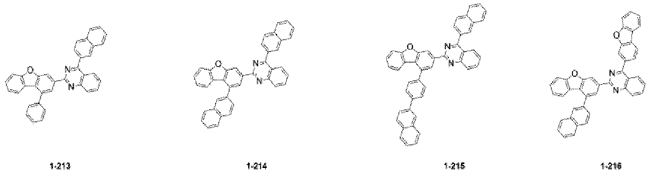

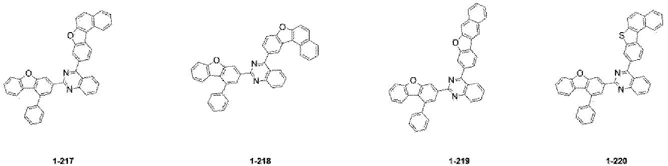

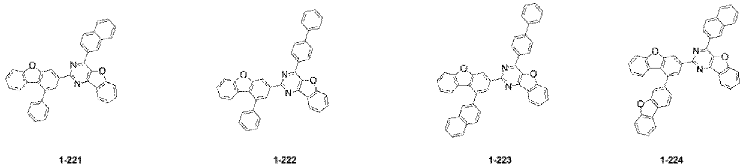

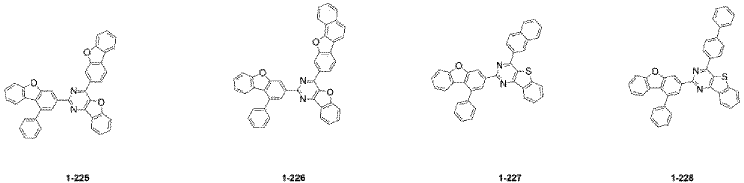

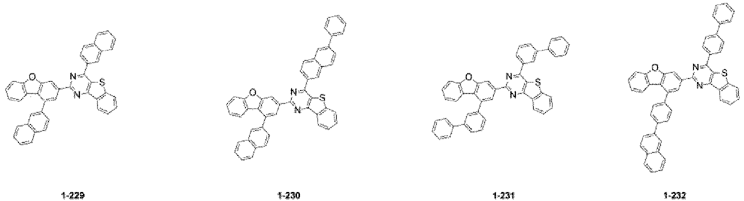

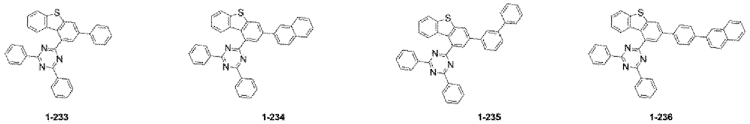

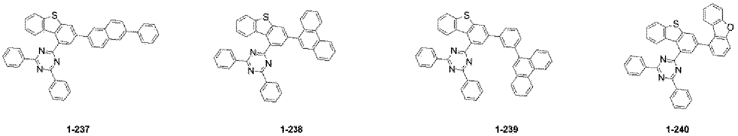

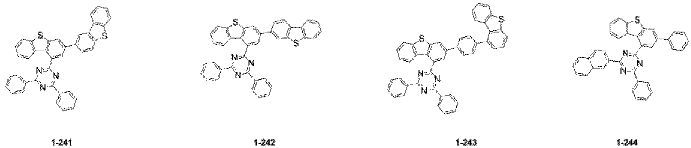

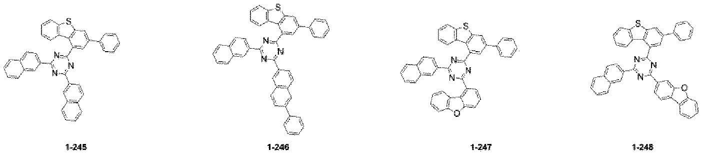

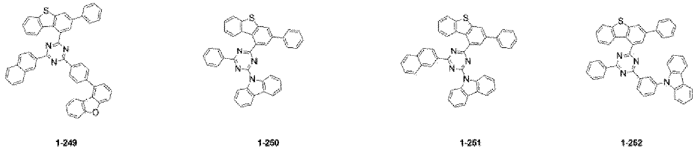

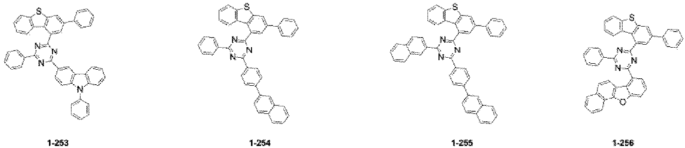

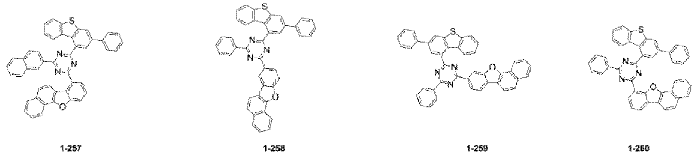

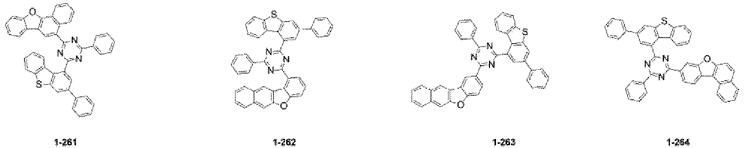

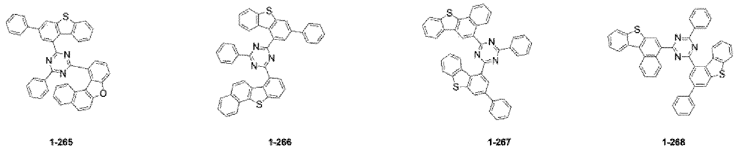

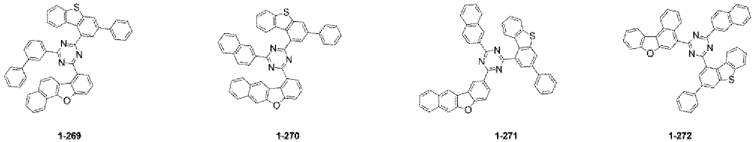

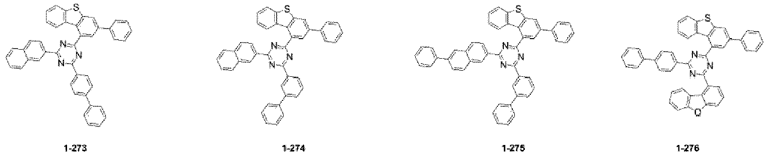

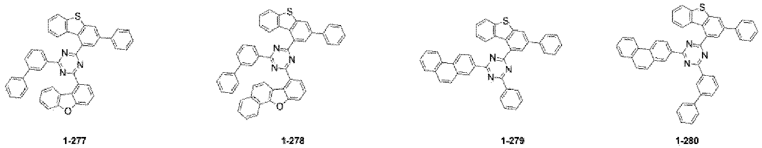

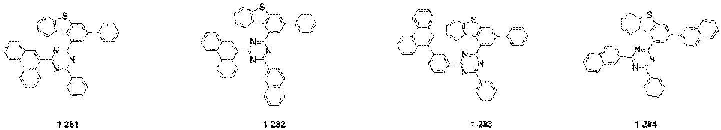

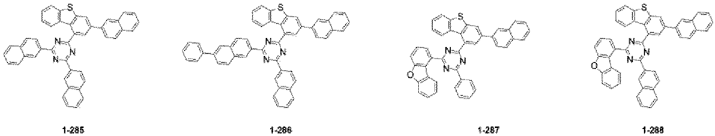

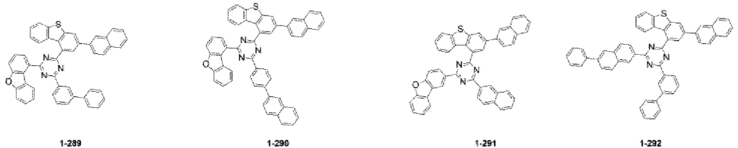

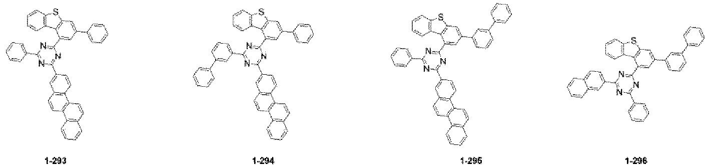

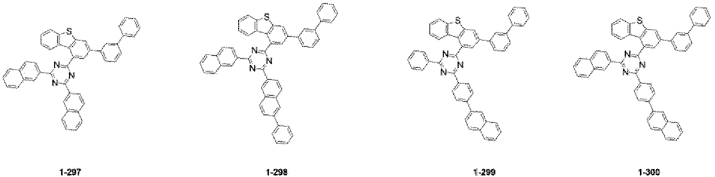

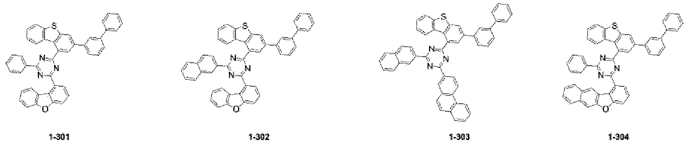

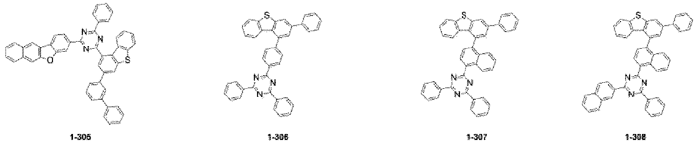

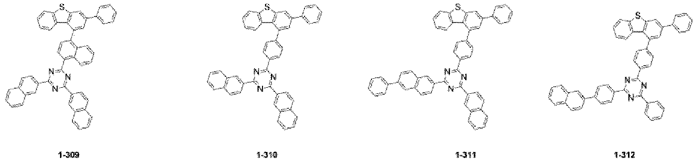

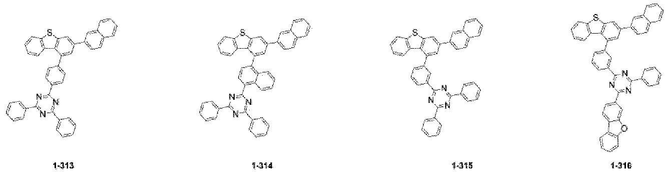

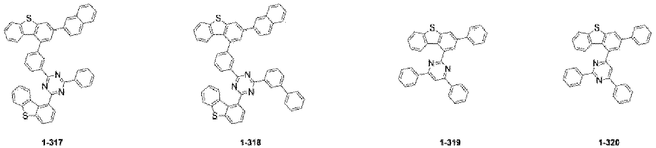

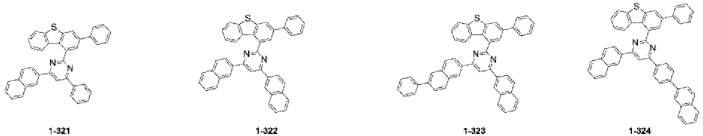

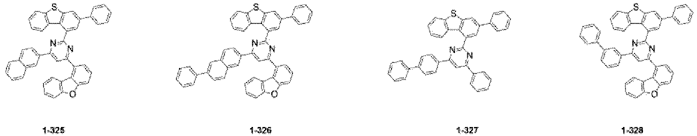

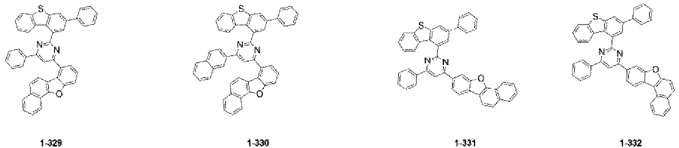

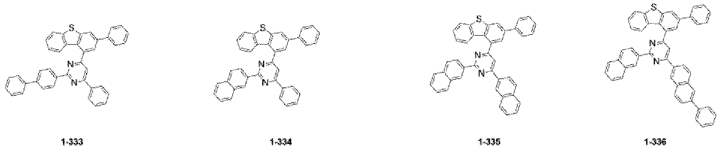

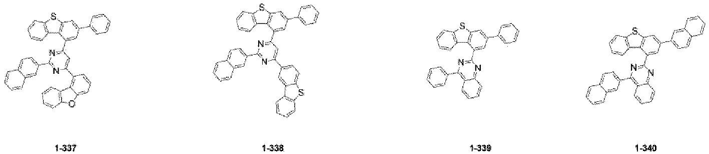

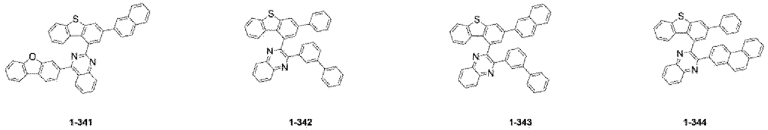

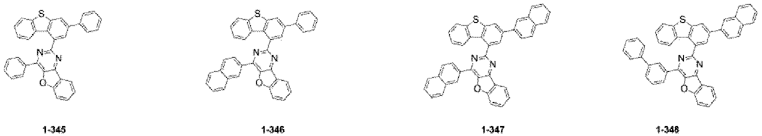

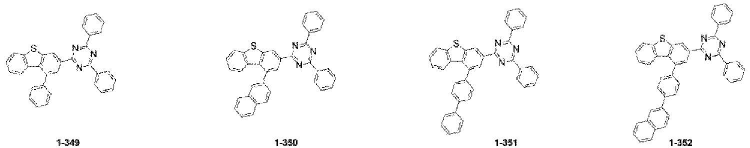

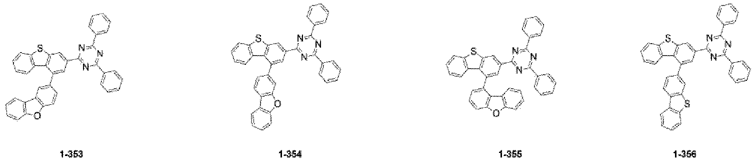

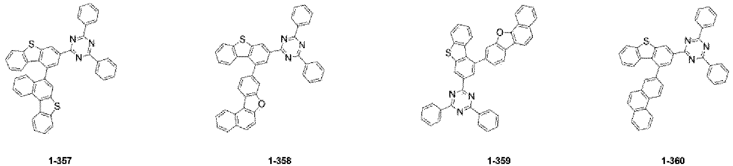

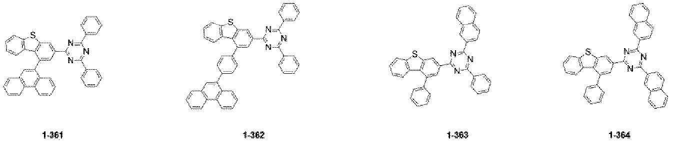

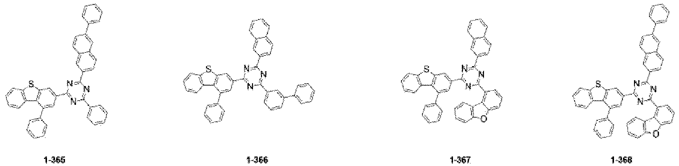

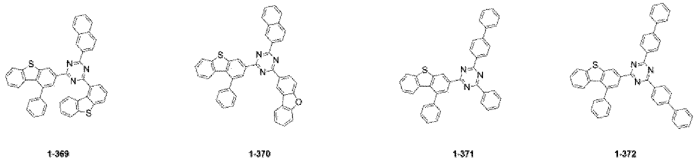

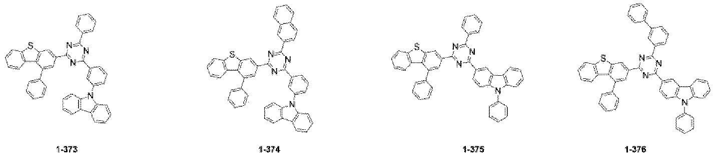

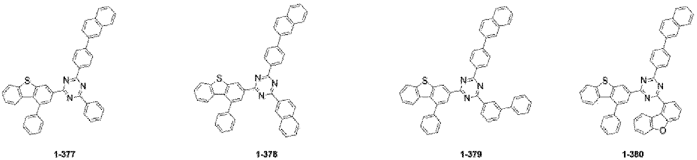

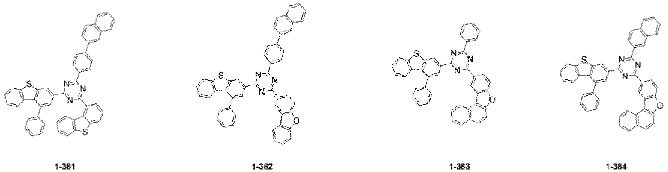

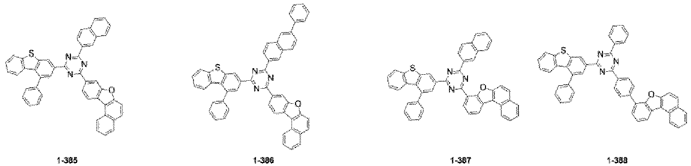

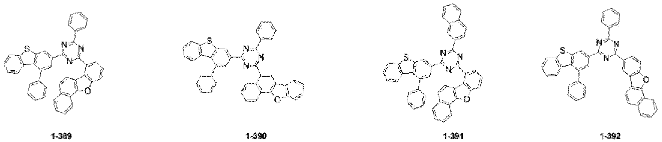

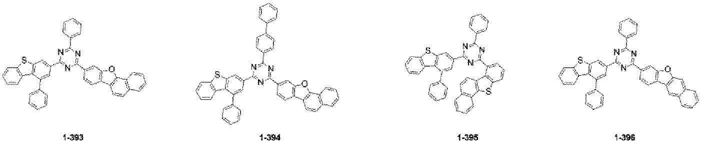

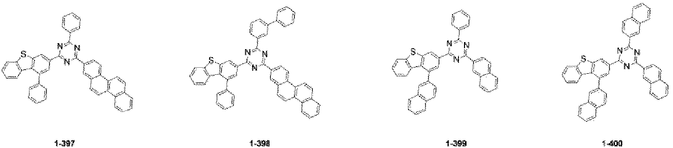

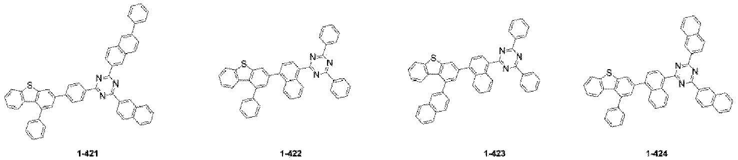

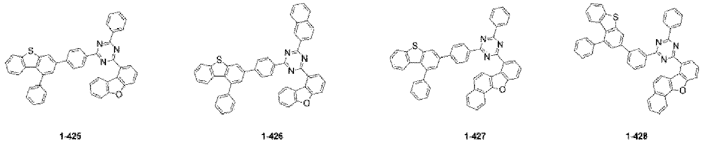

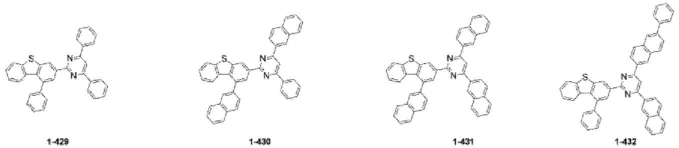

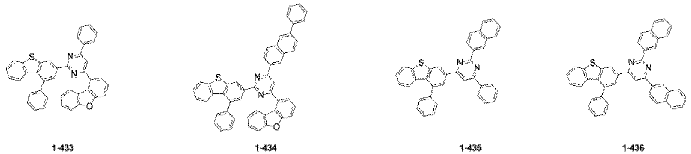

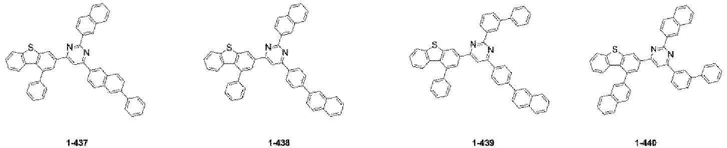

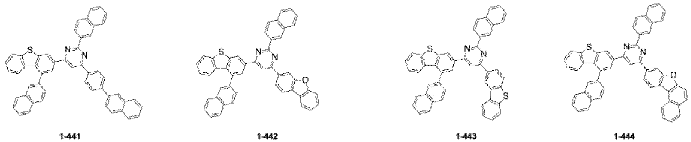

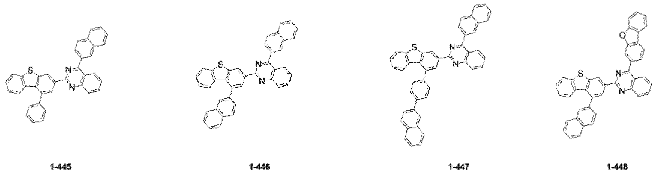

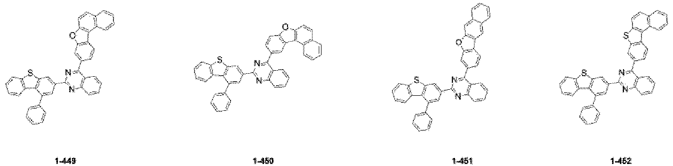

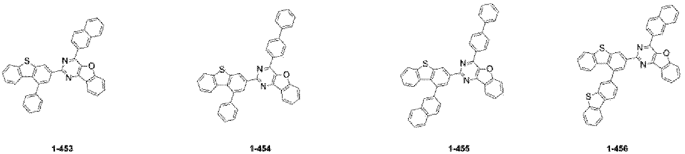

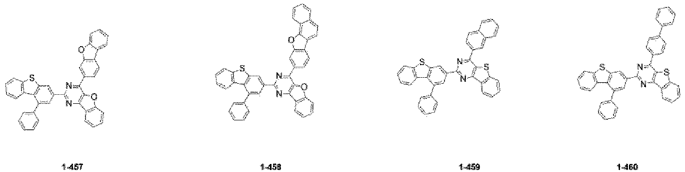

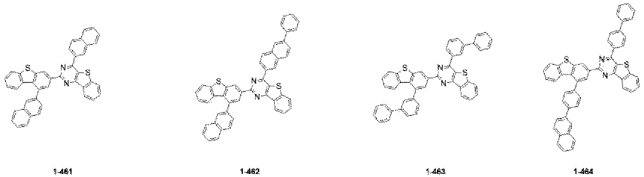

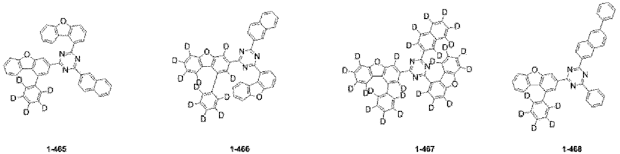

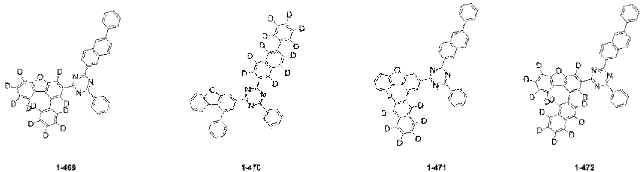

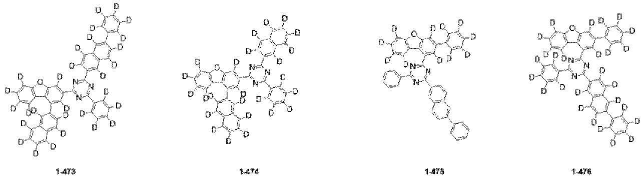

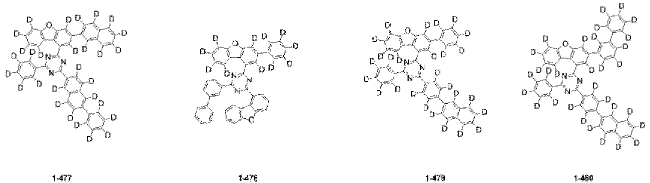

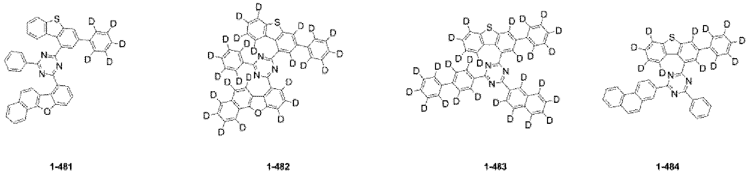

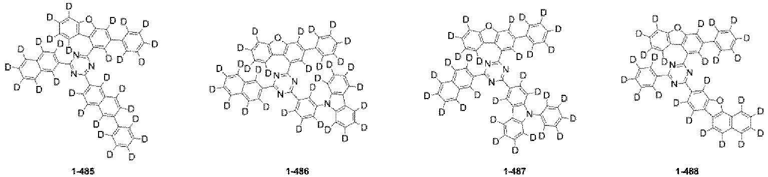

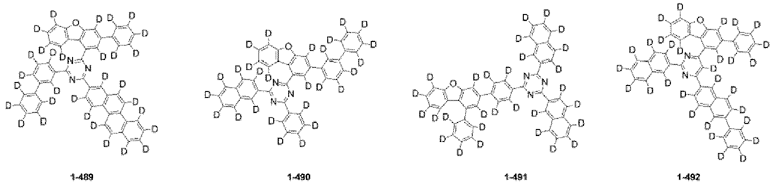

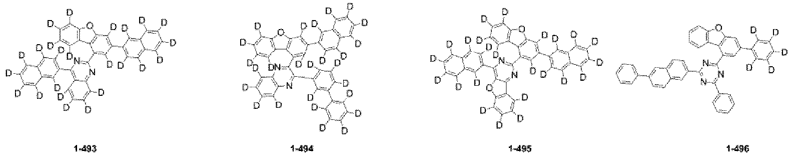

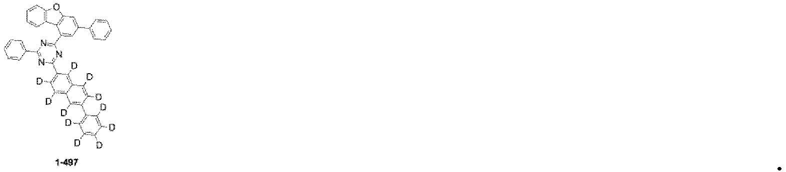

8. The organic light emitting device of claim 1,
wherein Formula 2 is represented by the following Chemical Formula 2-1 or Chemical Formula 2-2: 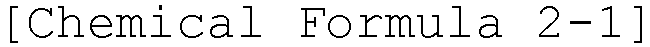 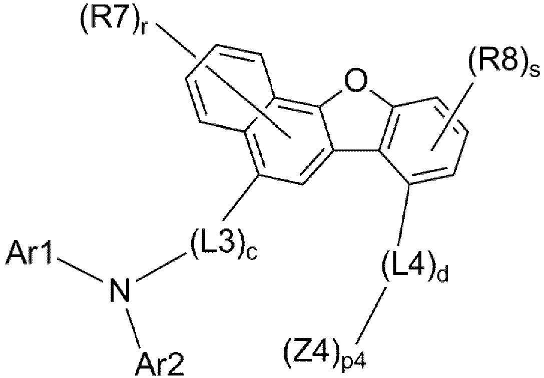 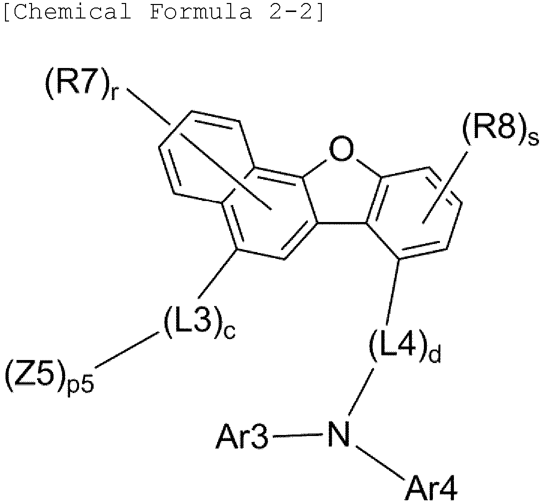 in Chemical Formulae 2-1 and 2-2,
L3, L4, R7, R8, c, d, r and s are the same as the definitions in Chemical Formula 2,
Arl to Ar4 are the same as or different from each other, and are each independently a substituted or unsubstituted C6 to C60 aryl group; or a substituted or unsubstituted C2 to C60 heteroaryl group,
Z4 and Z5 are the same as or different from each other, and are each independently a substituted or unsubstituted C6 to C60 aryl group; or a substituted or unsubstituted C2 to C60 heteroaryl group, and
p4 and p5 are each an integer from 1 to 3, and when p4 is 2 or higher, Z4's are the same as or different from each other, and when p5 is 2 or higher, Z5's are the same as or different from each other.

9. The organic light emitting device of claim 1, wherein Z2 and Z3 are the same as or different from each other, and are each independently an amine group substituted with a substituted or unsubstituted C6 to C60 aryl group or a substituted or unsubstituted C2 to C60 heteroaryl group; a substituted or unsubstituted phenyl group; a substituted or unsubstituted naphthyl group; a substituted or unsubstituted dibenzofuran group; or a substituted or unsubstituted dibenzothiophene group, any one of Z2 and Z3 is an amine group substituted with a substituted or unsubstituted C6 to C60 aryl group or a substituted or unsubstituted C2 to C60 heteroaryl group, and the other is a substituted or unsubstituted phenyl group; a substituted or unsubstituted naphthyl group; a substituted or unsubstituted dibenzofuran group; or a substituted or unsubstituted dibenzothiophene group.

10. The organic light emitting device of claim 8,
wherein Arl to Ar4 are the same as or different from each other, and are each independently a substituted or unsubstituted phenyl group; a substituted or unsubstituted biphenyl group; a substituted or unsubstituted terphenyl group; a substituted or unsubstituted naphthyl group; a substituted or unsubstituted fluorenyl group; a substituted or unsubstituted dibenzofuran group; a substituted or unsubstituted dibenzothiophene group; a substituted or unsubstituted naphthobenzofuran group; or a substituted or unsubstituted naphthobenzothiophene group.

11. The organic light emitting device of claim 1,
wherein a deuterium content of the compound of Chemical Formula 2 is 0% or 1% to 100%.

12. The organic light emitting device of claim 1,
wherein Chemical Formula 2 is represented by any one of the following compounds:

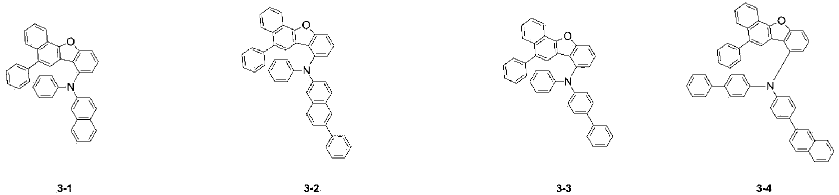

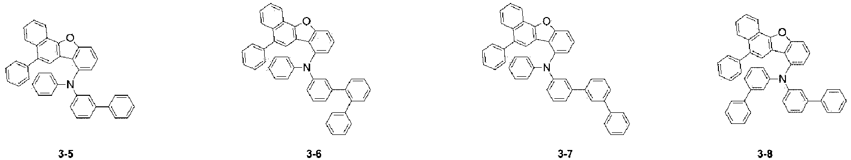

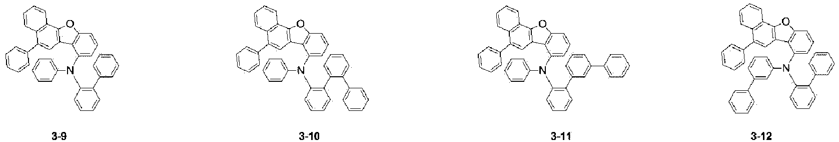

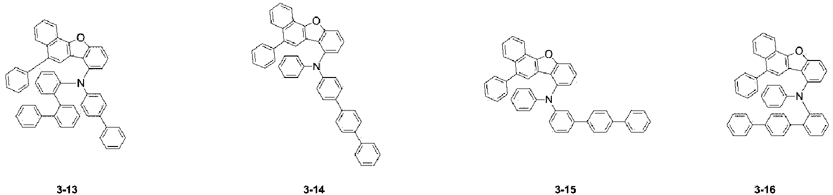

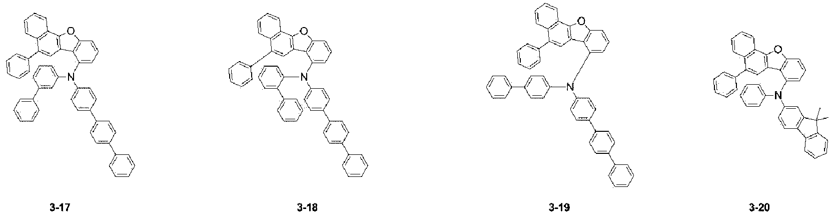

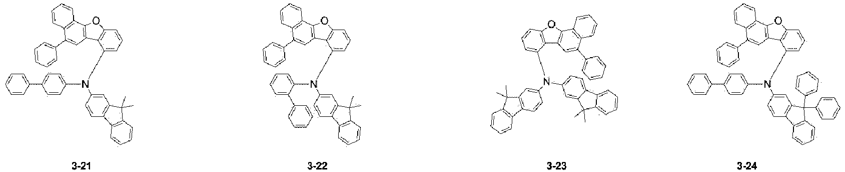

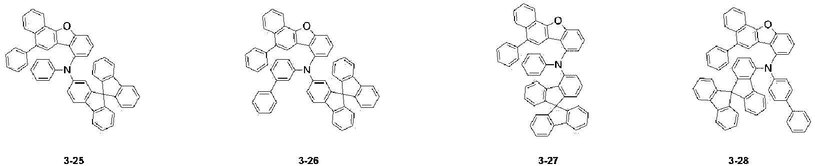

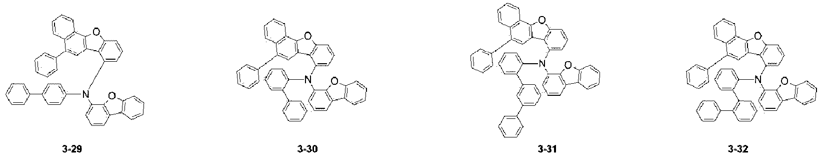

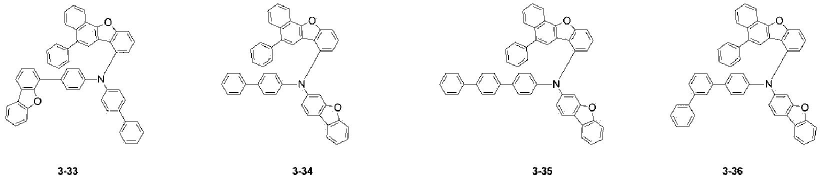

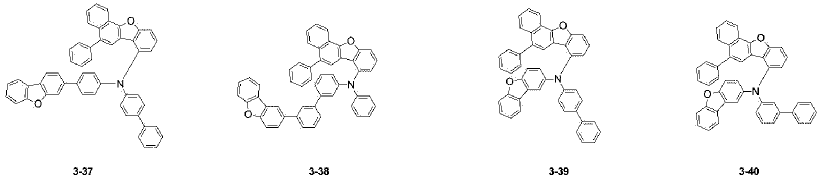

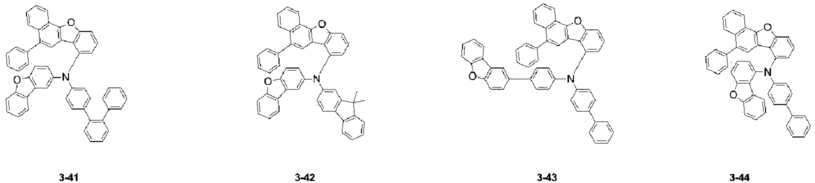

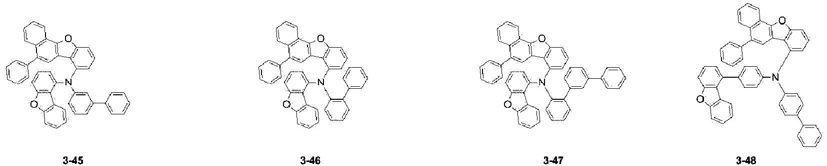

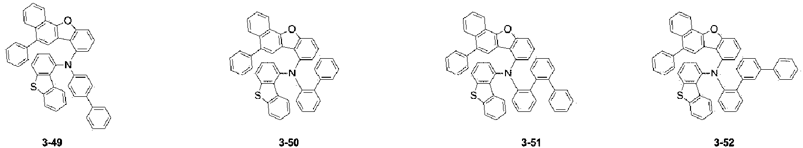

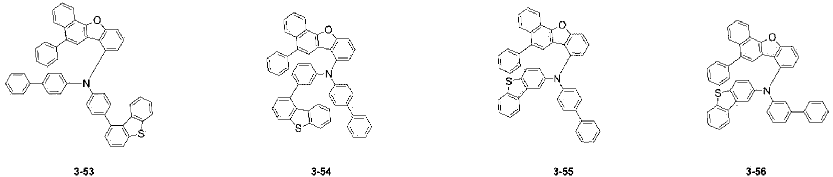

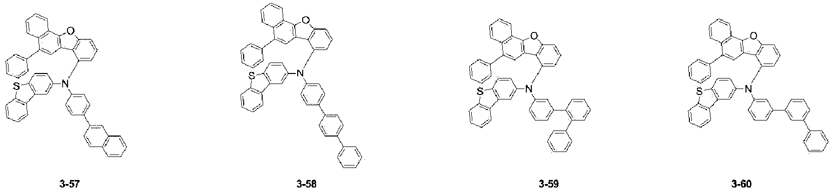

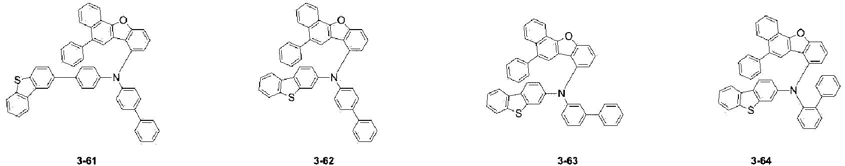

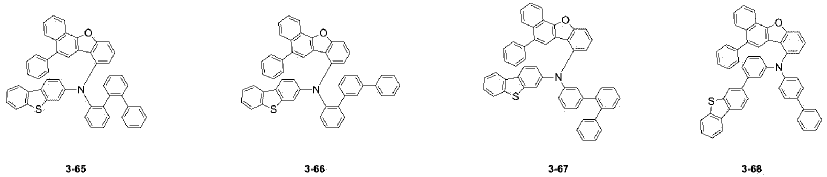

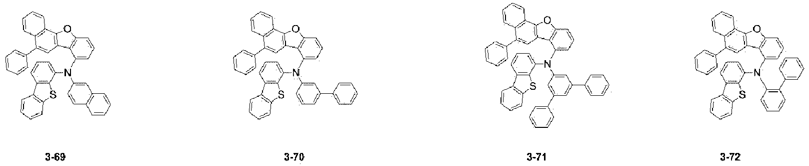

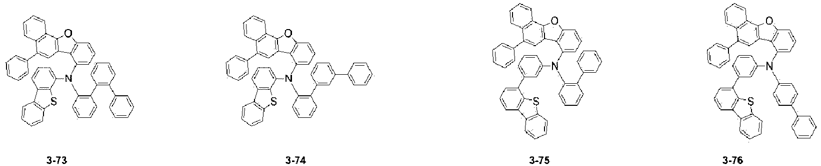

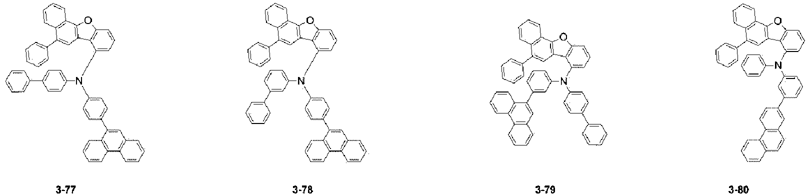

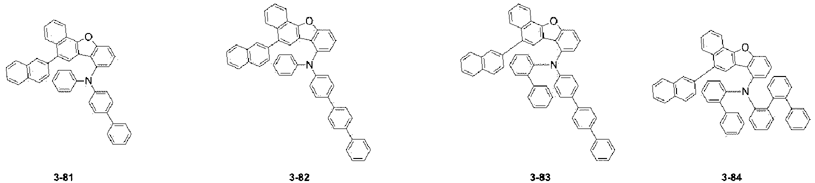

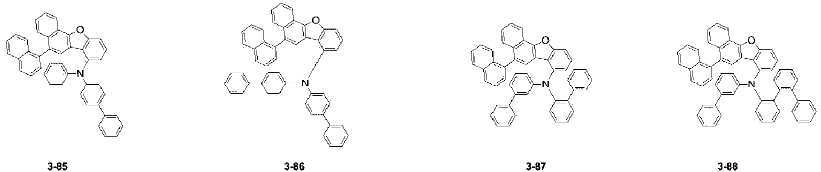

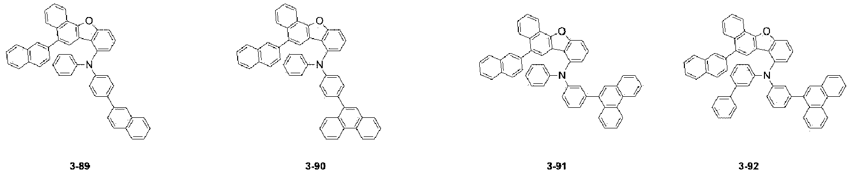

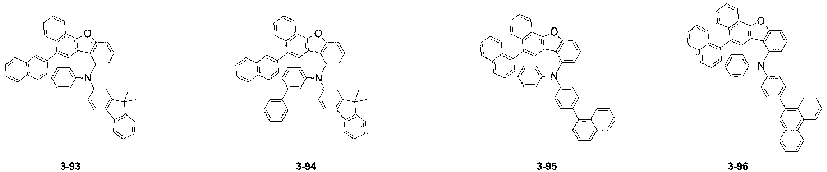

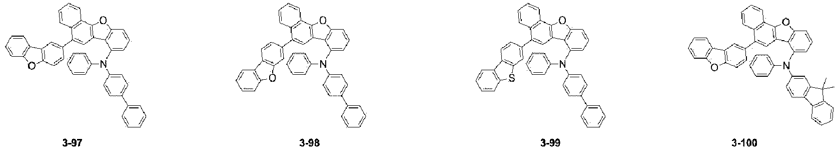

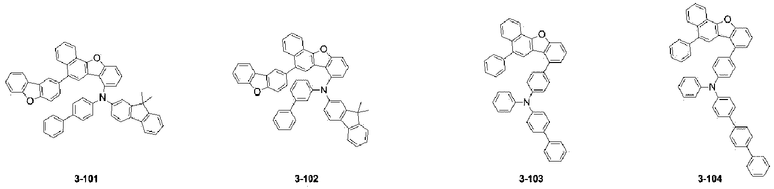

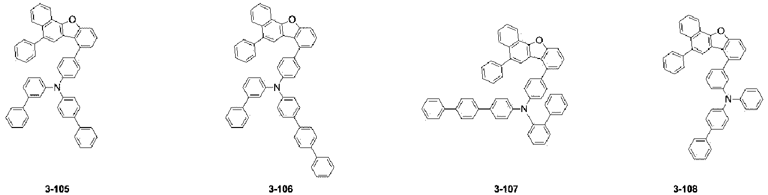

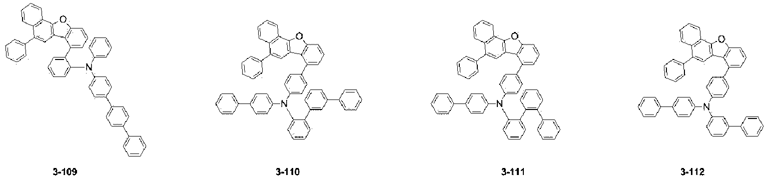

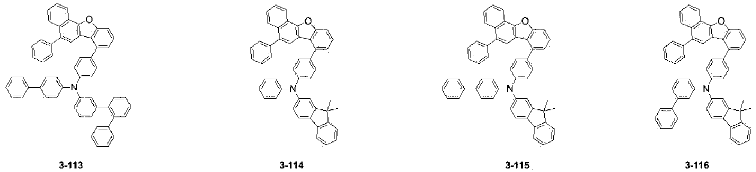

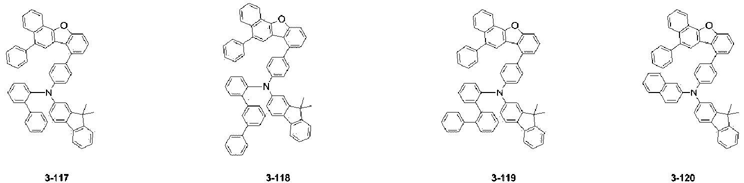

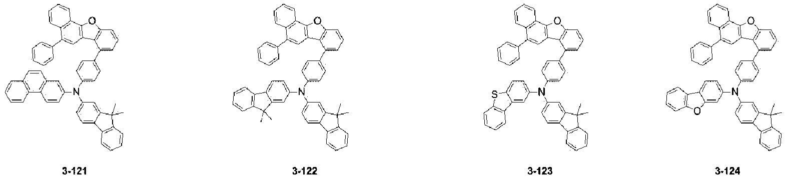

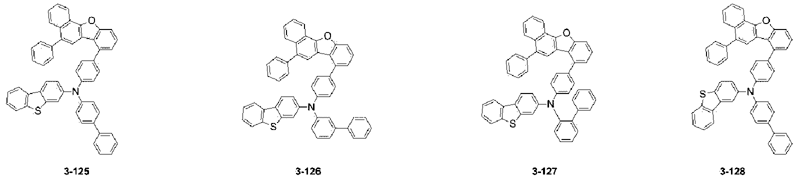

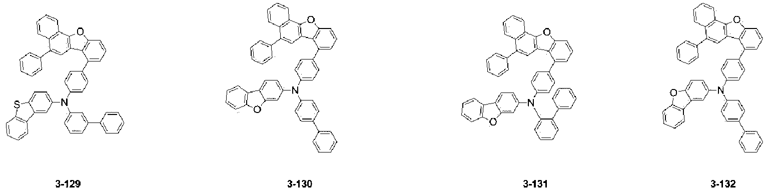

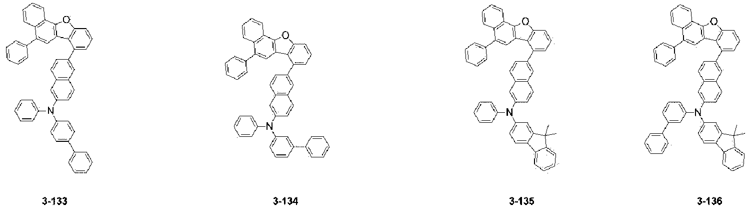

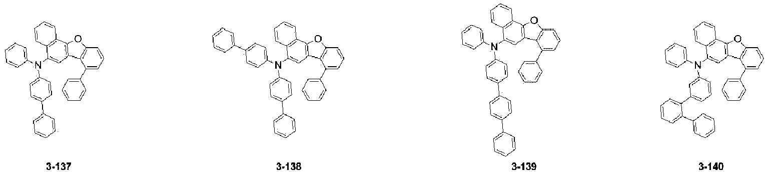

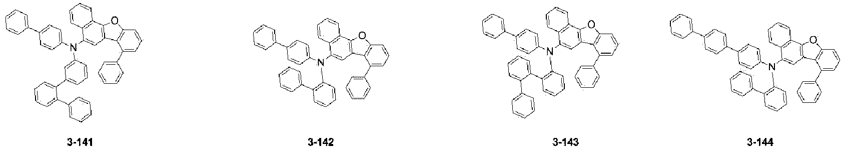

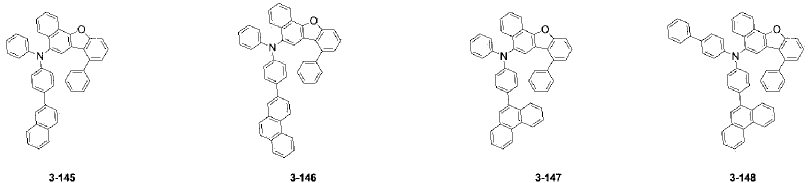

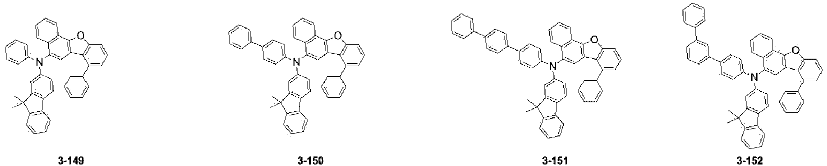

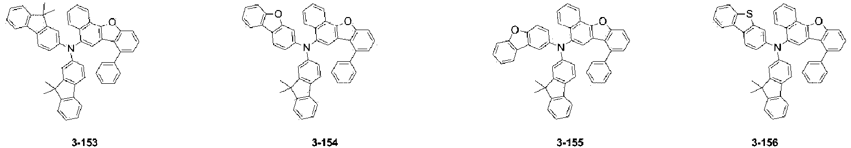

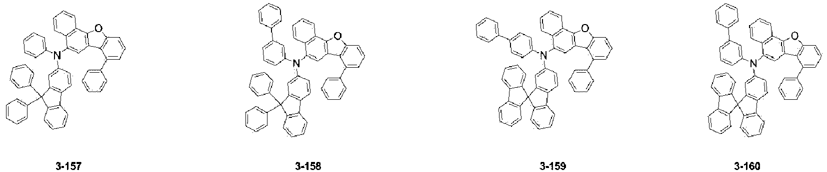

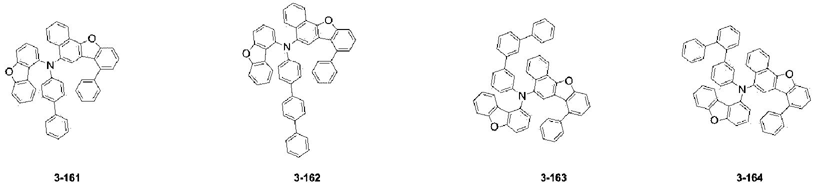

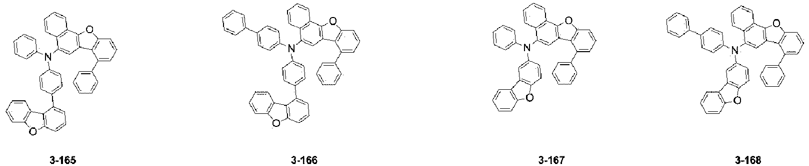

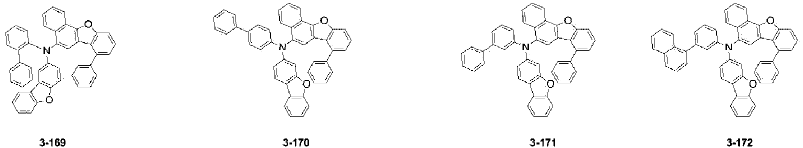

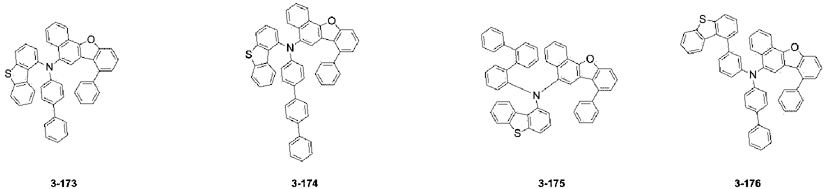

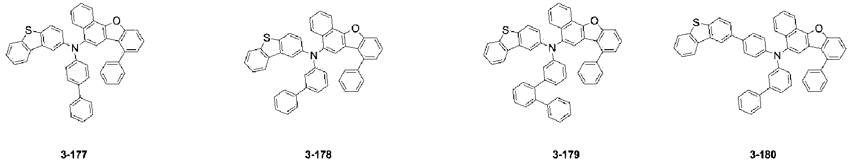

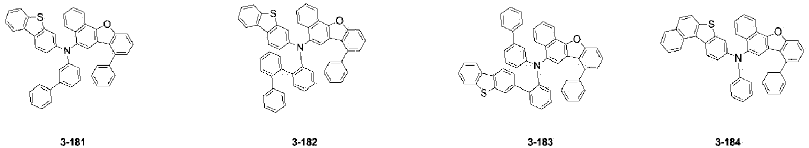

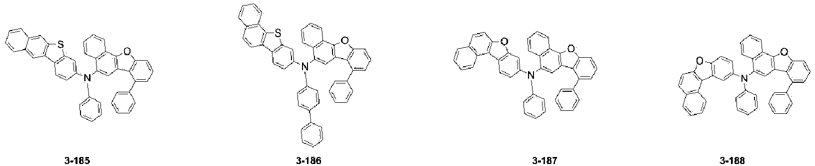

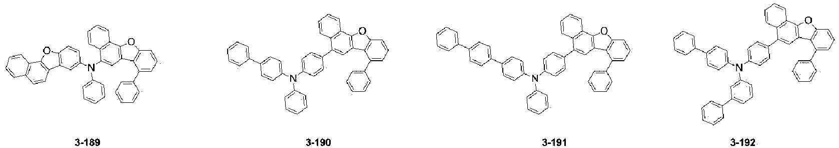

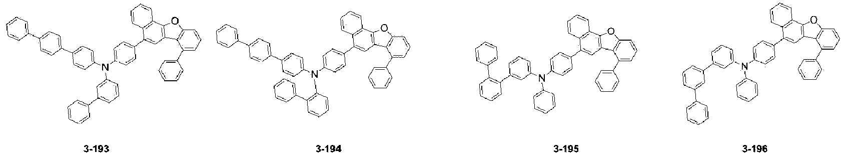

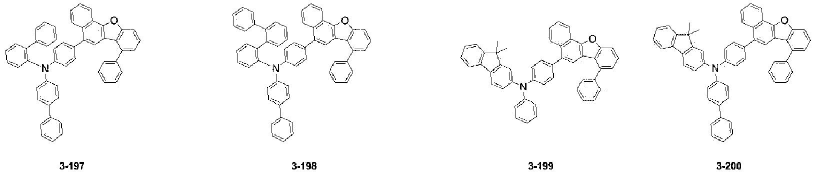

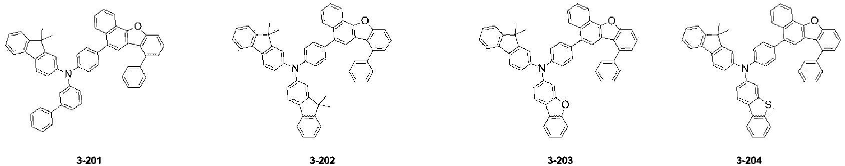

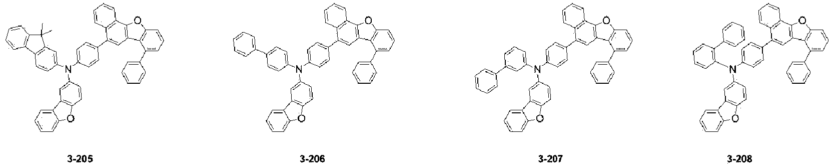

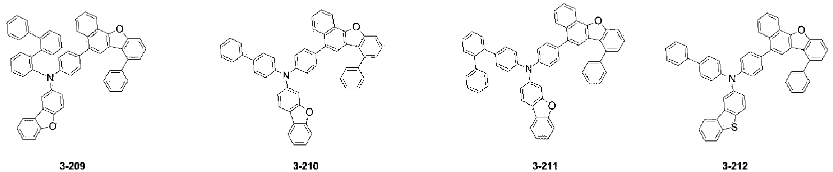

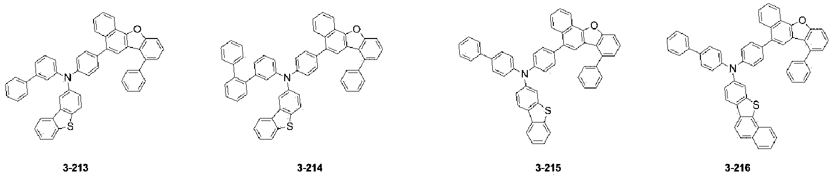

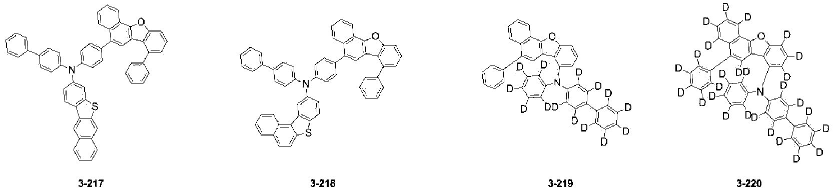

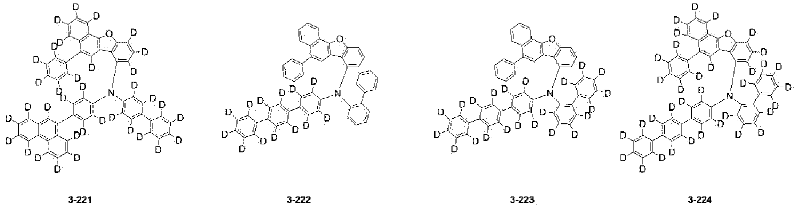

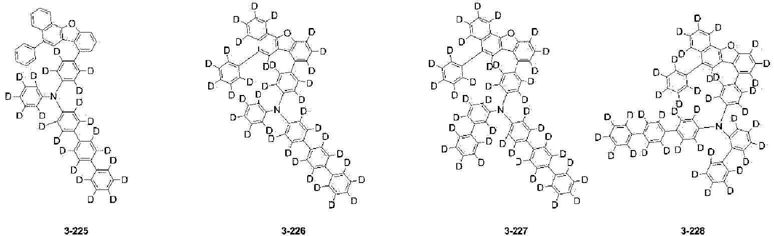

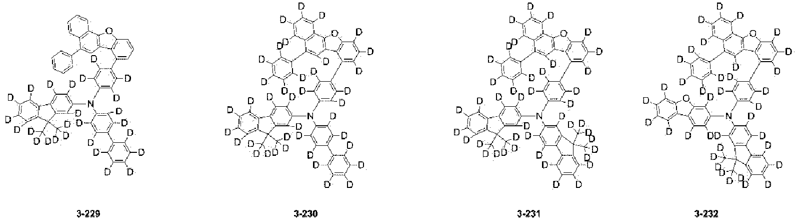

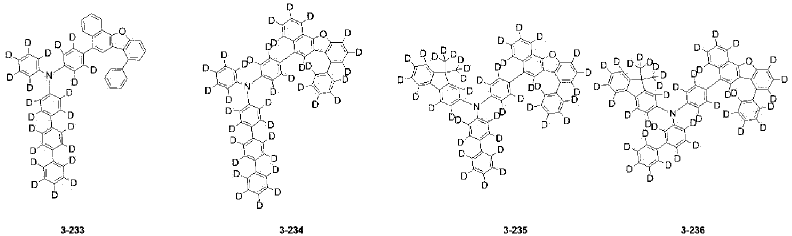

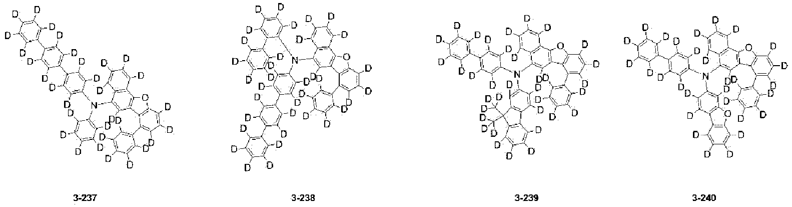

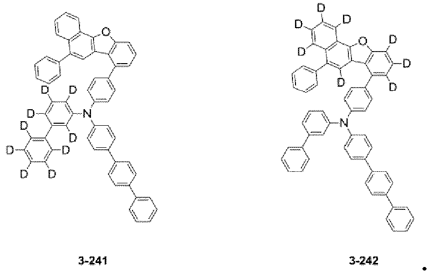

13. The organic light emitting device of claim 1,
wherein the organic material layer comprises a light emitting layer, and the light emitting layer comprises the compound of Chemical Formula 1 and the compound of Chemical Formula 2.

14. The organic light emitting device of claim 1,
wherein the organic material layer comprises a light emitting layer, and the light emitting layer comprises a host material, and the host material comprises the compound of Chemical Formula 1 and the compound of Chemical Formula 2.

15. The organic light emitting device of claim 1, further comprising one or two or more layers selected from the group consisting of a light emitting layer, a hole injection layer, a hole transport layer, a hole blocking layer, an electron blocking layer, a hole blocking layer, an electron transport layer and an electron injection layer.

16. A composition for forming an organic material layer comprising a compound of the following Chemical Formula 1 and a compound of the following Chemical Formula 2: 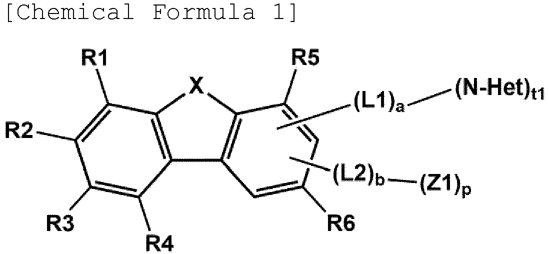 in Chemical Formula 1,
X is O or S,
L1 and L2 are the same as or different from each other, and are each independently a direct bond; a substituted or unsubstituted C6 to C60 arylene group; or a substituted or unsubstituted C2 to C60 heteroarylene group,
Z1 is a substituted or unsubstituted C6 to C60 aryl group; or a substituted or unsubstituted C2 to C60 heteroaryl group,
N-Het is a monocyclic or polycyclic C2 to C60 heteroaryl group which is substituted or unsubstituted and includes one or more N's,
R1 to R6 are the same as or different from each other, and are each independently hydrogen; deuterium; a halogen group; -CN; a substituted or unsubstituted C1 to C60 alkyl group; a substituted or unsubstituted C6 to C60 aryl group; or a substituted or unsubstituted C2 to C60 heteroaryl group,
a and b are each an integer from 0 to 3, and when a is 2 or higher, L1's are the same as or different from each other, and when b is 2 or higher, L2's are the same as or different from each other,
p and t1 are each an integer from 1 to 3, and when p is 2 or higher, Z1's are the same as or different from each other, and when t1 is 2 or higher, N-Het's are the same as or different from each other, 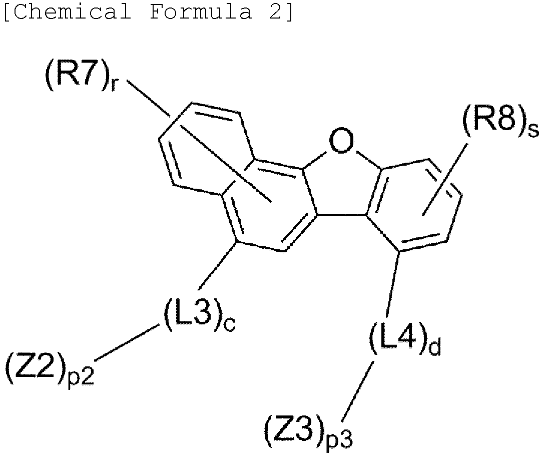 in Chemical Formula 2,
L3 and L4 are the same as or different from each other, and are each independently a direct bond; or a substituted or unsubstituted C6 to C60 arylene group,
Z2 and Z3 are each independently a substituted or unsubstituted amine group; a substituted or unsubstituted C6 to C60 aryl group; or a substituted or unsubstituted C2 to C60 heteroaryl group,
any one of Z2 and Z3 is a substituted or unsubstituted amine group, and the other is a substituted or unsubstituted C6 to C60 aryl group; or a substituted or unsubstituted C2 to C60 heteroaryl group,
R7 and R8 are the same as or different from each other, and are each independently hydrogen; deuterium; a halogen group; -CN; a substituted or unsubstituted C1 to C60 alkyl group; a substituted or unsubstituted C6 to C60 aryl group; or a substituted or unsubstituted C2 to C60 heteroaryl group,
c and d are each an integer from 0 to 3, and when c is 2 or higher, L3's are the same as or different from each other, and when d is 2 or higher, L4's are the same as or different from each other,
p2 and p3 are each an integer from 1 to 3, and when p2 is 2 or higher, Z2's are the same as or different from each other, and when p3 is 2 or higher, Z3's are the same as or different from each other,
r is an integer from 0 to 5, and when r is 2 or higher, R7's are the same as or different from each other, and
s is an integer from 0 to 3, and when s is 2 or higher, R8's are the same as or different from each other.

17. The composition of claim 16, wherein a weight ratio of the compound of Chemical Formula 1 and the compound of Chemical Formula 2 is 1:10 to 10:1.
